# EUROPEAN PATENT APPLICATION

(11) **EP 4 518 633 A1**
(43) Date of publication of application: **05.03.2025**
(21) Application number: 24193874.5
(22) Date of filing: 09.08.2024
(51) Int. Cl.: H10K 59/80, H10K 50/854, H10K 50/86, H10K 59/122, H10K 59/35, H10K 59/38

(54) **LIGHT EMITTING DISPLAY DEVICE**

(30) Priority: 23.08.2023 KR 20230110507; 19.01.2024 KR 20240009095
(71) Applicant: Samsung Display Co., Ltd., Gyeonggi-do 17113 (KR)
(72) Inventor: Kim, Changwook, Yongin-si, Gyeonggi-do (KR); Choi, Beohm Rock, Yongin-si, Gyeonggi-do (KR); Lee, Jun Hee, Yongin-si, Gyeonggi-do (KR); Ann, Minjung, Yongin-si, Gyeonggi-do (KR); Lee, Wang Jo, Yongin-si, Gyeonggi-do (KR); Cho, Hyun Duck, Yongin-si, Gyeonggi-do (KR); Choi, Kook Hyun, Yongin-si, Gyeonggi-do (KR); Choi, Yechan, Yongin-si, Gyeonggi-do (KR)
(74) Representative: Gulde & Partner

(57) **Abstract**

A light emitting display device includes a substrate (110), an anode located on the substrate, a pixel defining layer (380) located on the anode with a first opening (OP) defined therethrough to overlap the anode, a light emitting layer (EML) located within the first opening of the pixel defining layer, a cathode located on the light emitting layer and the pixel defining layer, an encapsulation layer (400) located on the cathode, a scattering layer (210) located on the encapsulation layer and including scattering particles (211), with a scattering layer opening (OPSL) defined therethrough to overlap the first opening in a plan view at least in part, and a light blocking layer (220) located on the light blocking layer with a second opening (OPBM) defined therethrough to overlap the first opening in a plan view, where at least one selected from the first opening, the scattering layer opening, and the second opening has an oval shape.

## Description

### BACKGROUND

### 1. Field

This disclosure relates to a light emitting display device.

### 2. Description of the Related Art

A display device is a device that displays a screen and may include a liquid crystal display (LCD) and an organic light emitting diode (OLED).

These display devices are used in various electronic devices such as mobile phones, navigation devices, digital cameras, electronic books, portable game consoles, and various terminals.

A display device, such as an organic light emitting display device, may have a structure that allows the display device to be bent or folded using a flexible substrate.

In addition, in small electronic devices such as mobile phones, optical elements such as cameras and optical sensors are formed in the bezel area around the display area. However, as the size of the display screen increases, the size of the area surrounding the display area gradually decreases, and camera technology that allows optical sensors to be positioned on the back of the display area is being developed.

### SUMMARY

Embodiments are for reducing diffraction patterns that occur when external light is reflected or for reducing reflectivity. The embodiments are intended to provide a light emitting display device that prevents the user from recognizing diffraction patterns that can occur when external light is reflected in the scattering layer.

A light emitting display device according to an embodiment includes a substrate, an anode located on the substrate, a pixel defining layer located on the anode, where a first opening is defined through the pixel defining layer to overlap the anode, a light emitting layer located in the first opening of the pixel defining layer, a cathode located on the light emitting layer and the pixel defining layer, an encapsulation layer located on the cathode, a scattering layer located on the encapsulation layer, where the scattering layer includes scattering particles, and a scattering layer opening is defined through the scattering layer to overlap the first opening in a plan view at least in part, and a light blocking layer located on the scattering layer, where a second opening is defined through the light blocking layer to overlap the first opening in a plan view, where at least one selected from the first opening, the scattering layer opening, and the second opening has an oval planar shape.

In an embodiment, at least one selected from the first opening, the scattering layer opening, and the second opening may have an elliptical planar shape.

In an embodiment, each of the first opening, the scattering layer opening, and the second opening may have a circular planar shape.

In an embodiment, each of the first opening, the scattering layer opening, and the second opening may have an oval planar shape.

In an embodiment, each of the first opening, the scattering layer opening, and the second opening may have an elliptical planar shape.

In an embodiment, the first opening and the second opening may have a circular planar shape, and the scattering layer opening may have the oval planar shape.

In an embodiment, the first opening and the second opening may have a circular planar shape, and the scattering layer opening may have an elliptical planar shape.

In an embodiment, the scattering layer opening may be in planar contact with the corresponding first opening and/or the second opening in a plan view.

In an embodiment, a portion of the first opening may be covered with the scattering layer.

In an embodiment, each of the planar shape of the first opening and the second opening may have the oval planar shape.

In an embodiment, each of the planar shape of the first opening and the second opening, may have an elliptical planar shape.

In an embodiment, the scattering layer opening may have the oval planar shape.

In an embodiment, the scattering layer opening may have an elliptical planar shape.

In an embodiment, the scattering layer opening and the first opening may coincide with each other in a plan view.

In an embodiment, a long-axis direction of the scattering layer opening may be different from a long-axis direction of the first opening or a long-axis direction of the second opening.

In an embodiment, the long-axis direction of the scattering layer opening may be different from a long-axis direction of the first opening and a long-axis direction of the second opening.

In an embodiment, the scattering layer opening may have a circular planar shape.

In an embodiment, a portion of the first opening may be covered with the scattering layer.

In an embodiment, the oval planar shape may be a planar shape in which at least two oval shapes with different planar eccentricities are combined.

In an embodiment, the elliptical planar shape may be a planar shape in which at least two oval shapes with different planar eccentricities are combined.

A light emitting display device according to an embodiment includes a substrate, an anode comprising a plurality of anodes located on the substrate, a pixel defining layer located on the plurality of anodes, were a first opening comprising a plurality of first openings that is defined through the pixel defining layer to overlap the plurality of anodes, respectively, a light emitting layer comprising a plurality of light emitting layers located in the plurality of first openings of the pixel defining layer, respectively, a cathode located on the plurality of light emitting layers and the pixel defining layer, an encapsulation layer located on the cathode, a scattering layer located on the encapsulation layer, where the scattering layer includes scattering particles, and a scattering layer opening comprising a plurality of scattering layer openings that is defined through the scattering layer to overlap the plurality of first openings, respectively, in a plan view at least in part, and a light blocking layer located on the scattering layer, where a second opening comprising a plurality of second openings that is defined through the light blocking layer to overlap the plurality of first openings, respectively in a plan view, where each of the plurality of first openings, the plurality of scattering layer openings, and the plurality of second openings are in a circular shape in the plan view, and each of the plurality of scattering layer openings is located within a corresponding one of the plurality of first openings in the plan view.

In an embodiment, each of the plurality of first openings, the plurality of scattering layer openings, and the plurality of second openings may be in an oval shape in the plan view.

In an embodiment, each of the plurality of first openings, the plurality of scattering layer openings, and the plurality of second openings may be in an elliptical shape in the plan view.

In an embodiment, a first opening and a scattering layer opening corresponding to each other may have a same center in the plan view.

In an embodiment, at least one of the plurality of first openings may not overlap the plurality of scattering layer openings in the plan view.

A light emitting display device according to an embodiment includes a substrate, an anode located on the substrate, a pixel defining layer located on the anode, where a first opening is defined through the pixel defining layer to overlap the anode, a light emitting layer located in the first opening of the pixel defining layer, a cathode located on the light emitting layer and the pixel defining layer, an encapsulation layer located on the cathode, a scattering layer located on the encapsulation layer, where the scattering layer includes scattering particles, and a scattering layer concave part is defined in the scattering layer to overlap the first opening in a plan view at least in part, and a light blocking layer located on the scattering layer, where a second opening is defined through the light blocking layer to overlap the first opening in the plan view, where the scattering layer concave part is thinner than another part of the scattering layer.

In an embodiment, the scattering layer concave part that is defined in the scattering layer may be comprised in a scattering layer opening that is defined through the scattering layer to overlap the first opening in a plan view at least in part.

In an embodiment, the thickness of the concave part OPSL-c of the scattering layer may be within a range of about 2-5 µm.

In another embodiment, the thickness of the concave part OPSL-c of the scattering layer may be 3 µm.

In an embodiment, each of the first opening, the scattering layer concave part, and the second opening may have a circular planar shape or an elliptical planar shape.

In an embodiment, each of the first opening, the scattering layer concave part, and the second opening may have an oval planar shape.

In an embodiment, the elliptical shape may be a planar shape in which at least two or more oval shapes with different eccentricities are combined.

In an embodiment, the oval shape may be a planar shape in which at least two or more oval shapes with different eccentricities are combined.

A light emitting display device according to an embodiment includes a substrate, an anode located on the substrate; a pixel defining layer located on the anode, where a first opening is defined through the pixel defining layer to overlap the anode, a light emitting layer located in the first opening of the pixel defining layer, a cathode located on the light emitting layer and the pixel defining layer, an encapsulation layer located on the cathode, a scattering layer located on the encapsulation layer, wherein the scattering layer includes scattering particles, and a scattering layer opening is defined through the scattering layer to overlap the first opening in a plan view at least in part, and a plurality of color filters located on the scattering layer, where the plurality of color filters corresponds to different colors, respectively, and the plurality of color filters includes at least two color filters overlapping each other in a light blocking area of the color filter, and a second opening is defined through only one color filter among the plurality of color filters to overlap the first opening in the plan view.

In an embodiment, the light blocking layer may comprise the plurality of color filters located on the scattering layer.

In an embodiment, each of the first opening, the scattering layer opening, and the second opening may have a circular planar shape or an elliptical planar shape.

In an embodiment, each of the first opening, the scattering layer opening, and the second opening may have an oval or elliptical planar shape.

In an embodiment, the elliptical planar shape may be a planar shape in which at least two elliptical shapes with different plane eccentricities are combined.

In an embodiment, the oval planar shape may be a planar shape in which at least two elliptical shapes with different plane eccentricities are combined.

According to embodiments, the reflectance of external light can be lowered by including a scattering layer so that external light is scattered.

According to embodiments, light scattered and reflected from the scattering layer may generate a diffraction pattern, and various openings may be formed in the scattering layer to prevent the user from seeing the diffraction pattern due to the scattering/reflection of external light.

According to embodiments, the diffraction pattern of external light can be reduced by forming the opening of the pixel defining layer, the opening of the scattering layer, and the opening of the light blocking layer in various shapes and angles.

### BRIEF DESCRIPTION OF THE DRAWINGS

FIG. 1 is a schematic perspective view illustrating a display device according to an embodiment in an environment of use.
FIG. 2 is an exploded perspective view of a display device according to an embodiment.
FIG. 3 is a schematic cross-sectional view of a display device according to an embodiment.
FIG. 4 is a block diagram of a display device according to an embodiment.
FIG. 5 is a perspective view schematically showing a light emitting display device according to another embodiment.
FIG. 6 is an enlarged plan view of a partial area of a light emitting display device according to an embodiment.
FIG. 7 is a schematic cross-sectional view of a display panel according to an embodiment.
FIG. 8 and FIG. 9 are plan views of a portion of a display panel according to an embodiment.
FIG. 10 is a table showing the characteristics of comparative examples and examples.
FIG. 11 is a plan view of a portion of a display panel according to another embodiment.
FIG. 12 is a table showing reflection characteristics of a comparative example and an example by photographing them.
FIG. 13 is an enlarged cross-sectional view of a portion of a display panel according to an embodiment.
FIG. 14 is an enlarged cross-sectional view of a portion of a display panel according to a comparative example.
FIG. 15 to FIG. 28 are plan views of a portion of a display panel according to another embodiment.
FIG. 29 to FIG. 32 are plan views of a portion of a display panel according to various modified embodiments.
FIG. 33 is a diagram showing reflection characteristics of a light emitting display device depending on angle.
FIG. 34 is a diagram showing various angle arrangements according to an embodiment.
FIGS. 35 and 36 are diagrams showing a structure combining ellipses with different eccentricities.
FIG. 37 and FIG. 38 are schematic cross-sectional views of a display panel according to another embodiment.
FIG. 39 is a plan view including a color filter of a display area according to an embodiment.
FIG. 40 and FIG. 41 are schematic cross-sectional views of a display panel according to another embodiment.
FIG. 42 is a plan view showing color filters of a display area according to another embodiment.
FIG. 43 is a plan view of a portion of a display panel according to another embodiment.
FIG. 44 is a graph showing the transmittance versus the wavelength of the color filter.
FIGS. 45 and 46 are cross-sectional views of a light emitting display device according to an embodiment.

### DETAILED DESCRIPTION

The invention now will be described more fully hereinafter with reference to the accompanying drawings, in which various embodiments are shown. These embodiments are provided so that this disclosure will be thorough and complete, and will fully convey the scope of the invention to those skilled in the art as defined in the appended claims. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In addition, throughout the specification, when reference is made to "in a plan view," this means when the target portion is viewed from above, and when reference is made to "in cross-section," this means when a cross-section of the target portion is cut vertically and viewed from the side.

In addition, throughout the specification, when "connected" is used, this does not mean only when two or more components are directly connected, but when two or more components are indirectly connected through other components, physically connected or electrically connected, but also when different names are referred to depending on location or function, each part that is substantially integrated may be connected to each other.

In addition, throughout the specification, when a part such as a wiring, layer, film, region, plate, or component is said to "extend in a first or second direction," this does not mean only a straight shape extending in that direction, but also a structure that extends overall along the first or second direction, and also includes a bent, zigzag, or curved structure.

In addition, electronic devices (e.g., mobile phones, TVs, monitors, and laptop computers) containing display devices, display panels, etc. described in the specification, or display devices, display panels, etc. manufactured by the manufacturing method described in the specification are not excluded from the scope of rights herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

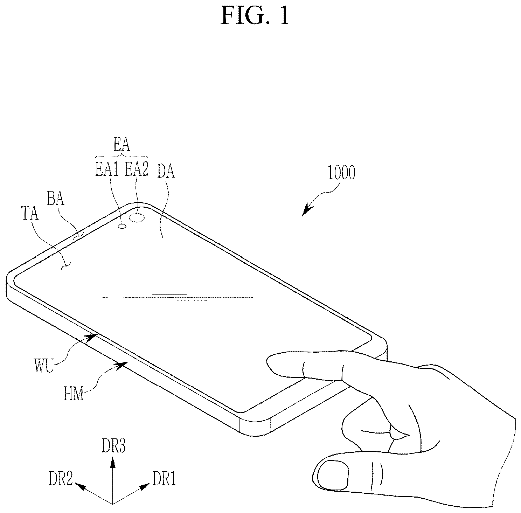

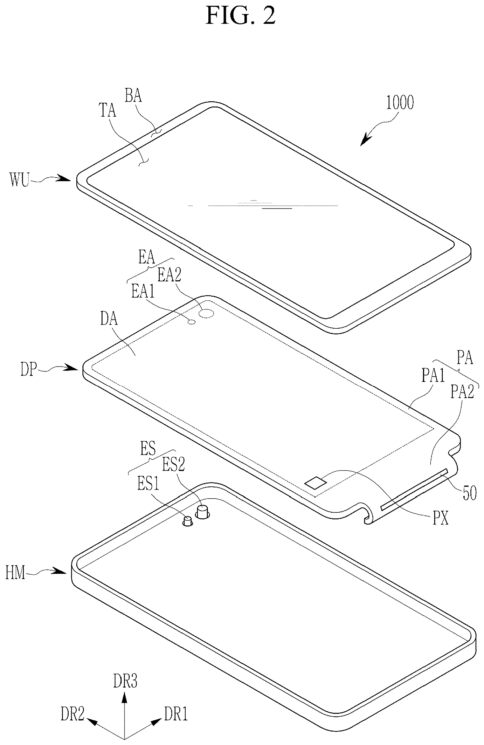

Hereinafter, a structure of an embodiment of the display device will be described with reference to FIGS. 1 and 2.

FIG. 1 is a schematic perspective view showing a display device according to an embodiment in an environment of use, and FIG. 2 is an exploded perspective view of a display device according to an embodiment.

Referring to FIG. 1, a display device 1000 according to an embodiment is a device that displays moving images or still images, and may be used or included in a mobile phone, a smart phone, a tablet personal computer (PC), or a mobile phone, not only portable electronic devices such as communication terminals, electronic notebooks, e-books, portable multimedia players (PMP), navigation devices, and ultra mobile PCs (UMPC), but also large-sized electronic devices such as televisions, laptops, monitors, billboards, internet of things (IOT), etc.

In addition, the display device 1000 according to an embodiment may be included or mounted in a wearable device such as a smart watch, a watch phone, a glasses-type display, and a head-mounted display (HMD).

In addition, the display device 1000 according to an embodiment includes a dashboard of a car, a center information display (CID) placed on the center fascia or dashboard of a car, and a room mirror display instead of a side mirror of a car, as entertainment for the back seat of a car, and as a display placed on the back of the front seat.

FIG. 1 shows an embodiment where the display device 1000 is a smart phone, for convenience of illustration and description.

An embodiment of the display device 1000 may display an image in a third direction DR3 on a display surface parallel to each of a first direction DR1 and a second direction DR2.

The display surface on which the image is displayed may correspond to a front surface of the display device 1000 and a front surface of a cover window WU.

Images displayed on the display surface may include static images as well as dynamic images.

In an embodiment, the front (or top) and back (or bottom) surfaces of each member are defined based on the direction in which the image is displayed.

The front and back surfaces are opposed to each other in a third direction DR3, and the normal directions of each of the front and back surfaces may be parallel to the third direction DR3.

The separation distance between the front and back surfaces in the third direction DR3 may correspond to the thickness of the display panel in the third direction DR3. The third direction DR3 may be a thickness direction of the display device 1000.

The display device 1000 according to an embodiment may detect a user's input (refer to the hand in FIG. 1) applied from an outside.

The user's input may include various types of external inputs, such as parts of the user's body, light, heat, or pressure.

In an embodiment, as shown in FIG. 1, the user's input may be the user's hand applied to the front.

However, the invention is not limited to this.

The user's input may be provided in various forms, and the display device 1000 may also detect the user's input applied to the side or back of the display device 1000 depending on the structure of the display device 1000.

Referring to FIGS. 1 and 2, an embodiment of the display device 1000 may include a cover window WU, a housing HM, a display panel DP, and an optical element ES.

In an embodiment, the cover window WU and the housing HM may be combined with each other to form the exterior of the display device 1000.

The cover window WU may include an insulating panel.

In an embodiment, for example, the cover window WU may include or be made of glass, plastic, or a combination thereof.

The front surface of the cover window WU may define the front surface of the display device 1000.

A transmission area TA may be an optically transparent area.

In an embodiment, for example, the transmission area TA may be an area with a visible light transmittance of about 90% or greater.

A blocking area BA may define the shape of the transmission area TA.

The blocking area BA is adjacent to the transmission area TA and may surround the transmission area TA.

The blocking area BA may be an area with relatively low light transmittance compared to the transmission area TA.

The blocking area BA may include an opaque material that blocks light.

The blocking area BA may have a predetermined color.

The blocking area BA may be defined by a bezel layer provided separately from the transparent substrate defining the transmission area TA, or may be defined by an ink layer formed by inserting or coloring the transparent substrate.

The display panel DP may include a display pixel PX that displays an image and a driver 50, and the display pixel PX is located in the display area DA and a component area EA.

The display panel DP may include a front surface including a display area DA and a non-display area PA.

In an embodiment, the display area DA and the component area EA are areas where images are displayed by pixels therein, and at the same time, a touch sensor may be located in the upper side of the third direction DR3 of the pixels, which can be an area where external input is detected.

The transmission area TA of the cover window WU may at least partially overlap the display area DA and the component area EA of the display panel DP.

In an embodiment, for example, the transmission area TA may overlap the front surface of the display area DA and the component area EA, or may overlap at least a portion of the display area DA and the component area EA.

Accordingly, the user can view the image through the transmission area TA or provide external input based on the image.

However, the invention is not limited to this.

In an embodiment, for example, the area where an image is displayed and the area where external input is detected may be separated from each other.

The non-display area PA of the display panel DP may at least partially overlap the blocking area BA of the cover window WU.

The non-display area PA may be an area covered by the blocking area BA.

The non-display area PA is adjacent to the display area DA and may surround the display area DA.

An image is not displayed in the non-display area PA, and a driving circuit or driving wiring for driving may be disposed to drive the display area DA.

The non-display area PA may include a first peripheral area PA1 located outside the display area DA and a second peripheral area PA2 including the driver 50, a connection wiring, and a bending area.

In an embodiment, as shown in FIG. 2, the first peripheral area PA1 may be located on three sides of the display area DA, and the second peripheral area PA2 may be located on the remaining side of the display area DA.

In an embodiment, the display panel DP may be assembled in a flat state with the display area DA, the component area EA, and the non-display area PA facing the cover window WU.

However, the invention is not limited to this.

In an embodiment, a portion of the non-display area PA of the display panel DP may be curved.

In such an embodiment, part of the non-display area PA is directed toward the rear of the display device 1000, so that the blocking area BA visible on the front of the display device 1000 can be reduced, and as shown in FIG. 2, the second peripheral area PA2 can be bent and placed on the back surface of the display area DA and then assembled.

In an embodiment, the component area EA of the display panel DP may include a first component area EA1 and a second component area EA2.

The first component area EA1 and the second component area EA2 may be at least partially surrounded by the display area DA.

In an embodiment, as shown in FIG. 2, the first component area EA1 and the second component area EA2 may be spaced apart from each other, but are not limited to this and may be at least partially connected.

The first component area EA1 and the second component area EA2 may be areas in which an optical element (see ES in FIG. 2; hereinafter referred to as a component) that uses infrared (IR) rays, visible rays, or sound is disposed.

In an embodiment, the display area DA (hereinafter also referred to as the main display area) and the component area EA include or are formed with a plurality of light emitting diodes and a plurality of pixel circuit parts that generate and transmit light emission current to each of the plurality of light emitting diodes. Hereinafter, embodiments where the display device is a light emitting display device will be described in detail, and the display device may also be referred to as a light emitting display device in embodiments described herein.

Here, one light emitting diode and one pixel circuit part may define a pixel PX.

One pixel circuit part and one light emitting diode may be formed in a one-to-one ratio or correspondence in the display area DA and the component area EA.

The first component area EA1 may include a transmission portion through which light and/or sound can transmit and a display portion including a plurality of pixels.

The transmission portion is located between adjacent pixels and includes a layer through which light and/or sound can pass.

The transmission portion may be located between adjacent pixels in the first component area EA1, or a layer that does not transmit light, such as a light blocking layer, may overlap the first component area EA1.

The number of pixels per unit area (hereinafter also referred to as resolution) of the pixels included in the display area DA (hereinafter also referred to as normal pixels) and the number of pixels per unit area of the pixels included in the first component area EA1 (hereinafter referred to as first component pixels) may be the same as each other.

The second component area EA2 includes an area including a transparent layer so that light can pass through (hereinafter also referred to as a light transmission area), and the light transmission area may not have a conductive layer or a semiconductor layer and includes a light blocking material, and a layer-for example, a pixel defining layer and/or a light blocking layer-that may have a structure that does not block light may be provided with an opening that overlaps a position corresponding to the second component area EA2.

The number of pixels per unit area of the pixels included in the second component area EA2 (hereinafter also referred to as second-component pixels) may be less than the number of pixels per unit area of the normal pixels included in the display area DA.

As a result, the resolution of the second-component pixel may be lower than that of the normal pixel.

The display panel DP may further include a touch sensor TS in addition to the display area DA including the display pixels PX.

The display panel DP includes pixels PX, which are components that generate images, and can be visible to the user from the outside through the transmission area TA.

In an embodiment, the touch sensor TS may be located on top of (or a top or upper surface of) the pixel PX and may detect an input applied from outside.

The touch sensor TS can detect an external input provided to the cover window WU.

Referring to FIG. 2, the second peripheral area PA2 may include a bending portion.

The display area DA and the first peripheral area PA1 may be in a flat state substantially parallel to the plane defined by the first direction DR1 and the second direction DR2, and one side of the second peripheral area PA2 may extend from the first peripheral area PA1 in a flat state, further extend in a bending portion, and then in a flat state again.

As a result, at least a portion of the second peripheral area PA2 may be bent and assembled to be located on the rear surface of the display area DA.

In such an embodiment where at least a portion of the second peripheral area PA2 is bent, a portion of the second peripheral area PA2 is disposed to overlap the display area DA in a plan view, such that the blocking area BA of the display device 1000 may be reduced.

However, the invention is not limited to this.

In an embodiment, for example, the second peripheral area PA2 may not be bent.

The driver 50 may be mounted on the second peripheral area PA2, on the bending part, or located on either side of the bending part.

The driver 50 may be provided in the form of a chip.

The driver 50 is electrically connected to the display area DA and the component area EA, and can transmit electrical signals to pixels in the display area DA and the component area EA.

In an embodiment, for example, the driver 50 may provide data signals to the pixels PX arranged in the display area DA.

Alternatively, the driver 50 may include a touch driving circuit and may be electrically connected to the touch sensor TS disposed in the display area DA and/or the component area EA.

In an embodiment, the driver 50 may include various circuits in addition to the above-described circuits or may be designed to provide various electrical signals to the display area DA.

In an embodiment, the display device 1000 may include a pad portion located at an end of the second peripheral area PA2, and is electrically connected to a flexible printed circuit board FPCB including a driving chip by the pad portion.

Here, the driving chip located on the flexible printed circuit board may include various driving circuits for driving the display device 1000 or a connector for power supply.

In another embodiment, a rigid printed circuit board PCB may be used instead of a flexible printed circuit board.

The optical element ES may be disposed below the display panel DP.

The optical element ES may include a first optical element ES1 overlapping the first component area EA1 and a second optical element ES2 overlapping the second component area EA2.

In an embodiment, the first optical element ES1 may use IR rays, and in such an embodiment, a layer that does not transmit light, such as a light blocking layer, may overlap the first component area EA1.

In an embodiment, the first optical element ES1 may be an electronic element that uses light or sound.

In such an embodiment, for example, the first optical element ES1 may be a sensor that collects and utilizes light, such as an IR sensor, a sensor that outputs and detects light or sound to measure distance or recognize fingerprints, a small lamp that emits light, or a speaker that outputs sound.

In the case of electronic elements that use light, it would be understood that light of various wavelength bands, such as visible light, IR light, and ultraviolet light, can be used.

The second optical element ES2 is at least one selected from a camera, an IR camera, a dot projector, an IR illuminator, and a time-of-flight (ToF) sensor.

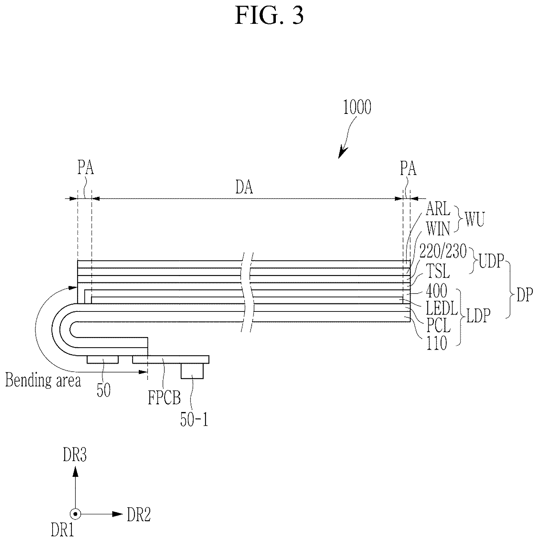

An embodiment of a light emitting display device may have a cross-sectional structure as shown in FIG. 3, and the cross-sectional structure thereof will be described with reference to FIG. 3.

FIG. 3 is a schematic cross-sectional view of a display device according to an embodiment.

Referring to FIG. 3, an embodiment of the display device 1000 includes a display panel DP mainly divided into a lower panel layer LDP and an upper panel layer UDP and a cover window WU located in front of the display panel.

The lower panel layer LDP of the display panel DP includes a light emitting device layer LEDL where the light emitting diodes constituting the pixel PX are located on the substrate 110, and a pixel circuit layer PCL located between the substrate 110 and the light emitting device layer LEDL and including the pixel circuit part for transmitting current to the light emitting diodes located in the light emitting device layer LEDL.

The lower panel layer LDP further includes an encapsulation layer 400, and the light emitting device layer LEDL is covered by the encapsulation layer 400.

In such an embodiment, the encapsulation layer 400 may protect the light emitting device layer LEDL by preventing moisture and air from flowing into the light emitting device layer LEDL.

The upper panel layer UDP of the display panel DP may include a touch sensing layer TSL, a light blocking layer, and a color filter layer 220/230.

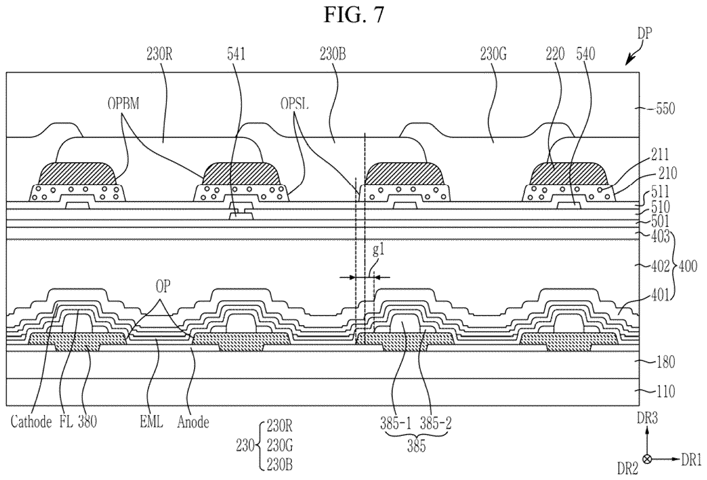

The touch sensing layer TSL may include a sensing insulating layer (see 501, 510, 511 in FIG. 7) and a plurality of sensing electrodes (see 540 and 541 in FIG. 7).

The light blocking layer and color filter layer 220/230 includes a light blocking layer (see 220 in FIG. 7) and a color filter (see 230 in FIG. 7), and may further include a scattering layer (see 210 in FIG. 7).

Hereinafter, each structure will be described in detail.

The substrate 110 is a base substrate or base member and may be a flexible substrate capable of bending, folding, rolling, etc.

In an embodiment, for example, the substrate 110 may include a polymer resin such as polyimide (PI), but is not limited thereto.

In another embodiment, the substrate 110 may include a glass material or a metal material.

The pixel circuit layer PCL may be disposed on the substrate 110.

The pixel circuit layer PCL may include a plurality of thin film transistors constituting the pixel circuit part of the pixel PX and may additionally include a capacitor.

The pixel circuit layer PCL may include wiring connected to the pixel circuit part, such as a scan line, a data line, and a power voltage line.

Each thin film transistor may include a semiconductor region, a source electrode, a drain electrode, and a gate electrode.

In an embodiment, the pixel circuit layer PCL may be located in the display area DA, or the pixel circuit layer PCL may be located in a portion of the non-display area PA or a portion of the bending area.

The light emitting device layer LEDL may be disposed on the pixel circuit layer PCL.

The light emitting device layer LEDL may include a plurality of light emitting diodes that emit light, where each of the light emitting diodes includes an anode, a cathode and a light emitting layer, and a pixel defining layer that defines the light emitting area.

A plurality of light emitting devices of the light emitting device layer LEDL may be disposed in the display area DA.

In an embodiment, the light emitting layer may be an organic light emitting layer including or containing an organic material.

In an embodiment, at least one functional layer such as a hole transport layer, a hole transport layer, an electron transport layer, and an electron transport layer may be provided above and below the light emitting layer.

When current flows between the anode and the cathode, holes and electrons can move to the light emitting layer through the hole transport layer and electron transport layer, respectively, and can combine with each other in the light emitting layer to emit light.

In an embodiment, the light emitting device may include a quantum-dot light emitting diode including a quantum-dot light emitting layer, an inorganic light emitting diode including an inorganic semiconductor, or a micro light emitting diode.

The encapsulation layer 400 may cover the top and side surfaces of the light emitting device layer LEDL and protect the light emitting device layer LEDL.

The encapsulation layer 400 may include at least one inorganic layer and at least one organic layer to encapsulate the light emitting device layer LEDL.

The touch sensing layer TSL may be disposed on the encapsulation layer 400.

The touch sensing layer TSL may include a plurality of sensing electrodes for detecting the user's touch in a capacitive manner, and a plurality of sensing lines connecting the plurality of sensing electrodes and the touch driver 50-1.

In an embodiment, the touch sensing layer TSL may detect the user's touch using a mutual capacitance method or a self-capacitance method.

In an embodiment, the touch sensing layer TSL may be formed on a separate substrate disposed on the light emitting device layer LEDL.

In such an embodiment, the substrate supporting the touch sensing layer TSL may serve as an encapsulation substrate that encapsulates the light emitting device layer LEDL, and in such an embodiment where the encapsulation substrate is provided, the encapsulation layer 400 may be omitted.

The plurality of sensing electrodes of the touch sensing layer TSL may not overlap the light emitting area, and may be positioned to be covered with a light blocking layer, etc., which will be described later.

The light blocking layer and the color filter layer 220/230 are disposed on the touch sensing layer TSL and may include a light blocking layer (see 220 in FIG. 7) and a color filter (see 230 in FIG. 7).

In an embodiment, the scattering layer (see 210 in FIG. 7) may be provided.

The light blocking layer covers the sensing electrode and may have a position that does not overlap the light emitting area, and the color filter can improve the color of the light emitted from the light emitting diode by overlapping the color filter of each color with the corresponding light emitting area.

The light blocking layer and the color filter layer 220/230 may have a structure that reduces reflection of external light so that external light flowing into the display device 1000 is not reflected again and transmitted to the user's eyes.

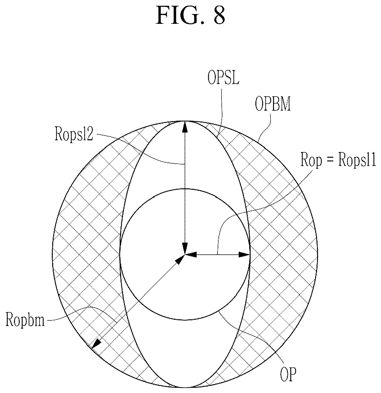

This will be described later in greater detail with reference to FIG. 8, etc.

In an embodiment, the substrate 110 may have a structure that is folded towards the back, including a bending area. The actuator 50 is located on one side of the folded substrate 110, and can be electrically connected to a flexible printed circuit board FPCB with a touch actuator 50-1 attached.

Here, the driver 50 may output signals and voltages for driving the display panel DP.

The driver 50 supplies data voltages to a plurality of data lines, supplies respective power voltages to power lines such as driving voltage lines, and supplies control signals such as clock signals to generate scan signals to be applied to the scan lines.

The driver 50 may be formed of or defined by an integrated circuit (IC) and mounted on the display panel DP using a chip-on-glass (COG) method, a chip-on-plastic (COP) method, or an ultrasonic bonding method.

In an embodiment, for example, the driver 50 may be positioned in a direction opposite to the display area DA and the third direction DR3 by bending the substrate 110, and may be positioned on the back of the display area DA.

In another embodiment, the driver 50 may be mounted on a flexible printed circuit board FPCB.

The flexible printed circuit board FPCB may be attached to the pad portion of the display panel DP using an anisotropic conductive film ACF.

The pad portion of the flexible printed circuit board FPCB may be electrically connected to the pad portion of the display panel DP.

The flexible printed circuit board FPCB may be a flexible printed circuit board, a printed circuit board, or a flexible film such as a chip on film.

The touch driver 50-1 may be mounted on a flexible printed circuit board FPCB.

The touch driver 50-1 is electrically connected to the detection electrodes of the touch sensing layer TSL in the display panel DP, may supply drive signals to multiple detection electrodes, and can detect the amount of change in the electrostatic capacitance between multiple detection electrodes to determine whether a touch is made.

The touch driver 50-1 may be formed of or defined by an IC.

A cover window WU is located on the front of the display panel DP, and the cover window WU may include a window WIN and an anti-reflection layer ARL.

The window WIN may be disposed on the light blocking layer and the color filter layer 220/230, and may be attached to the light blocking layer and the color filter layer 220/230 using a transparent adhesive.

The window WIN may serve to protect the display panel DP.

The window WIN may include or be made of a transparent material.

In an embodiment, the window WIN may include, for example, glass or plastic.

In an embodiment where the window WIN includes glass, the glass may be ultra-thin glass UTG or thin-film glass.

Ultra-thin glass may be a glass strengthened to have an internal predetermined stress profile.

Tempered ultra-thin glass may effectively prevent cracks from occurring, propagating, and breaking due to external impacts better than before tempering.

Ultra-thin glass strengthened through a tempering process can have varying stresses depending on the area.

In an embodiment where glass is made of an ultra-thin film or thin film, the glass has flexible characteristics and can be warped, bent, folded, or rolled.

The thickness of the glass may be in a range from, for example, about 10 micrometers (µm) to about 300µm, e.g., in a range of about 10µm to about 100µm or about 50µm.

The glass of the window WIN may include soda lime glass, alkali aluminosilicate glass, borosilicate glass, or lithium aluminosilicate glass.

The glass of the window WIN may include chemically strengthened or thermally strengthened glass to have extra strength.

Chemical strengthening can be achieved through an ion-exchange treatment process in alkaline salts.

The ion-exchange treatment process may be performed two or more times.

Additionally, the window WIN may be a polymer film coated with a thin film of glass on both opposing sides.

An anti-reflection layer ARL may be located on the front of the window WIN, and the anti-reflection layer ARL may be attached to the front of the window WIN in the form of an optical film.

The anti-reflection layer ARL may be disposed on the window WIN.

The anti-reflection layer ARL can protect the window WIN and reduce reflection of external light.

The anti-reflection layer ARL may include a hard coating layer and a low refractive index layer, and may server to prevent or reduce reflection of external light by forming the two layers with different refractive indices from each other so that external light is lost or destructive interference occurs at the interface or there is offsetting interference.

Here, the low refractive index layer may have a structure including particles dispersed in a transparent resin.

In an embodiment, a high refractive index layer may be additionally included in the anti-reflection layer ARL, and the high refractive index layer may be located between the hard coating layer and the low refractive index layer.

The hard coating layer, the low refractive index layer, and/or the high refractive index layer that may be included in the anti-reflection layer ARL and may have the following characteristics.

The hard coating layer can reduce distortion or lifting of the anti-reflection layer ARL under harsh conditions such as high temperature and high humidity, thereby mitigating reliability problems.

The hard coating layer may include an organic layer.

The organic layer is at least one selected from an acrylate-based compound, a urethane-based compound, polyimide, polycarbonate, polyethersulfone, polyethylene naphthalate, polyphenylene sulfide, liquid crystal polymer (LCP), polymethyl methacrylate, and an epoxy polymer, or the organic layer may include a combination thereof.

In another embodiment, the hard coating layer may include an organic layer and an organic-inorganic composite layer.

In such an embodiment, the organic layer may include an acrylate-based compound.

In an embodiment, for example, the organic layer may be formed including urethane acrylate.

The organic layer may serve as a stress buffer layer.

The organic material in the organic-inorganic composite layer may be formed from at least one selected from an acrylate-based compound, a polyurethane-based compound, an epoxy-based compound, and a combination thereof.

In an embodiment, for example, the organic material may include urethane acrylate.

In an embodiment, the inorganic material of the hard coating layer may include at least one selected from silicon oxide (SiOz), zirconium oxide (ZrO₂), aluminum oxide (Al₂O₃), tantalum oxide (TazOs), niobium oxide (NbzOs or NbO₂), and glass beads.

The inorganic material may be provided in the form of a single type of inorganic oxide listed above or a mixture thereof.

Additionally, inorganic materials can be provided in various forms to form an organic-inorganic composite layer.

For example, silicon oxide can be provided in the form of particles, sol, or having a hollow shape.

In the organic-inorganic composite layer, the organic acrylate compound and inorganic particles may be mixed at a weight ratio of 5:5 to 8:2.

By containing both an acrylate compound and inorganic particles, the organic-inorganic composite layer forms a hard coating layer that is not easily broken, improves surface hardness and has shock absorbency against external shock.

In an embodiment, the hard coating layer may include an acrylate-based compound and a urethane-based compound.

Acrylate-based compounds and urethane-based compounds can be mixed and polymerized in monomer form.

Acrylate-based compounds can increase the hardness and wear resistance of the anti-reflection layer ARL by increasing the hardness of the low refractive index layer.

The urethane-based compound can increase the elasticity of the anti-reflection layer ARL by providing flexibility to the low refractive index layer.

In an embodiment, the ratio of the acrylate-based compound in the hard coating layer may be 70% to 99.9% and the ratio of the urethane-based compound may be 0.1% to 30%.

In an embodiment, for example, the mixing ratio of the acrylate-based compound and the urethane-based compound may be 7:3 or more, and the ratio of the acrylate-based compound may be further increased.

In an embodiment, for example, the mixing ratio of the acrylate-based compound and the urethane-based compound may be further increased, such as 7:3, 8:2, or 9:1.

In another embodiment, the hard coating layer may include an acrylate-based compound.

In such an embodiment, the acrylate-based compound may be an acrylic resin.

That is, the hard coating layer can improve the hardness and wear resistance of the anti-reflection layer ARL by including acrylic resin.

The thickness of the hard coating layer may be in a range of about 2µm to about 10µm.

By including the hard coating layer within the above thickness range, distortion or lifting phenomena can be reduced and reliability problems can be improved.

The refractive index of the hard coating layer may be in a range of 1.48 to 1.53.

By including the hard coating layer in the above refractive index range, it has a difference in refractive index at the interface with the low refractive index layer, which will be described later, and refracts the light emitted from the light emitting device layer upward to increase light output efficiency and reduce reflection of external light.

The low refractive index layer may be disposed on the hard coating layer.

The low refractive layer can refract light emitted from the light emitting device layer upward to increase light output efficiency and reduce reflection of external light.

The low refractive index layer may include particles dispersed in a transparent resin.

The resin may include at least one selected from acryl, polysiloxane, polyurethane, polyurethane acrylate, polyimide, polymethylsilsesquioxane (PMSSQ), and poly(methyl methacrylate) (PMMA).

The particles may be hollow particles.

In an embodiment, for example, the particles may include at least one selected from silica (SiOz), magnesium fluoride (MgF₂), and iron oxide (Fe₃O₄).

Additionally, the particles may include a shell made of one or more of the above materials and a hollow interior of the shell.

In an embodiment, the diameter of the particles may be in a range of about 10 nanometers (nm) to about 200 nm, and the thickness of the shell and the diameter of the hollow interior may be determined depending on the diameter of the particles.

Particles contained in the low refractive index layer may be included in a weight ratio of 10% to 50% relative to the resin.

If the weight ratio of particles to resin is 10% or greater, the refractive index of the low refractive index layer can be lowered, and if the weight ratio of particles to resin is 50% or less, adhesion to adjacent layers can be prevented from being reduced.

The low refractive index layer can be formed by coating and curing a solution containing a solvent in which resin and particles are dispersed.

The thickness of the low refractive layer may be in a range of about 10 nm to about 200 nm.

By including the low refractive index layer within the above thickness range, it can contain sufficient particles to lower the refractive index and improve adhesion to the lower layer.

The refractive index of the low refractive index layer may be less than the refractive index of the hard coating layer.

The weight ratio of particles to resin example, the refractive index of the low refractive index layer may be less than the refractive index of the hard coating layer by about 0.05 or greater.

If the difference between the refractive index of the low refractive index layer and the hard coating layer is 0.05 or more, total reflection of external light can be increased at the interface between the low refractive index layer and the hard coating layer, leading to destructive interference with light reflected from the surface of the low refractive index layer.

Accordingly, the reflectance of external light of the anti-reflection layer ARL can be reduced.

The refractive index of the low refractive layer may be in a range from about 1.3 to about 1.43.

However, it is not limited to this, and a lower refractive index layer can be used as long as the refractive index thereof is smaller than the refractive index of the hard coating layer.

In an embodiment, the high refractive index layer may include an inorganic material, an organic material, or an inorganic material and an organic material.

Therefore, the high refractive index layer may include or be made of an inorganic layer, an organic layer, or an organic layer containing inorganic particles.

Inorganic substances contained in the high refractive index layer may be at least one selected from zinc oxide, titanium oxide, zirconium oxide, niobium oxide, tantalum oxide, and tin oxide nickel oxide, silicon oxide, silicon nitride, indium nitride, and gallium nitride.

Organic substances contained in the high refractive index layer include at least one selected from poly(3,4-ethylenedioxythiophene (PEDOT), 4,4'-bis[N-(3-methylphenyl)-N-phenyl amino]biphenyl (TPD), 4,4',4"-tris[(3-methylphenyl)phenyl aminotriphenylamine (m-MTDATA), 1,3,5-tris[N,N-bis(2)-methylphenyl]-amino]-benzene (o-MTDAB), 1,3,5-tris[N,N-bis(3-methylphenyl)-amino]-benzene (m-MTDAB), 1,3,5-tris [N,N-bis(4-methylphenyl)-amino]-benzene (p-MTDAB), 4,4'-bis[N,N-bis(3-methylphenyl)-amino]-diphenylmethane (BPPM), 4,4'-dicarbazolyl-1,1'-biphenyl (CBP), 4,4',4"-tris (N-carbazole)triphenylamine (TCTA), 2,2',2"-(1,3,5-benzentolyl)tris-[1-phenyl-1H-benzoimidazole](TPBI), and 3-(4-biphenyl)-4-phenyl-5-t-butylphenyl-1,2,4-triazole (TAZ).

The refractive index of the high refractive index layer may be greater than that of the low refractive index layer to reduce reflection of external light.

In an embodiment, for example, the refractive index of the high refractive index layer may be greater than or equal to that of the low refractive index layer by 0.05 or greater.

The refractive index of the high refractive index layer may be in a range from about 1.53 to about 1.7.

However, it is not limited to this, and the high refractive index layer may be used as long as the refractive index thereof is greater than that of the low refractive index layer.

The thickness of the high refractive index layer may be in a range of about 50 nm to about 200 nm.

By including the high refractive index layer within the above thickness range, the interface with the low refractive index layer can be formed flat and the bonding strength with the hard coating layer can be prevented from decreasing.

The anti-reflection layer ARL further including a high refractive index layer can further reduce reflection of external light by increasing the difference in refractive index at the interface with the low refractive index layer.

In an embodiment, an optical film other than the anti-reflection layer ARL may be further included on the front surface of the window WIN, and an anti-fingerprint layer may be included.

In such an embodiment, a polarizer is not included, and this is because the light blocking layer and color filter layer 220/230, which will be described later, lower the reflectance of external light and make it difficult for the user to see.

Accordingly, in such an embodiment, the anti-reflection layer ARL may not be included on the front surface of the window WIN.

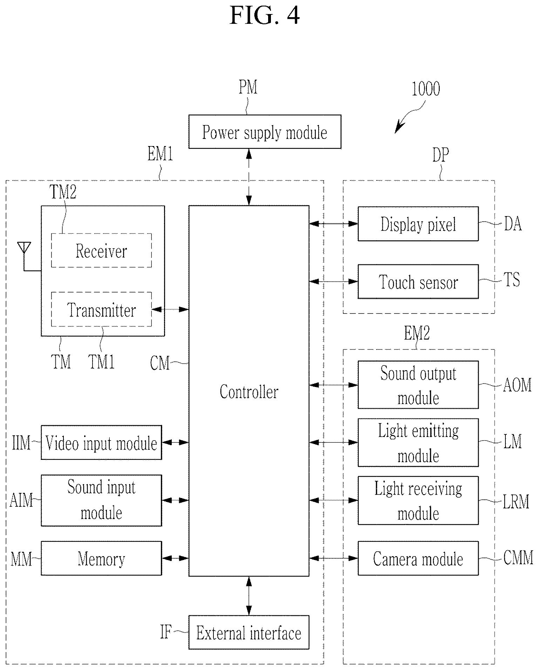

Hereinafter, a display device according to an embodiment will be described with reference to FIG. 4.

FIG. 4 is a block diagram of a display device according to an embodiment.

Referring to FIG. 4, an embodiment of the display device 1000 may include a display panel DP, a power supply module PM, a first electronic module EM1, and a second electronic module EM2.

The display panel DP, the power supply module PM, the first electronic module EM1, and the second electronic module EM2 may be electrically connected to each other.

In FIG. 4, a display pixel and a touch sensor TS located in the display area DA of the display panel DP are shown as an example.

The power supply module PM can supply power required for the overall operation of the display device 1000.

The power supply module PM may include a conventional battery module.

The first electronic module EM1 and the second electronic module EM2 may include various functional modules for operating the display device 1000.

The first electronic module EM1 may be mounted directly on a motherboard electrically connected to the display panel DP, or may be mounted on a separate board and electrically connected to the motherboard through a connector (not shown).

The first electronic module EM1 may include a control module (or controller) CM, a wireless communication module TM, an image (or video) input module IIM, an audio (or sound) input module AIM, a memory MM, and an external interface IF.

Some of the modules may not be mounted on the motherboard, but may be electrically connected to the motherboard through a flexible printed circuit board connected thereto.

The control module CM may control the overall operation of the display device 1000. The control module CM may be a microprocessor.

In an embodiment, for example, the control module CM activates or deactivates the display panel DP.

The control module CM can control other modules, such as the image input module IIM or the audio input module AIM, based on the touch signal received from the display panel DP.

The wireless communication module TM can transmit/receive wireless signals to and from other terminals using a Bluetooth or Wi-Fi.

The wireless communication module TM can transmit/receive voice signals using a general communication line.

The wireless communication module TM includes a transmitter TM1 that modulates and transmits a signal to be transmitted, and a receiver TM2 that demodulates the received signal.

The image input module IIM can process video signals and convert them into video data that can be displayed on the display panel DP.

The audio input module AIM can receive external audio signals through a microphone in recording mode, voice recognition mode, etc. and convert them into electrical voice data.

The external interface IF may serve as an interface connected to an external charger, wired/wireless data port, card socket (e.g., memory card, SIM/UIM card), etc.

The second electronic module EM2 may include an audio (or sound) output module AOM, a light emitting module LM, a light receiving module LRM, and a camera module CMM, at least some of which include optical elements ES, and may be located on the back of the display panel DP, as shown in FIGS. 1 and 2.

The optical element ES may include the light emitting module LM, the light receiving module LRM, and the camera module CMM.

In an embodiment, the second electronic module EM2 is mounted directly on the motherboard, or may be mounted on a separate board and electrically connected to the display panel DP through a connector (not shown), or may be connected to the first electronic module EM1.

The audio output module AOM can convert audio data received from the wireless communication module TM or audio data stored in the memory MM and output it to the outside.

The light emitting module LM can generate and output light.

The light emitting module LM can output IR rays.

For example, the light emitting module LM may include an LED device.

For example, a light receiving module LRM can detect infrared light.

The light receiving module LRM may be activated when infrared rays above a certain level are detected.

The light receiving module LRM may include a CMOS sensor.

After the IR light generated in the light emitting module LM is output, it is reflected by an external subject (e.g., a user's finger or face), and the reflected IR light may be incident on the light receiving module LRM.

The camera module CMM can capture external images.

In an embodiment, the optical element ES may additionally include a light detection sensor or a heat detection sensor.

The optical element ES can detect an external subject received through the front or provide a sound signal such as voice to the outside through the front.

Additionally, the optical element ES may include a plurality of components and is not limited to any one embodiment.

Again, referring to FIG. 2, the housing HM may be combined with the cover window WU.

The cover window WU may be disposed on the front of the housing HM.

The housing HM can be combined with the cover window WU to provide a predetermined accommodation space.

The display panel DP and the optical element ES may be accommodated in a predetermined accommodation space provided between the housing HM and the cover window WU.

The housing HM may include a material with relatively high rigidity.

In an embodiment, for example, the housing HM may include a plurality of frames and/or plates including or made of glass, plastic, or metal, or a combination thereof.

The housing HM can stably protect the components of the display device 1000 accommodated in the internal space from external shock.

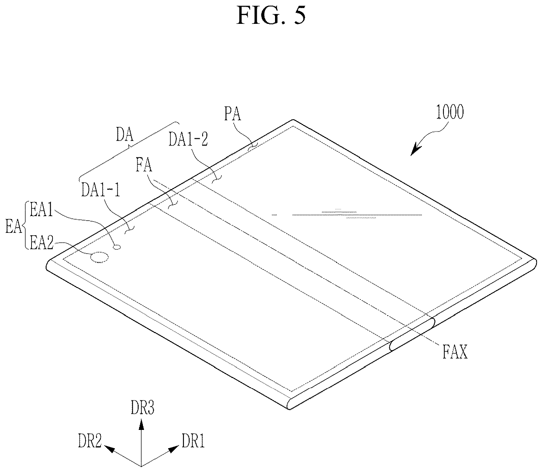

Hereinafter, the structure of the display device 1000 according to another embodiment will be described with reference to FIG. 5.

FIG. 5 is a perspective view schematically showing a light emitting display device according to another embodiment.

Any repetitive detailed descriptions of the same components as those described above will be omitted, and the embodiment of FIG. 5 shows a foldable display device in which the display device 1000 is foldable with respect to the folding axis FAX.

Referring to FIG. 5, in an embodiment, the display device 1000 may be a foldable display device.

The display device 1000 may be folded outward or inward based on the folding axis FAX.

In an embodiment where the display device 1000 is foldable outward based on the folding axis FAX, the display surfaces of the display device 1000 are positioned on the outside in the third direction DR3 in a folded state such that images can be displayed in both opposing directions.

In an embodiment where the display device 1000 is foldable inward based on the folding axis FAX, the display surface may not be visible from the outside in a folded state.

In an embodiment, the display device 1000 may include a display area DA, a component area EA, and a non-display area PA.

The display area DA may be divided into a first display area DA1-1, a first display area DA1-2, and a folding area FA.

The first display area DA1-1 and the second display area DA1-2 may be located on the left and right sides, respectively, based on (or centered on) the folding axis FAX, and the folding area FA may be located between the first display area DA1-1 and the second display area DA1-2.

In an embodiment, when the display device 1000 is folded outward based on the folding axis FAX, the first display area DA1-1 and the first display area DA1-2 are positioned on both opposing sides in the third direction DR3, and images can be displayed in both directions.

In an embodiment, when the display device 1000 is folded inward based on the folding axis FAX, the first display area DA1-1 and the second display area DA1-2 may not be visible from the outside.

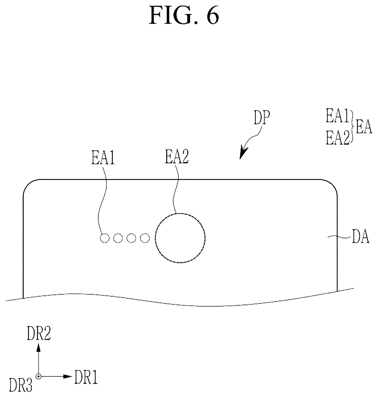

FIG. 6 is an enlarged plan view of a partial area of a light emitting display device according to an embodiment.

FIG. 6 shows a portion of an embodiment of a light emitting display panel DP of a light emitting display device according to an embodiment, and the light emitting display panel DP may be a display panel for a mobile phone.

The display area DA is located on the front of the light emitting display panel DP, and a component area EA is also located within the display area DA.

Specifically, the component area EA may include a first component area EA1 and a second component area EA2.

In an embodiment, as shown in FIG. 6, the first component area EA1 may be located adjacent to the second component area EA2.

In an embodiment, as shown in FIG. 6, the first component area EA1 may be located to the left of the second component area EA2.

The location and number of the first component areas EA1 may vary in other embodiments.

In an embodiment shown in FIG. 6, the second optical element ES2 corresponding to the second component area EA2 may be a camera, and the first optical element ES1 corresponding to the first component area EA1 may be an optical sensor.

The display area DA includes a plurality of light emitting diodes and a plurality of pixel circuit parts that generate and transmit light emitting current to each of the plurality of light emitting diodes.

Here, one light emitting diode and one pixel circuit part may collectively define a pixel PX.

In the display area DA, one pixel circuit part and one light emitting diode are formed in a one-to-one correspondence.

The display area DA is hereinafter also referred to as the "normal display area."

Although the structure of the light emitting display panel DP below the cutting line is not shown in FIG. 6, the display area DA may be located below the cutting line.

The light emitting display panel DP according to an embodiment can be largely divided into a lower panel layer and an upper panel layer.

The lower panel layer is a part where the light emitting diode and the pixel circuit part that constitute the pixel are located, and may further include an encapsulation layer (see 400 in FIG. 7) covering the light emitting diode.

That is, the lower panel layer may include an anode, a pixel defining layer (see 380 in FIG. 7), a light emitting layer (see EML in FIG. 7), and a spacer (see 385 in FIG. 7) from the substrate (see 110 in FIG. 7) to the encapsulation layer, and may further include a functional layer (see FL in FIG. 7), a cathode (see Cathode in FIG. 7), an insulating layer between the substrate and the anode, a semiconductor layer, and a conductive layer.

In an embodiment, the upper panel layer is a part located above the encapsulation layer, includes a sensing insulating layer capable of detecting touch (see 501, 510, 511 in FIG. 7) and a plurality of sensing electrodes (see 540 and 541 in FIG. 7), and may further include a light blocking layer (see 220 in FIG. 7), a scattering layer (see 210 in FIG. 7), a color filter (see 230 in FIG. 7), and a planarization layer (see 550 in FIG. 7).

The first component area EA1 may include only a transparent layer to allow light to pass through, and may not include a conductive layer or semiconductor layer to allow light to pass therethrough, and may have an optical sensor area in the lower panel layer, a pixel defining layer, a light blocking layer and color filter layer of the upper panel layer and may have a structure that does not block light by forming an opening (hereinafter referred to as an additional opening) at a position corresponding to the first component area EA1.

In an embodiment, even if the optical sensor area is located in the lower panel layer, if no corresponding opening is defined in the upper panel layer, it may be considered as the display area DA rather than the first component area EA1.

One first component area EA1 may include a plurality of adjacent optical sensor areas, and in this case, pixels adjacent to the optical sensor area may be included in the first component area EA1.

In an embodiment, when the first optical element ES1 corresponding to the first component area EA1 uses IR rays rather than visible rays, the first component area EA1 overlaps the light blocking layer 220 that blocks visible rays.

The second component area EA2 may include a second-component pixel and a light transmission area, and the space between adjacent second-component pixels may be a light transmission area.

Although not shown in FIG. 6, a peripheral area may be further located outside the display area DA.

In addition, although FIG. 6 shows a display panel for a mobile phone, the embodiment described above can be applied to any display panel in which optical elements can be located on the back of the display panel, and it can also be a flexible display device.

In the case of a foldable display device among flexible display devices, the second component area EA2 and the first component area EA1 may be formed in positions different from those of FIG. 6.

Hereinafter, the structure of the light emitting display panel DP according to an embodiment will be described with reference to FIG. 7.

FIG. 7 is a schematic cross-sectional view of a display panel according to an embodiment.

The light emitting display panel DP according to an embodiment may display an image by light emitting diodes disposed on the substrate 110, can detect a touch by including a plurality of sensing electrodes 540 and 541, and also has color characteristics of the color filters 230R, 230G, 230B in the light emitted by the light emitting diode by including a light emitting diode, a light blocking layer 220 and a color filter 230R, 230G, 230B.

In an embodiment, as shown in FIG. 7, the light emitting display panel DP may further include a scattering layer 210 under the light blocking layer 220, and the scattering layer 210 can reflect or refract light by including scattering particles 211 therein.

The scattering layer 210 may be a colorless light transmitting layer that does not have a color in the visible light band.

In an embodiment, for example, the scattering layer 210 may include a colorless, light-transmitting organic material such as an acrylic resin. In an embodiment, the scattering layer 210 may include a transparent organic material that is photosensitive.

The scattering particles 211 can be formed of a material with a different refractive index than the scattering layer 210, and may include at least one material selected from titanium dioxide (TiO₂), silicon dioxide (SiOz), zirconium oxide (Zr₂O₃), aluminum oxide (Al₂O₃), hollow silica, acrylate-based materials, or silicon-based materials.

Here, the hollow silica may have a structure with hollow spaces inside of the silicon oxide (SiO₂) particle having a three-dimensional shape such as a sphere.

Also, on the front of the light emitting display panel DP according to an embodiment, a polarizer is not formed, but instead, a pixel defining layer 380 is formed with a black organic material, and a light blocking layer 220 and a color filter 230 are formed on the top so that even if external light enters the inside, the external light can be prevented from being reflected from the anode, etc., and transmitted to the user, and the scattering layer 210 is also located on the top, so when external light enters or is reflected, the external light can be scattered, thereby reducing the intensity of the external light.

A detailed feature of the light emitting display panel DP according to an embodiment is as follows.

The substrate 110 may include a material that has rigid properties and does not bend, such as glass, or may include a flexible material that can bend, such as plastic or polyimide.

A plurality of thin film transistors is disposed on the substrate 110, but the thin film transistors are omitted in FIG. 7 for convenience of illustration and only the organic layer 180 covering the thin film transistors is shown.

One pixel is defined by a light emitting diode and a pixel circuit part in which a plurality of transistors and capacitors that transmit light emitting current to the light emitting diode are formed.

In FIG. 7, the pixel circuit part is not shown, and the structure of the pixel circuit part may vary in embodiments.

In FIG. 7, the organic layer 180 in the pixel circuit part is shown.

A light emitting diode including an anode, an EML, and a cathode is located on the organic layer 180.

An anode may be composed of or defined by a single layer containing a transparent conductive oxide film and a metal material or a multiple layer containing these.

The transparent conductive oxide film may include at least one selected from indium tin oxide (ITO), poly-ITO, indium zinc oxide (IZO), indium gallium zinc oxide (IGZO), and indium tin zinc oxide (ITZO), and the metal material may include at least one selected from silver (Ag), molybdenum (Mo), copper (Cu), gold (Au), and aluminum (Al).

The light emitting layer EML may be formed of an organic light emitting material, and adjacent light emitting layers EML may display different colors from each other.

In another embodiment, each light emitting layer EML may emit light of a same color may different color lights may be generated through the color filters 230R, 230G, 230B located at the top.

In an embodiment, the light emitting layer EML may have a structure in which a plurality of light emitting layers are stacked (also called a tandem structure).

A pixel defining layer 380 is located on the organic layer 180 and the anode, and an opening OP is defined or formed in the pixel defining layer 380, the opening overlaps a part of the anode, and a light emitting layer EML is located above the anode exposed by the opening OP.

The light emitting layer EML can be located only within the opening OP of the pixel defining layer 380 and is separated from the adjacent light emitting layer EML by the pixel defining layer 380.

The pixel defining layer 380 may include or be formed of a negative-type black organic material.

The black organic material may include a light blocking material, and the light blocking material may include carbon black, carbon nanotubes, a resin or paste containing black dye, metal particles such as nickel, aluminum, molybdenum, and alloys thereof, metal oxide particles (e.g., chromium nitride), or the like.

The pixel defining layer 380 contains a light blocking material and is black in color, and may have characteristics of absorbing/blocking light rather than reflecting the light.

Because the negative type uses organic materials, it can have the property of removing areas covered by the mask.

A spacer 385 is formed on the pixel defining layer 380.

The spacer 385 includes a first part 385-1 that is protruded and located in a narrow area, and a second part 385-2 that is lower in height and is located in a wide area.

In FIG. 7, the first part 385-1 and the second part 385-2 are shown separately by a dotted line within the spacer 385.

Here, the first part 385-1 may serve to secure rigidity against pressing pressure by enhancing scratch strength.

The second part 385-2 may serve as a contact assistant between the pixel defining layer 380 and the upper functional layer FL.

The first part 385-1 and the second part 385-2 include or are made of a same material as each other, and may be made of a positive-type photosensitive organic material-for example, photosensitive polyimide (PSPI).

Because the positive-type photosensitive organic material has positive characteristics, parts not covered by the mask can be removed.

The spacer 385 is transparent so that light can be transmitted and/or reflected.

The pixel defining layer 380 may be formed as a negative type, and the spacer 385 may be formed as a positive type. In an embodiment, the pixel defining layer 380 and the spacer 385 may include a same material as each other.

At least a portion of the upper surface of the pixel defining layer 380 is covered by the spacer 385, and the edge of the second part 385-2 has a structure in which the edge of the pixel defining layer 380 is spaced apart from the edge of the pixel defining layer 380, and a portion of the pixel defining layer 380 has a structure that is not covered by the spacer 385.

The second part 385-2 covers even the upper surface of the pixel defining layer 380 where the first part 385-1 is not located, thereby strengthening the adhesion characteristics between the pixel defining layer 380 and the functional layer FL.

In an embodiment, the spacer 385 is located only in the area overlapping the light blocking layer 220 to be described later, so that when viewed from the front of the display panel DP, the spacer 385 may not be visible because the spacer 385 is hidden by the light blocking layer 220.

A functional layer FL is located on the spacer 385 and the exposed pixel defining layer 380, and the functional layer FL may be formed on the entire surface of the light emitting display panel DP, or in some areas-for example, the second component- the functional layer FL may be formed in all areas except the light transmitting area of the component area EA2.

The functional layer FL may include an electron injection layer, an electron transport layer, a hole transport layer, and a hole injection layer, and the functional layer FL may be located above and below the light emitting layer EML.

In other words, a hole injection layer, a hole transport layer, a light emitting layer EML, an electron transport layer, an electron injection layer, and a cathode may be sequentially located on the anode. In such an embodiment, the hole injection layer and the hole transport layer among the functional layers FL can be located below the light emitting layer EML, and the electron transport layer and the electron injection layer can be located above the light emitting layer EML.

The spacer 385 can increase the scratch resistance of the luminescent display panel DP and reduce the defect rate due to pressing pressure, and according to an embodiment, the spacer 385 can increase the adhesion with the functional layer FL located at the upper part of the spacer 385 to prevent moisture and air from being injected from the outside.

In addition, high adhesive strength may be desired for eliminating the problem of poor adhesion between layers when the light emitting display panel DP has flexible characteristics and is folded and unfolded.

The cathode may be formed as a light transmitting electrode or a reflective electrode.

In an embodiment, the cathode may be a transparent or translucent electrode, including at least one selected from lithium (Li), calcium (Ca), lithium/calcium fluoride (LiF/Ca), lithium/aluminum fluoride (LiF/AI), aluminum (Al), silver (Ag), magnesium (Mg), and their compounds, and the cathode can be formed as a metal thin film with a small work function.

In an embodiment, a transparent conductive oxide (TCO) film, such as indium tin oxide (ITO), indium zinc oxide (IZO), zinc oxide (ZnO), or indium oxide (In₂O₃), may be further disposed on the metal thin film.

The cathode may be formed integrally or commonly over the entire surface of the light emitting display panel DP.

An encapsulation layer 400 is located on the cathode.

The encapsulation layer 400 includes at least one inorganic layer and at least one organic layer, and in an embodiment, as shown in FIG. 7, the encapsulation layer 400 has a triple-layer structure including a first inorganic encapsulation layer 401, an organic encapsulation layer 402, and a second inorganic encapsulation layer 403.

The encapsulation layer 400 may protect the light emitting layer EML including or made of an organic material from moisture or oxygen that may enter from the outside.

In an embodiment, the encapsulation layer 400 may include a structure in which an inorganic layer and an organic layer are further sequentially stacked.

Sensing insulating layers 501, 510, 511 and a plurality of sensing electrodes 540, 541 are positioned on the encapsulation layer 400 for touch detection.

In an embodiment, as shown in FIG. 7, touch is sensed in a capacitive type using two sensing electrodes 540 and 541, but in another embodiment, touch can also be detected in a self-capacitive type using only one sensing electrode.

The plurality of sensing electrodes 540 and 541 may be insulated with a second sensing insulating layer 510 interposed therebetween, and a lower sensing electrode 541 is located on the first sensing insulating layer 501, and the second sensing insulating layer 510 is interposed between the plurality of sensing electrodes 540 and 541, an upper sensing electrode 540 is located on the sensing insulating layer 510, and the upper sensing electrode 540 is covered by a third sensing insulating layer 511.

The plurality of sensing electrodes 540 and 541 may be electrically connected through an opening defined or formed in the second sensing insulating layer 510.

Here, the sensing electrodes (540, 541) can include metals or metal alloys including aluminum (Al), copper (Cu), silver (Ag), gold (Au), molybdenum (Mo), titanium (Ti), tantalum (TA), etc., and can be defined by a single layer or multiple layers.

A scattering layer 210, a light blocking layer 220, and color filters 230R, 230G, 230B are positioned on the third sensing insulating layer 511.

In an embodiment, the light blocking layer 220 may be positioned to overlap the sensing electrodes 540 and 541 in a plan view, and may be positioned not to overlap the anode in a plan view.

Accordingly, in such an embodiment, the anode and the light emitting layer EML capable of displaying an image may not be obscured by the light blocking layer 220 and the sensing electrodes 540 and 541.

The scattering layer 210 can be positioned to overlap the light blocking layer 220 and the sensing electrodes (540, 541) in a planar manner, a part of the scattering layer 210 can overlap the anode in a planar manner, and a part may not overlap with the anode.

The scattering layer 210 may overlap the pixel defining layer 380 in a plan view.

The scattering layer 210 includes scattering particles 211 that can scatter light, and has an opening OPSL (also referred to as a scattering layer opening) that overlaps at least a portion of the opening OP of the pixel defining layer 380 in a plan view.

The size, shape, and arrangement direction of the opening OPSL of the scattering layer 210 may vary and will be described in greater detail later.

Referring to FIG. 7, in an embodiment, the light blocking layer 220 is preferably located only in the area that overlaps the pixel defining layer 380 in a plan view, and one side of the light blocking layer 220 extends inward from the corresponding side of the pixel defining layer 380.

The light blocking layer 220 may define an opening OPBM (hereinafter also referred to as the second opening), and the area of the second opening OPBM of the light blocking layer 220 is larger than the opening OP (also referred to as a first opening) of the pixel defining layer 380 in a plan view, and the opening OP of the pixel defining layer 380 and the light blocking layer 220 may be located within the second opening OPBM in the plan view.

In the plan view, the second opening OPBM of the light blocking layer 220 can be larger than the opening OPSL of the scattering layer 210, and at least a part of the second opening OPBM of the light blocking layer 220 can overlap the opening OPSL of the scattering layer 210.

In addition, one side of the spacer 385 is disposed inward from a corresponding side of the pixel defining layer 380 by a predetermined distance (g-1), and the spacer 385 is disposed on one side of the light blocking layer 220.

As a result, the spacer 385 may not be visible because the spacer 385 is obscured by the light blocking layer 220 when viewed from the front of the display panel DP.

When external light is incident, the external light passes through the second opening OPBM of the light blocking layer 220 and the opening OPSL of the scattering layer 210, and then is reflected from the side wall of the opening OP of the pixel defining layer 380.

The side wall of the opening OP of the pixel defining layer 380 is curved, and color separation occurs depending on the position of reflection, so that the reflected light can appear in various colors, such as a rainbow.

Such color-separated reflected light can be easily noticeable to the user's eye and may degrade the display quality. In an embodiment, the light can be scattered by the scattering particles 211 located in the scattering layer 210, thereby making it difficult for the user to recognize the reflected light.

In addition, as will be described later, the shape, size, and angle of the opening OPSL of the scattering layer 210 may be changed in various ways, and various openings OPSL of the scattering layer 210 are included in one panel, so it is possible to prevent reflected external light from forming a specific diffraction pattern.

As a result, it may be difficult for the user to recognize the reflection of external light, thereby reducing the deterioration of display quality due to reflected light.

This will be described in greater detail later.

In an embodiment, as shown in FIG. 7, the opening OPSL of the scattering layer 210 is larger than the opening OP of the pixel defining layer 380, and the second opening OPBM of the light blocking layer 220 is depicted as being larger than the opening OPSL of the scattering layer 210

However, the width relationship of these openings may vary depending on the shape, size, placement, and cross-section of each opening.

Color filters 230R, 230G, 230B are positioned on the sensing insulating layers 501, 510, 511, the scattering layer 210, and the light blocking layer 220.

The color filters 230R, 230G, 230B are a red-color filter 230R that transmits red light, a green-color filter 230G that transmits green light, and a blue-color filter 230B that transmits blue light.

Each of the color filters 230R, 230G, 230B may be positioned to overlap the anode of the light emitting diode in a plan view.

Since the light emitted from the emitting layer EML may change to a corresponding color as the light passes through a color filter, all light emitted from the emitting layer EML may have a same color as each other.

In another embodiment, where the light emitting layer EML emits light of different colors, the displayed color can be strengthened by passing through a color filter of the same color.

The light blocking layer 220 may be positioned between each color filter 230R, 230G, 230B.

In an embodiment, the color filters 230R, 230G, 230B may be replaced with a color conversion layer or may further include a color conversion layer.

The color conversion layer may include quantum dots.

A planarization layer 550 covering the color filters 230R, 230G, 230B is positioned on the color filters 230R, 230G, 230B.

The planarization layer 550 is provided to planarize the upper surface of the light emitting display panel, and may be a transparent organic insulating layer including at least one material selected from polyimide, polyamide, acrylic resin, benzocyclobutene, and phenol resin.

In an embodiment, a low refractive layer and an additional planarization layer may be further positioned on the planarization layer 550 to improve front visibility and light output efficiency of the display panel.

In an embodiment, light can be refracted and emitted toward the front by an additional flattening layer with a low refractive layer and a high refractive characteristic.

In such an embodiment, the planarization layer 550 may be omitted and a low refractive layer and an additional planarization layer may be located directly on the color filter 230.

In such an embodiment, a polarizer is not included on top of the planarization layer 550.

In other words, the polarizer can prevent display quality from deteriorating when external light is incident and reflected by the anode or the side wall of the opening OP of the pixel defining layer 380, which is visible to the user.

However, more power may be used to display a certain luminance due to the polarizer as the polarizer not only reduces the reflection of external light but also reduces the light emitted from the light emitting layer EML.

In an embodiment, the light emitting display device may not include a polarizer to reduce power consumption.

In an embodiment, a scattering layer 210 is formed under the light blocking layer 220, and the shape, size, and/or arrangement of the opening OPSL of the scattering layer 210 can be variously formed. When external light is incident or reflected, the external light is scattered by the scattering layer 210, to prevent the external light from forming a certain diffraction pattern, thereby preventing the degradation of display quality.

Therefore, in such an embodiment, the polarizer may not be separately formed on the front of the light emitting display panel DP.

In an embodiment, as shown in FIG. 7, the scattering layer 210 may be located between the third sensing insulating layer 511 and the light blocking layer 220, but in another embodiment, the scattering layer 210 may be formed at a different location.

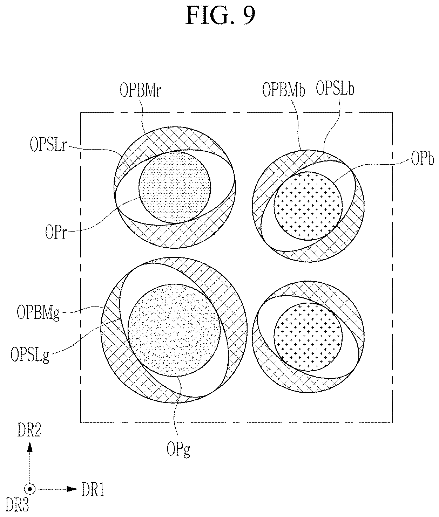

Hereinafter, an embodiment in which the opening OP of the pixel defining layer 380 and the second opening OPBM of the light blocking layer 220 are formed in a circular shape, and the opening OPSL of the scattering layer 210 is formed in an elliptical shape will be described based on the structure of the light emitting display panel DP formed in the display area DA through FIGS. 8 and 9.

FIG. 8 and FIG. 9 are plan views of a portion of a display panel according to an embodiment.

First, in FIG. 8, only the opening OP of one pixel defining layer 380, the corresponding second opening OPBM of one light blocking layer 220, and the opening OPSL of one scattering layer 210 are shown.

In an embodiment, as shown in FIG. 8, in a plan view or when viewed in the third direction DR3, the pixel defining layer 380 is located on the outer part of the opening OP, the scattering layer 210 is located on the outer part of the opening OPSL of the scattering layer 210, and the light blocking layer 220 is also located on the outer part of the second opening OPBM.

In FIG. 8, hatching is additionally shown to indicate a portion of the scattering layer 210 that is not obscured by the light blocking layer 220 and is visible from the front.

This hatch indicates the scattering layer 210 that is not covered by the light blocking layer 220 throughout the figures, and may indicate a portion where light can be scattered by scattering particles (see 211 in FIG. 7).

In an embodiment, as shown in FIG. 8, in the plan view, the opening OP of the pixel defining layer 380 and the second opening OPBM of the light blocking layer 220 have a circular planar shape, and the opening OPSL of the scattering layer 210 has an oval planar shape (e.g., an elliptical planar shape or a combination of elliptical planar shapes).

The elliptical opening OPSL of the scattering layer 210 has a structure tangential to the circular opening OP of the pixel defining layer 380 and the second opening OPBM of the light blocking layer 220 at two points each.

That is, the opening OPSL of the scattering layer 210 is circumscribed with the opening OP of the pixel defining layer 380 and has a structure that is inscribed with the second opening OPBM of the light blocking layer 220.

In an embodiment, as shown in FIG. 8, the radius value Rop of the circular shape of the opening OP of the pixel defining layer 380 is substantially the same as the length Ropsl1 of the semi-minor axis of the elliptical shape of the opening OPSL of the scattering layer 210, and is less than the length Ropsl2 of the semi-major axis of the elliptical shape.

In such an embodiment, the radius value Ropbm of the circular shape of the second opening OPBM of the light blocking layer 220 is greater than the length Ropsl1 of the semi-minor axis length of the elliptical shape of the opening OPSL of the scattering layer 210, and is equal to the length Ropsl2 of the semi-major axis of the elliptical shape.

The length Ropsl2 of the semi-major axis of the opening OPSL of the scattering layer 210 and the radius value Ropbm of the second opening OPBM of the light blocking layer 220 may be greater than the radius value Rop of the circular shape of the opening OP of the pixel defining layer 380, and the length Ropsl2 of the semi-major axis of the opening OPSL of the scattering layer 210 and the radius value Ropbm of the second opening OPBM of the light blocking layer 220 may be greater than the radius value Rop of the circular shape of the opening OP of the pixel defining layer 380 by at least 4.5µm and no more than 10µm.

The length Ropsl2 of the semi-major axis may vary in horizontal spacing depending on the thickness of the layer (e.g., encapsulation layer) located between the scattering layer 210 and the pixel defining layer 380, and the encapsulation layer can have a thickness of about 6 µm.

Here, the ellipse has two foci, and can have a shape connecting points where the sum of the distances to the two foci is constant, and can have a long (or major) axis and a short (or minor) axis.

In an embodiment, the eccentricity of an ellipse is the distance between two foci divided by the length of the long axis.

When the eccentricity is 0, it is a circle, and when it is 1, it forms a parabola, so an ellipse has an eccentricity value that is greater than 0 and less than 1.

The eccentricity value of the elliptical shape of the opening OPSL of the scattering layer 210 may vary in embodiments.

In embodiments, the direction of the long axis of the opening OPSL of the scattering layer 210 may also vary.

In an embodiment, as shown in FIG. 8, the opening OPSL of the scattering layer 210 is at two points in a plan view from the opening OP of the pixel defining layer 380 and the second opening OPBM of the light blocking layer 220. However, due to errors during actual processing, a portion of one side of the opening OP of the pixel defining layer 380 may be covered with the light blocking layer 220 without overlapping the second opening OPBM of the light blocking layer 220.

The opening OP of the pixel defining layer 380 having a same structure as that shown in FIG. 8, and the opening OPSL of the scattering layer 210, and the second opening OPBM of the light blocking layer 220 may be arranged as shown in FIG. 9 in the display area.

In FIG. 9, the opening OP of the pixel defining layer 380, the opening OPSL of the scattering layer 210, and the second opening OPBM of the light blocking layer 220, which correspond to each light emitting layer that displays the three primary colors of red, green, and blue, are distinguished and shown as an opening OPr, OPg, OPb of the scattering layer 210, an opening OPSLr, OPSLg, OPSLb, and a second opening OPBMr, OPBMg, OPBMb, respectively.

Here, r, g, and b may correspond to red, green, and blue, respectively.

In FIG. 9, as described above with reference to FIG. 8, the scattering layer 210 exposed by the second openings OPBMr, OPBMg, OPBMb of the light blocking layer is shown with hatching, and three different combinations are used to represent the red, green, and blue light emitting layers that can be exposed by the openings OPr, OPg, and OPb of the pixel defining layer, respectively.

In an embodiment, as shown in FIG. 9, the light emitting layer exposed by the openings OPr, OPg, OPb of the pixel defining layer 380 may not overlap the scattering layer 210.

The openings OPSLr, OPSLg, OPSLb of the scattering layer 210 may be arranged at various angles, and the openings OPSLr, OPSLg, OPSLb for red, green, and blue of the scattering layer 210 may be arranged at various angles, and may have different eccentricities from each other.

In an embodiment, the openings OPSLr, OPSLg, OPSLb of the scattering layer 210 of a same color may each be formed with a same eccentricity or may be formed with two or more different eccentricities.

In an embodiment, the red opening OPr, the green opening OPg, and the blue opening OPb of the pixel defining layer 380 and the red second opening OPBMr and the green second opening OPBMg, and the blue second opening OPBMb of the light blocking layer 220 may be formed as circles with different radii depending on the size of the openings OPSLr, OPSLg, OPSLb of the scattering layer 210, respectively.

In an embodiment, the openings OPr, OPg, OPb and the second openings OPBMr, OPBMg, OPBMb a same color may each have a same radius and be formed in a same size or may be formed in two or more different sizes.

The openings OPr, OPg, OPb of one pixel defining layer 380 are disposed inside the openings OPSLr, OPSLg, OPSLb of one scattering layer 210 and the second openings OPBMr, OPBMg, OPBMb of one light blocking layer 220.

That is, an opening of the scattering layer 210 corresponding to each of the second openings OPBMr, OPBMg, OPBMb of the light blocking layer 220 OPSLr, OPSLg, OPSLb and openings OPr, OPg, OPb of the pixel defining layer 380 are located within each of the second openings OPBMr, OPBMg, OPBMb of the light blocking layer 220.

The second openings OPBMr, OPBMg, OPBMb of each of the corresponding light blocking layers 220, the openings OPSLr, OPSLg, OPSLb of the scattering layer 210, and the openings OPr, OPg, OPb of the pixel defining layer 380 can overlap each other in a plan view.

In an embodiment, as described above with reference to FIG. 8, the elliptical-shaped openings OPSLr, OPSLg, OPSLb of the scattering layer 210 are disposed inside of and tangential to the circular openings OPr, OPg, OPb of the pixel defining layer 380. In addition, the elliptical-shaped openings OPSLr, OPSLg, OPSLb of the scattering layer 210 are disposed outside of and tangential to the circular-shaped second opening OPBMr, OPBMg, OPBMb of the light blocking layer 220.

In another embodiment, the openings OPSLr, OPSLg, OPSLb of the scattering layer 210 may be formed large or small, crossing the boundaries of the openings OPr, OPg, OPb of the pixel defining layer 380, and/or the boundaries of the second openings OPBMr, OPBMg, OPBMb of the light blocking layer 220 do not pass or meet each other.

Hereinafter, various modified embodiments will be discussed in detail.

In an embodiment, as shown in FIG. 9, the openings OPSLr, OPSLg, OPSLb of the scattering layer 210 are arranged in various directions, and the angles at which the openings OPSLr, OPSLg, OPSLb of the scattering layer 210 are arranged can be described based on the direction of the long (or major) axis of the ellipse. That is, an arrangement direction of the openings OPSLr, OPSLg, OPSLb of the scattering layer 210 may be the same as a direction of the long axis of the openings OPSLr, OPSLg, OPSLb having an elliptical shape.

According to an embodiment, long axes of the openings OPSLr, OPSLg, OPSLb of the scattering layer 210 can have four or more different angles or direction, and also, the angle formed by the long axis can be arranged at intervals of 45 degrees or less.

Hereinafter, the relationships in an embodiment with five angles will be described.

In such an embodiment with five angles, angles (or arrangement directions) of the long axis may be determined based on intervals of 36 degrees. That is, if one long axis has (or is arranged to form an angle of) 0 degrees based on the first direction DR1, the other long axes may have angles of 36 degrees, 72 degrees, 108 degrees, and 144 degrees based on the first direction DR1, for a total of five angles.

In other words, by dividing the 180-degree angle by the number of directions, which is 5, the spacing (different) between the angles of the long axis can be determined. This is because the two angles that have a 180-degree angle difference out of the 360-degree angle are essentially the same as the direction of the long axis of the ellipse, so it means that it is calculated by dividing by the number based on 180 degrees.

In an embodiment, as described above, where the number of angles formed by the long axes of the openings OPSLr, OPSLg, OPSLb of the scattering layer 210 is four, the long axes can be arranged at intervals of 45 degrees.

In an embodiment, the angle formed by the long axis of each second opening OPBMr, OPBMg, OPBMb may be one of 45 degrees or less, and may be arranged at irregular intervals.

An embodiment in which the long axes of the openings are arranged at irregular intervals may be intentionally arranged to reduce the diffraction pattern, or may be arranged at irregular intervals due to processing errors.

In an embodiment, in order to have the unit pixel including the openings of red, green, and blue to have a square structure, it may be appropriate to form the unit pixel by distinguishing the number corresponding to the square of the integer for the angle of the long axis-for example, 2², 3², 4², 5², and so on.

Here, the unit pixel may include at least each of red, green, and blue openings, and a plurality of openings of one color-for example, green openings may be formed.

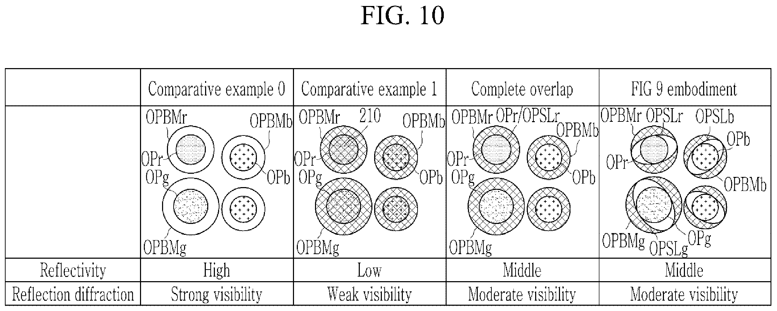

In this way, the openings OPr, OPg, OPb of the pixel defining layer 380 and the second opening OPBMr, OPBMg, OPBMb of the light blocking layer 220 are formed in a circular shape. The reflection characteristics will be described with reference to FIG. 10 in which the openings OPSLr, OPSLg, OPSLb of the scattering layer 210 are formed in an elliptical shape.

FIG. 10 is a table showing the characteristics of comparative examples and embodiments.

In FIG. 10, characteristics of the embodiment of FIG. 9 and three comparative examples (comparative example 0, comparative example 1, and completely overlapped) are shown.

In comparative example 0, only the openings OPr, OPg, OPb of the pixel defining layer 380 and the second openings OPBMr, OPBMg, OPBMb of the light blocking layer 220 are formed in a circular shape, and the scattering layer 210 is not included.

In comparative example 1, the openings OPr, OPg, OPb of the pixel defining layer 380 and the second openings OPBMr, OPBMg, OPBMb of the light blocking layer 220 are formed in a circular shape, and the scattering layer 210 is also included, the scattering layer 210 is formed over the entire area, so no opening is formed in the scattering layer 210.

In a comparative example of complete overlapping (also referred to as completely overlapped comparison example), the openings OPr, OPg, OPb of the pixel defining layer 380 and the second openings OPBMr, OPBMg, OPBMb of the light blocking layer 220 are formed in a circular shape, and the openings OPBMr, OPBMg, OPBMb of the light blocking layer 220 are formed in a circular shape and are formed in the scattering layer 210, and as the openings OPSLr, OPSLg, OPSLb are formed in a circular shape, the openings OPr, OPg, OPb of the pixel defining layer 380 and the openings OPSLr, OPSLg, OPSLb of the scattering layer 210 completely overlap.

A comparison of this comparative example with the embodiment of FIG. 8 is as follows.

Comparative example 0 has an undesired characteristic in that the reflectance is high, so the diffraction pattern generated when external light is reflected is easily visible to the user.

By comparison, in comparative example 1, the completely overlapping comparative example, and the embodiment of FIG. 9 include a scattering layer 210, so the intensity of the diffraction pattern may be reduced as external light is scattered.

The degree of scattering of external light can be most significantly reduced when the scattering layer 210 is located across the entire area as in comparative example 1, but in comparative example 1, the light transmitted from the light emitting diode to the front is also scattered, reducing the display efficiency, and there is a drawback of recognizing separate diffraction patterns, such as a rainbow-colored diffraction pattern.

In order to overcome the undesired characteristic of comparative example 1, an opening may be formed in the scattering layer 210.

In the complete overlapping comparative example and FIG. 9, each have openings OPSLr, OPSLg, OPSLb formed in the scattering layer 210, so most of the light transmitted from the light emitting diode to the front is not scattered, eliminating the degradation of display quality similar to comparative example 1. However, there are areas where the scattering layer 210 is not formed, so the reflectance of external light is higher than comparative example 1, but lower than comparative example 0, and the diffraction pattern occurring as the external light is reflected can be recognized with a moderate intensity.

Therefore, the completely overlapped comparative example and the embodiment of FIG. 9 in which openings OPSLr, OPSLg, OPSLb are formed in the scattering layer 210 may be desired in that the diffraction pattern of external light is weaker than the case without the scattering layer 210, while scattering unlike comparative example 1 in which no opening is formed in the layer 210, it has the advantage of not forming a rainbow-colored diffraction pattern.

The difference between the completely overlapped comparison example and FIG. 9 lies in whether the openings OPr, OPg, OPb of the pixel defining layer 380 and the openings OPSLr, OPSLg, OPSLb of the scattering layer 210 completely match in a plan view or have some differences.

In addition, in the completely overlapping comparative example, all openings are circular and formed uniformly at all angles, but in the embodiment of FIG. 9, the openings OPSLr, OPSLg, OPSLb of the scattering layer 210 having an elliptical shape are formed at various angles. Alternatively, the size or shape can be changed by changing the eccentricity, so that the diffraction pattern is not generated uniformly, the undesired characteristics of the diffraction pattern being visible is further improved, and it may become difficult for the user to see the diffraction pattern.

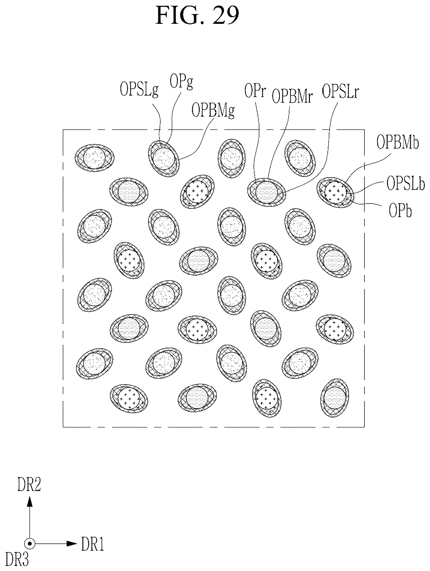

An embodiment of forming an oval-shaped opening at various angles or eccentricities will be described later with reference to FIGS. 29 to 34.

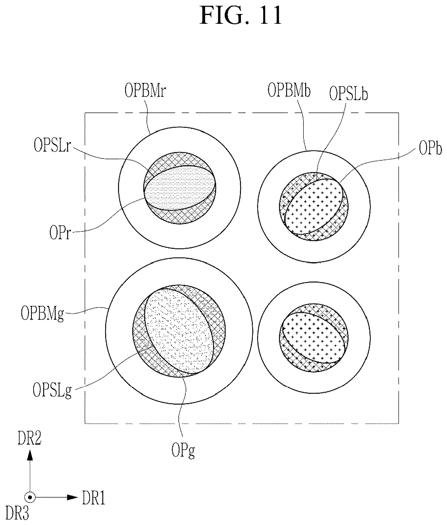

In another embodiment, the openings OPSLr, OPSLg, OPSLb of the scattering layer 210 may be located only within the openings OPr, OPg, OPb of the pixel defining layer 380. Such an embodiments will hereinafter be described with reference to FIG. 11.

FIG. 11 is a plan view of a portion of a display panel according to another embodiment.

In an embodiment of FIG. 11, as described above with reference to FIG. 8, the openings OPr, OPg, OPb of the pixel defining layer 380 and the second openings OPBMr, OPBMg, OPBMb of the light blocking layer 220 are flat, the shape is circular, and the openings OPSLr, OPSLg, OPSLb of the scattering layer 210 have an elliptical shape in a plan view.

In such an embodiment, as shown in FIG. 11, the openings OPSLr, OPSLg, OPSLb of the elliptical -shaped scattering layer 210 are located within the openings OPr, OPg, OPb and have a structure that contacts the openings OPr, OPg, OPb of the pixel defining layer 380 at two points.

That is, the openings OPSLr, OPSLg, OPSLb of the scattering layer 210 have a structure tangential to the openings OPr, OPg, OPb of the pixel defining layer 380.

In FIG. 11, the hatching indicating the scattering layer 210 exposed by the second openings OPBMr, OPBMg, OPBMb of the light blocking layer 220 is located within the hatching showing each light emitting layer that can be individually exposed by the openings OPr, OPg, OPb of the pixel defining layer 380.

As a result, in such an embodiment, some of each light emitting layer overlaps the scattering layer 210 in a plan view, and the remaining portion overlaps the openings OPSLr, OPSLg, OPSLb of the scattering layer 210.

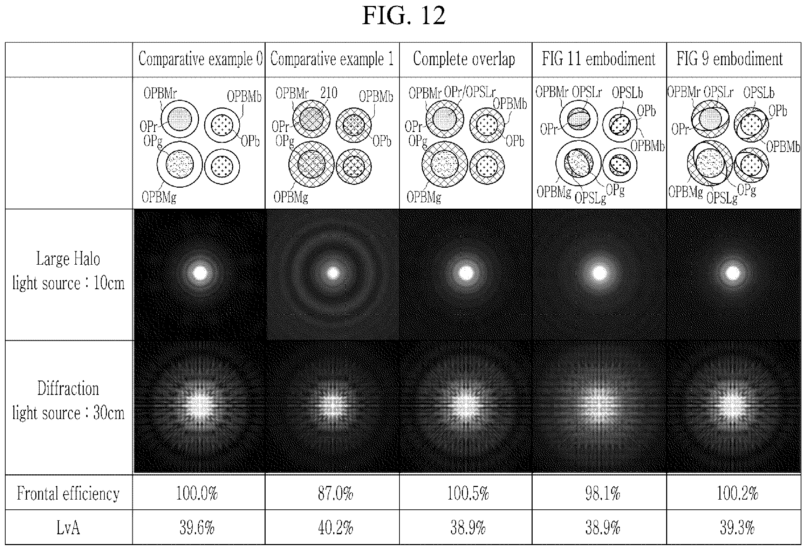

The table of FIG. 12 shows the characteristics of the embodiment of FIG. 11 in addition to comparative example 0, comparative example 1, the completely overlapped comparative example, and the embodiment of FIG. 9.

FIG. 12 is a table showing the photographed reflection characteristics of a comparative example and an embodiment.

FIG. 12 includes photographs of reflection characteristics of the embodiment of FIG. 11 as well as comparative example 0, comparative example 1, the completely overlapped comparative example, and the embodiment of FIG. 9, which are shown in FIG. 10.

In FIG. 12, two pictures are included, one of which is taken with external light provided at 10 centimeters (cm), and the other being taken with external light provided at 30 cm.

Here, the photo taken at 10 cm shows the size and intensity of the halo that occurs around strong light, and the photo taken at 30 cm shows the characteristic of external light being reflected and diffracted.

Additionally, in FIG. 12, frontal efficiency and LvA value are shown.

Here, the front efficiency is the front luminance ratio in each comparative example and embodiments with the front luminance of comparative example 0 set to 100%. The LvA value is an abbreviation denoting a value for luminance versus angle, which is the luminance ratio at an angle of 45 degrees to the front luminance.

Referring to FIG. 12, the difference in diffraction patterns between the comparative example and the embodiments can be seen more clearly in a photograph taken by placing external light at a close position (10 cm).

In comparative example 0, the gap between the diffraction patterns is not large, but the ring-shaped halo is clearly visible, and in comparative example 1, a rainbow-colored diffraction pattern is visible.

In contrast, it can be confirmed that the diffraction patterns of the completely overlapped comparative examples and the examples of FIGS. 9 and 11 in which openings OPSLr, OPSLg, OPSLb are formed in the scattering layer 210 are relatively weakly visible.

However, referring to FIG. 12, it can be seen that the diffraction pattern is weakly visible even in the completely overlapped comparative example and the embodiments of FIGS. 9 and 11, so it may be desired to make the diffraction pattern weaker.

Unlike the completely overlapping comparative examples, the embodiments of FIGS. 9 and 11 include an elliptical -shaped opening, and the elliptical shape is arranged at various angles or formed at various eccentricities, the diffraction pattern is formed blurred while less constructive interference occurs.

Therefore, in a light emitting display device according to an embodiments of FIGS. 9 and 11, if the angles of the elliptical openings are randomly arranged, it can have an improved diffraction pattern compared to the photographs taken in FIG. 12, and it can have an improved diffraction pattern even compared to the completely overlapping comparison example.

In an embodiment, if the eccentricity, shape, or size of the elliptical -shaped opening is formed in various ways in the light emitting display device including the embodiment of FIGS. 9 and 11, it may have an improved diffraction pattern compared to the photograph taken in FIG. 12 and the completely overlapping comparative example.

In FIG. 12, it can be seen that comparative example 1 has the lowest frontal efficiency, and the completely overlapping comparative example, the embodiment of FIG. 9, and the embodiment of FIG. 11 have frontal luminance equivalent to comparative example 0.

In particular, when the openings OPSLr, OPSLg, OPSLb of the scattering layer 210 are tangential to the openings OPr, OPg, OPb of the pixel defining layer 380, as in the embodiment of FIG. 9, the frontal efficiency is 100.2% exceeding 100%, so it can be confirmed that the frontal efficiency can be kept high while having an improved diffraction pattern.

Additionally, referring to the LvA value, it can be seen that the luminance at 45 degrees of the embodiments of FIGS. 9 and 11 is almost similar to that of comparative example 0, so even if the embodiments of FIGS. 9 and 11 are applied to a light emitting display device, it can be confirmed that there is no problem of deteriorating display quality at the 46-degree viewing angle.

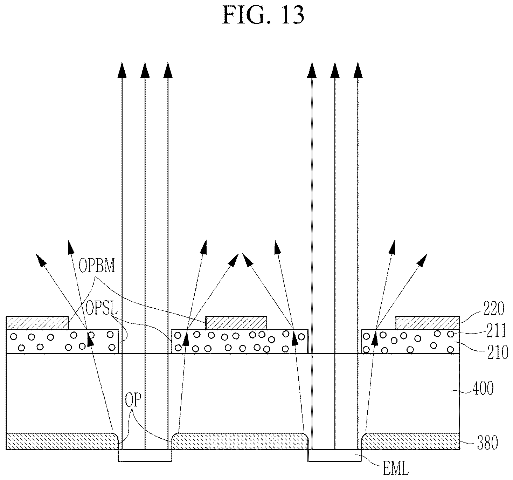

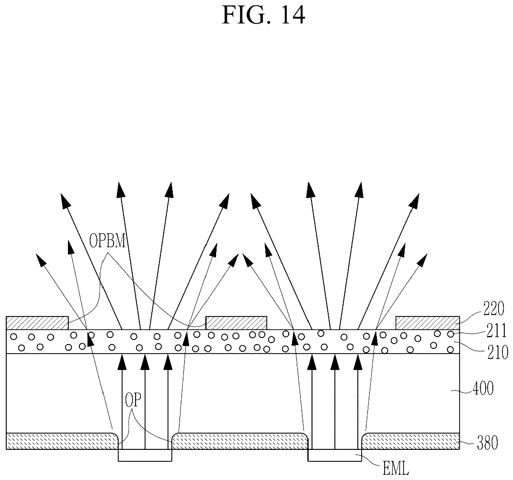

This difference in frontal efficiency will now be described with reference to FIGS 13 and 14.

FIG. 13 is an enlarged cross-sectional view of a portion of a display panel according to an embodiment, and FIG. 14 is an enlarged cross-sectional view of a portion of a display panel according to a comparative example.

FIG. 13 shows a structure in which an opening OPLS is formed in the scattering layer 210 as in the completely overlapped comparative example, the embodiment of FIG. 9, and the embodiments of FIG. 11, and FIG. 14 show a structure without an opening in the scattering layer 210 as in comparative example 1.

FIG. 13 and FIG. 14 schematically show only the light emitting layer EML, the pixel defining layer 380, the encapsulation layer 400, the scattering layer 210 and the light blocking layer 220, where the scattering layer 210 includes a plurality of scattering particles 211.

The opening OP of the pixel defining layer 380 and the second opening OPBM of the light blocking layer 220 are provided in both FIGS. 13 and 14, but in the embodiment of FIG. 13, unlike comparative example 1 of FIG. 14, an opening OPLS is further formed in the scattering layer 210.

As shown in FIGS. 13 and 14, the front luminance can be improved as the light emitted from the light emitting layer EML is provided to the front rather than being refracted to the side due to the opening OPLS of the scattering layer 210.

Therefore, just like the frontal efficiency value of FIG. 12, the completely overlapping comparative example, the embodiment of FIG. 9, and the embodiment of FIG. 11 have a frontal luminance equivalent to comparative example 0, and it can be seen that the frontal efficiency decreases as more light is scattered to the side as shown in comparative example 1.

Referring to FIGS. 10 and 12, a light emitting display device that does not include a polarizer on the front surface may have desired characteristics in terms of thickness and manufacturing cost, but it has the undesired characteristics in that a diffraction phenomenon is strongly visible due to the high reflectivity of external light.

In order to overcome the diffraction phenomenon, in an embodiment, the scattering layer 210 is provided to scatter external light and/or diffraction light to reduce the diffraction pattern and reduce the visibility of the diffraction pattern.

However, if the scattering layer 210 is applied to cover the entire surface as in comparative example 1, reflection diffraction can be reduced, but the light emitted to the front for display is also scattered, resulting in a decrease in frontal efficiency.

In order to improve frontal efficiency, in an embodiment, an opening OPSL is formed in the scattering layer 210.

A diffraction phenomenon mainly occurs at the edge of the opening (opening OP of the pixel defining layer 380, second opening OPBM of the light blocking layer 220, and/or opening OPSL) of the scattering layer 210, and therefore, the diffraction phenomenon can be further reduced by not applying the scattering layer to the entire surface and by not forming a constant gap between the openings as in the embodiment of FIGS 9. and 11 or by removing the directionality.

Therefore, in embodiments, an opening OPSL of a scattering layer 210 can be formed in the central portion of the light emitting layer EML (opening OP of the pixel defining layer 380) to reduce diffraction and minimize the reduction in frontal efficiency.

In such embodiments, the size and positional relationship of the opening OP of the pixel defining layer 380, the second opening OPBM of the light blocking layer 220, and the opening OPSL of the scattering layer 210 can be arranged in various ways. In the case of an ellipse, there may be various embodiments in which the direction of the long axis or eccentricity, etc. are changed.

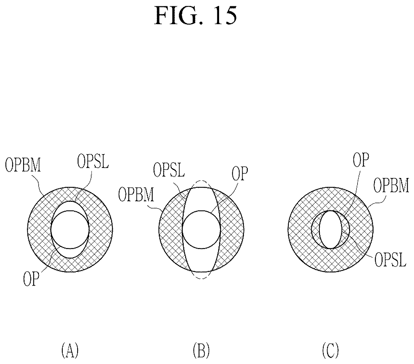

Hereinafter, various embodiments will be described with reference to FIGS. 15 to 28.

FIG. 15 to FIG. 28 are plan views of a portion of a display panel according to another embodiment.

First, embodiments of FIGS. 15 to 17 will be described.

In FIGS. 15 to 17, the part shown with a dotted line of the opening OPSL of the scattering layer 210 represents the part blocked by the light blocking layer 220, and the hatched part represents a part of the scattering layer 210 that is exposed by the second opening OPBM of the light blocking layer 220.

In an embodiment, as shown in FIG. 15 to FIG. 17, the opening OP of the pixel defining layer 380 and the second opening OPBM of the light blocking layer 220 are formed in a circular planar shape, and the opening OPSL of the scattering layer 210 has a circular shape. Various embodiments are shown in which the planar shape is elliptical.

FIG. 15 to FIG. 17 are modified embodiments of FIG. 8, where, as in FIG. 8, the opening OPSL of the scattering layer 210 is peripheral to the opening OP of the pixel defining layer 380, and the light blocking layer 220 does not contain a structure peripheral to the second opening OPBM.

FIG. 15 illustrates various embodiments in which the opening OPSL of the scattering layer 210 only contacts the opening OP of the pixel defining layer 380.

FIG. 15(A) shows an embodiment in which the opening OPSL of the scattering layer 210 is tangential to the opening OP of the pixel defining layer 380, but does not contact the second opening OPBM of the light blocking layer 220, and the opening OPSL of the scattering layer 210 is located within the second opening OPBM of the light blocking layer 220.

FIG. 15(B) shows an embodiment in which the opening OPSL of the scattering layer 210 is tangential to the opening OP of the pixel defining layer 380, but does not contact the second opening OPBM of the light blocking layer 220, and a portion of the opening OPSL of the scattering layer 210 is located outside the second opening OPBM of the light blocking layer 220.

FIG. 15(C) corresponds to the embodiment of FIG. 11 and shows an embodiment in which the opening OPSL of the scattering layer 210 is tangential to the opening OP of the pixel defining layer 380.

In such an embodiment, as shown in FIG. 15(C), the opening OPSL of the scattering layer 210 is located only within the opening OP of the pixel defining layer 380.

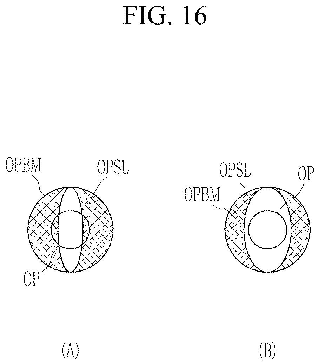

FIG. 16 shows various embodiments in which the opening OPSL of the scattering layer 210 only contacts the second opening OPBM of the light blocking layer 220.

FIG. 16(A) shows an embodiment in which the opening OPSL of the scattering layer 210 is tangential to the second opening OPBM of the light blocking layer 220, but does not contact the opening OP of the pixel defining layer 380, and a part of the opening OP of the pixel defining layer 380 is obscured by the scattering layer 210.

In such an embodiment, some of the openings OP of the pixel defining layer 380 may not overlap the openings OPSL of the scattering layer 210 in a plan view.

FIG. 16(B) shows an embodiment in which the opening OPSL of the scattering layer 210 is tangential to the second opening OPBM of the light blocking layer 220, but is not tangential to the opening OP of the pixel defining layer 380, and the opening OP of the defining layer 380 is not obscured by the scattering layer 210.

In such an embodiment, the opening OP of the pixel defining layer 380 is located within the opening OPSL of the scattering layer 210 in a plan view.

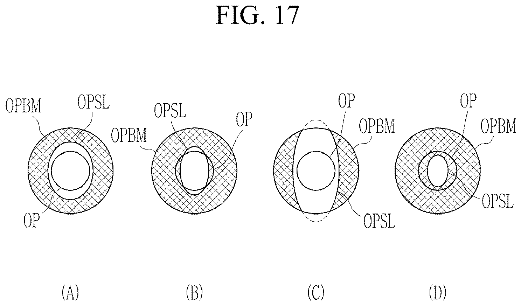

In FIG. 17, various embodiments are shown in which the opening OPSL of the scattering layer 210 does not contact either the second opening OPBM of the light blocking layer 220 or the opening OP of the pixel defining layer 380.

FIG. 17(A) shows an embodiment in which the opening OPSL of the scattering layer 210 does not contact the second opening OPBM of the light blocking layer 220 or the opening OP of the pixel defining layer 380, and the opening OP of the pixel defining layer 380 is not obscured by the scattering layer 210.

In such an embodiment, the opening OP of the pixel defining layer 380 is located within the opening OPSL of the scattering layer 210 in a plan view, and the opening OPSL of the scattering layer 210 is located within the second opening OPBM of the light blocking layer 220.

FIG. 17(B) shows an embodiment in which the opening OPSL of the scattering layer 210 does not contact the second opening OPBM of the light blocking layer 220 or the opening OP of the pixel defining layer 380, and a part of the opening OP of the pixel defining layer 380 is obscured by the scattering layer 210.

In such an embodiment, a part of the opening OP of the pixel defining layer 380 is located within the opening OPSL of the scattering layer 210, and a portion of the opening OPSL of the scattering layer 210 is located within the opening OPSL of the scattering layer 210, it is located outside the opening OP of the pixel defining layer 380 in a plan view.

In such an embodiment, the opening OPSL of the scattering layer 210 is located within the second opening OPBM of the light blocking layer 220 in a plan view.

FIG. 17(C) shows an embodiment in which the opening OPSL of the scattering layer 210 does not contact the second opening OPBM of the light blocking layer 220 and the opening OP of the pixel defining layer 380, and the opening OP of the pixel defining layer 380 is not obscured by the scattering layer 210, but some of the opening OPSL of the scattering layer 210 is shown to be located outside the second opening OPBM of the light blocking layer 220.

FIG. 17(D) shows an embodiment in which the opening OPSL of the scattering layer 210 does not contact the second opening OPBM of the light blocking layer 220 or the opening OP of the pixel defining layer 380, and the opening OPSL of the scattering layer 210 is located within the opening OP of the pixel defining layer 380 in a plan view.

FIG. 15 to FIG. 17 show embodiments in which the opening OPSL of each scattering layer 210, the second opening OPBM of the light blocking layer 220, and the opening OP of the pixel defining layer 380 correspond to each other.

In such embodiments, the opening OPSL of the scattering layer 210 having an elliptical shape may be arranged in various arrangement (long-axis) directions.

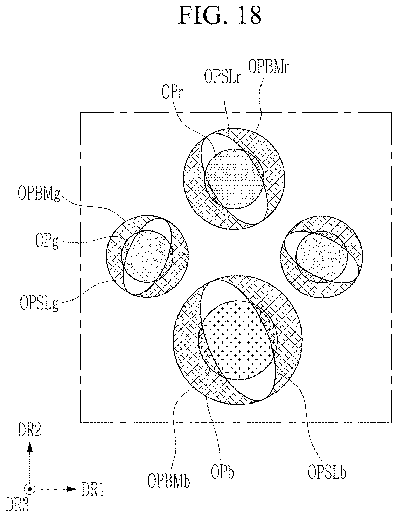

One of the embodiments formed in various long-axis directions will be described with reference to FIG. 18.

FIG. 18 shows an embodiment of one unit pixel in which the embodiment of FIG. 16(A) is arranged. In such an embodiment, the circular shape and elliptical shape of different colors have different sizes and/or eccentricities, and the elliptical shape of a same color has different sizes and/or eccentricities, the arrangement (or long-axis) directions of the shapes have different structures.

In FIG. 18, the scattering layer 210 exposed by the second openings OPBMr, OPBMg, OPBMb of the light blocking layer 220 is represented by diagonal lines, and also, the red, green, and blue light emitting layers exposed by the openings OPr, OPg, OPb of the pixel defining layer 380 are represented by separate diagonal lines.

As a result, in the embodiment of FIG. 18, a portion of the light emitting layer of each color has a structure that overlaps the scattering layer 210 in a plan view.

In the embodiment of FIG. 18, the circle and elliptical shapes of a same color have a same size and eccentricity as each other, and the long-axes of the elliptical shapes are arranged differently from each other.

That is, in FIG. 18, two green openings OPg of the pixel defining layer 380 are shown, and the two green openings OPg of the pixel defining layer 380 have a same area or radius length as each other, thereby blocking light, and the two green second openings OPBMg of light blocking layer 220 also have a same area or radius length as each other.

In an embodiment, the two green openings OPSLg of the scattering layer 210 are formed in an elliptical shape with a same eccentricity, but the long axes of the elliptical shapes are arranged in different directions.

That is, in such an embodiment, the openings OPSLr, OPSLg, OPSLb of the scattering layer 210 having a same color and elliptical shape may have a same eccentricity as each other, but have different long-axis directions.

In an embodiment, where the long-axis direction of the openings OPSLr, OPSLg, OPSLb of the scattering layer 210 are arranged in various ways as shown in FIG. 18, it is possible to prevent external light from forming a constant diffraction pattern and thereby prevent deterioration of display quality.

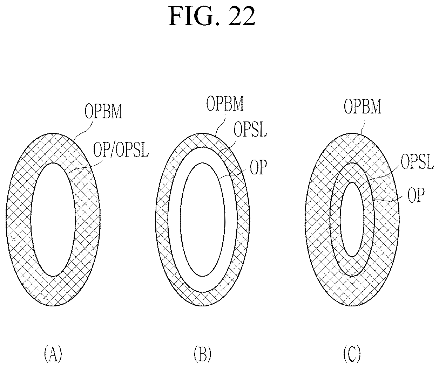

Specifically, the embodiment of FIG. 22 may have reflection characteristics of external light similar to the embodiment of FIG. 9 described as described above with reference to FIG. 10 or FIG. 12, the diffraction pattern is weaker than that of comparative example 0, so the diffraction pattern is not easily visible, and the frontal efficiency is reduced. Thus, it may have improved characteristics over comparative example 1.

In addition, the elliptical shape can be formed to have an improved diffraction pattern of external light by arranging the long-axis directions in various ways.

In an embodiment, circle shapes and elliptical shapes of the same color may be formed to have different sizes and eccentricities from each other.

That is, in another embodiment, the two green openings OPg of the pixel defining layer 380 have different areas or radial lengths from each other, and the two green second openings OPBMg of the light blocking layer 220 also have different areas and radius lengths from each other, and the two green openings OPSLg of the scattering layer 210 may be formed in elliptical shapes with different eccentricities from each other.

In such an embodiment, the two long axes of the green opening OPSLg of the scattering layer 210 may be arranged in a same direction or in different directions.

Since such an embodiment has more elliptical -shape variations than the embodiment of FIG. 18, external light may not form a constant diffraction pattern and deterioration of display quality can be more effectively prevented.

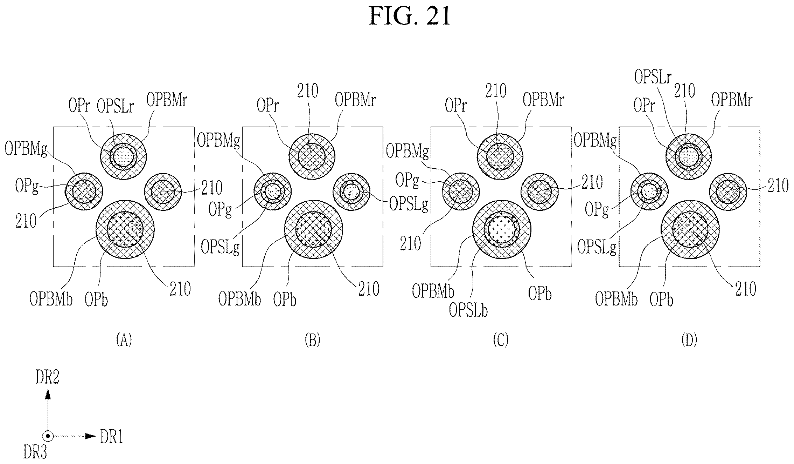

In an embodiment, at least one of the openings OPSLr, OPSLg, OPSLb of the scattering layer 210 may be omitted as in comparative example 1 of FIG. 10, and in an embodiment, the scattering layer 210 of a same color may be omitted. In an embodiment, only some of the openings OPSLr, OPSLg, OPSLb are omitted, and some may have a structure including the opening (see FIG. 21).

In such an embodiment, as described above, the eccentricity of the openings OPSLr, OPSLg, OPSLb of the scattering layer 210 having an elliptical shape may have a value greater than 0 and less than 1, and the angle formed by each long axis has four or more angles, the angle formed by the long axis may be arranged at regular angular intervals of 45 degrees or less.

In an embodiment, the angle formed by the long axis of the elliptical shape may be one of 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

In an embodiment, the maximum horizontal gap between the openings may be about 4.5µm or greater and about 10µm or less.

In the embodiment of FIG. 18, a total of four pixels including red, green, and blue openings are included in one unit pixel. In such an embodiment, two green openings are included, and one red opening and one blue opening are included.

However, the color of two pixels having same color in one unit pixel may be red or blue, and the positions of each of the four openings may be arranged differently from that shown in FIG. 18.

In an embodiment, the unit pixel may be formed as a unit pixel including only one red opening, one green opening, and one blue opening.

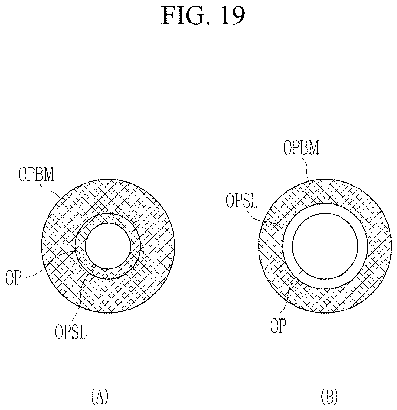

Hereinafter, an embodiment where the planar shapes of the opening OP of the pixel defining layer 380, the second opening OPBM of the light blocking layer 220, and the opening OPSL of the scattering layer 210 are all formed in a circular shape will be described with reference to FIGS. 19 to 21.

In such embodiments, the opening OP of the pixel defining layer 380, the second opening OPBM of the light blocking layer 220, and the opening OPSL of the scattering layer 210 have centers of circles that coincide with each other in a plan view.

That is, although FIGS. 19 to 21 illustrate an embodiment having a structure in which the centers of all circles coincide, but in another embodiment, the centers of the circles may not coincide with each other.

FIG. 19 shows embodiments where the size of the opening OP of the pixel defining layer 380 and the second opening OPBM of the light blocking layer 220 are the same as each other, while only the size of the opening OPSL of the scattering layer 210 is changed as shown separately in FIGS. 19(A) and 19(B).

In an embodiment, as shown in FIG. 19(A), the opening OPSL of the scattering layer 210 is formed as the smallest, and the opening OPSL of the scattering layer 210 is within the opening OP of the pixel defining layer 380.

As a result, in such an embodiment, the portion (hatched) of the scattering layer 210 exposed by the second opening OPBM of the light blocking layer 220 has a structure that overlaps the opening OP of the pixel defining layer 380 in a plan view.

In an embodiment, as shown in FIG. 19(B), the opening OPSL of the scattering layer 210 is larger than the opening OP of the pixel defining layer 380 and is smaller than the second opening OPBM of the light blocking layer 220. Thus, the opening OP of the pixel defining layer 380 is located within the opening OPSL of the scattering layer 210.

As a result, in such an embodiment, the portion (hatched) of the scattering layer 210 exposed by the second opening OPBM of the light blocking layer 220 has a structure that does not overlap the opening OP of the pixel defining layer 380 in a plan view.

In another embodiment, the opening OPSL of the scattering layer 210 may be formed to coincide with the opening OP of the pixel defining layer 380 in a plan view.

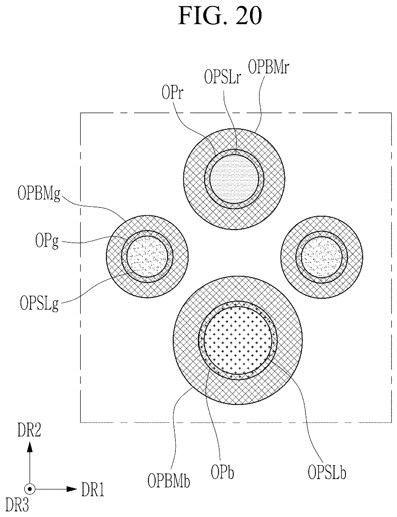

In FIG. 20, an embodiment of one unit pixel in which the embodiment of FIG. 19(A) is arranged.

The embodiment of FIG. 20 may have reflection characteristics of external light similar to the completely overlapped comparative example described above with reference to FIG. 10 or FIG. 12, the diffraction pattern is weaker than that of comparative example 0, so the diffraction pattern is not easily visible, and the frontal efficiency is similar to that of comparative example 1, so it can have further improved characteristics.

In such an embodiment, as shown in FIG. 20, the sizes of circles of different colors are different from each other, and the sizes of circles of a same color are the same as each other.

However, in another embodiment, the sizes of circles of a same color may be different from each other.

In such an embodiment, unlike FIG. 20, the two green openings OPg of the pixel defining layer 380 have different areas or radial lengths, and the two green second openings OPBMg of the light blocking layer 220 also have different areas or radial lengths, and the two green openings OPSLg of the scattering layer 210 may also be formed in a circular shape with different areas or radial lengths.

In an embodiment, as shown in FIG. 20, the opening OP of the pixel defining layer 380, the second opening OPBM of the light blocking layer 220, and the opening OPSL of the scattering layer 210 have the center of a circle matching each other in a plan view.

In such an embodiment where the centers of the circles coincide with each other in a plan view, there is no difference in the degree to which light is scattered by being covered with the scattering layer 210 depending on the user's viewing direction, which may allow to have display quality independent of the viewing angle.

In another embodiment, where the centers of the circles may not coincide with each other in a plan view, but the centers of the circles do not match on a consistent basis, differences in display quality may occur depending on the user's viewing direction, such that the centers of the circles are randomly changed, differences in display quality depending on the angle due to the centers that does not coincide with each other can be effectively prevented.

In the embodiment of FIG. 20, a total of four unit pixels including red, green, and blue openings are included in one unit pixel. In such an embodiment, two green openings are included, and one red opening and one blue opening are included.

However, the color of the two pixels having a same color in one unit pixel may be red or blue, and the positions of each of the four openings may be arranged differently from FIG. 20.

In another embodiment, the unit pixel may be formed as a unit pixel including only one red opening, one green opening, and one blue opening.

In another embodiment, at least one of the openings OPSLr, OPSLg, OPSLb of the scattering layer 210 may be omitted as in comparative example 1 of FIG. 10, and such an embodiment will now be described with reference to FIG. 21.

In FIG. 21, four embodiments among various embodiments are shown.

In an embodiment, as shown in FIG. 21(A), the red opening has the same shape as

FIG. 19(A), and no scattering layer opening is formed in the green and blue openings, and only a red opening OPSLr is formed in the scattering layer 210, and the green opening OPSLg and the blue opening OPSLb are not formed.

In an embodiment, as shown in FIG. 21(B), the green opening has the same shape as FIG. 19(A), and no scattering layer opening is formed in the red and blue openings, so only the green opening OPSLg is formed in the scattering layer 210, and the red opening OPSLr and the blue opening OPSLb are not formed.

In an embodiment, as shown in FIG. 21(C), the blue opening has the same shape as

FIG. 19(A), and no scattering layer opening is formed in the red and green openings. In such an embodiment, only the blue opening OPSLb is formed in the scattering layer 210, and the red opening OPSLr of the scattering layer and the green opening OPSLg of the scattering layer are not formed.

In an embodiment, as shown in FIG. 21(D), in a plan view, the red opening OPSLr is formed in the red opening, the blue opening OPSLb is not formed in the blue opening, and the green opening OPSLg is formed in some of the green openings OPg, but the green opening OPSLg is not formed in others of the green openings OPg in the unit pixel.

That is, in FIG. 21(D), a red opening OPSLr and a green opening OPSLg of the scattering layer 210 are formed, , and the red opening OPSLr of the scattering layer 210 is formed in all of the red openings.

However, some of the green openings OPg of the pixel defining layer 380 have green openings OPSLg of the corresponding scattering layer 210, but other green openings OPg have corresponding scattering layers. In such an embodiment, since the green opening OPSLg of the scattering layer 210 is not located, it has a structure covered with a scattering layer 210.

In an embodiment, unlike FIG. 21(D), the color in which the opening of the scattering layer 210 is not formed may be changed, and even in the red and/or blue openings, some openings of the scattering layer 210 are formed.

Various embodiments shown in FIG. 21 may include additional reflection characteristics of comparative example 1 described above with reference to FIGS. 10 and 12. Therefore, such embodiments may have reflection characteristics that are approximately midway between the reflection characteristics of comparative example 1 in FIGS. 10 and 12 and the reflection characteristics of a completely overlapping comparative example.

In such embodiments, the intensity of the diffraction pattern is further reduced as external light is scattered compared to comparative example 0, making it difficult for the user to check the scattering pattern, and frontal efficiency is improved compared to comparative example 1.

In an embodiment, referring to FIG. 21(D), the reflected color can be changed depending on the position of the opening of the scattering layer 210, and an additional effect of adjusting the color of the reflected light can be obtained.

Specifically, each embodiment can be separately described with reference to the SCI (specular component included) index and the SCE (specular component excluded) index corresponding to color as follows.

In FIG. 21(A), the a factor and b factor increase in the SCI index, but the a factor and b factor decrease in the SCE index, and in FIG. 21(B), the a factor decreases and the b factor increases in the SCI index. In the SCE index, the a factor increases and the b factor decreases, and in FIG. 21(C), the a factor increases and the b factor decreases in the SCI index, but the a factor increases and the b factor decreases and in the SCE index.

As the reflection characteristics change depending on the position of the opening of the scattering layer 210, the SCI index and/or SCE index may be optimized as desired by adjusting the position of the opening of the scattering layer 210 as shown in FIG. 21(D).

FIG. 21(D) is an example embodiment, and the opening of the scattering layer 210 may be located in a different position from that shown in FIG. 21(D).

Hereinafter, embodiments where the flat shapes of the pixel defining layer 380's opening OP, the light blocking layer 220's second opening OPBM, and the scattering layer 210's opening OPSL are all formed in an elliptical shape with be described with reference to FIGS. 22 to 26.

First, referring to FIG. 22, an embodiment in which the long-axis directions of each elliptical shape match will be described.

Referring to FIG. 22, the elliptical shape and size of the opening OP of the pixel defining layer 380 and the second opening OPBM of the light blocking layer 220 are shown to be the same as each other, and the opening OPSL of the scattering layer 210 is shown separately by changing only the size and/or eccentricity.

FIG. 22(A) shows an embodiment in which the opening OPSL of the scattering layer 210 and the opening OP of the pixel defining layer 380 have coincident boundaries in a plan view, and the opening OP of the pixel defining layer 380 and the opening OPSL of the scattering layer 210 have a same eccentricity as each other.

In an embodiment, as shown in FIG. 22(B), the opening OPSL of the scattering layer 210 may be larger than the opening OP of the pixel defining layer 380 and is smaller than the second opening OPBM of the light blocking layer 220. In such an embodiment, the opening OP of the pixel defining layer 380 is located within the opening OPSL of the scattering layer 210.

As a result, the portion (hatched) of the scattering layer 210 exposed by the second opening OPBM of the light blocking layer 220 has a structure that does not overlap the opening OP of the pixel defining layer 380 in a plan view.

FIG. 22(C) shows an embodiment in which the opening OPSL of the scattering layer 210 is formed to be the smallest, and the opening OPSL of the scattering layer 210 is within the opening OP of the pixel defining layer 380.

As a result, the portion (hatched) of the scattering layer 210 exposed by the second opening OPBM of the light blocking layer 220 has a structure that overlaps the opening OP of the pixel defining layer 380 in a plan view.

In FIG. 22, the elliptical shapes of the opening OP of the pixel defining layer 380 and the second opening OPBM of the light blocking layer 220 are shown as having a same long-axis direction, but may be formed in different long-axis directions.

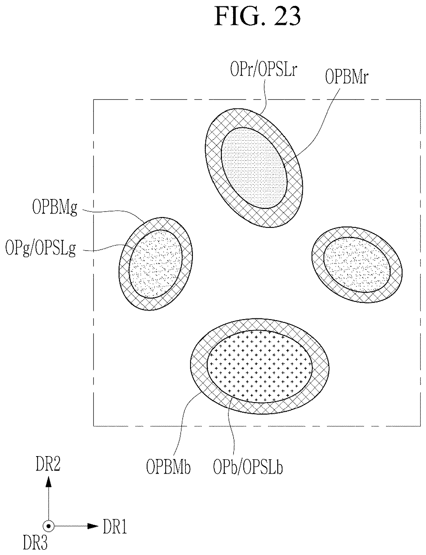

FIG. 23 shows an embodiment of a unit pixel in which the embodiment of FIG. 22(A) is arranged.

In the embodiment of FIG. 23, elliptical shapes of a same color have a same size and eccentricity as each other, and the long-axes of the oval shapes are arranged differently.

That is, in FIG. 23, two green openings OPg of the pixel defining layer 380 are shown, and the two green openings OPg of the pixel defining layer 380 have a same area or eccentricity as each other, and the two green second openings OPBMg of the light blocking layer 220 also have a same area or eccentricity as each other.

In an embodiment, the two green openings OPSLg of the scattering layer 210 are formed in an elliptical shape with the same eccentricity, but the long axes of the elliptical shapes are arranged in different directions.

That is, in such an embodiment, the openings OPSLr, OPSLg, OPSLb of the scattering layer 210 have a same color, and elliptical shape thereof have a same eccentricity, but have different long-axis directions.

In an embodiment, where the long axis direction of the openings OPSLr, OPSLg, OPSLb of the scattering layer 210 are arranged in various ways as shown in FIG. 23, it is possible to prevent external light from forming a constant diffraction pattern and thereby prevent deterioration of display quality.

Specifically, the embodiment of FIG. 23 may have reflection characteristics of external light similar to the completely overlapping comparative example described above with reference to FIG. 10 or 12, and the diffraction pattern may be weaker than comparative example 0 so that the diffraction pattern is not well recognized, and the frontal efficiency may be further improved compared to comparative example 1.

In addition, the elliptical shape can be formed to have a more improved diffraction pattern of external light by arranging the long-axis directions in various ways.

In another embodiment, elliptical shapes of the same color may be formed to have different sizes or eccentricities.

That is, unlike FIG. 23, in an embodiment, the two green openings OPg of the pixel defining layer 380 have different areas or eccentricities, the two green second openings OPBMg of the light blocking layer 220 also have different areas or eccentricities, and the two green openings OPSLg of the scattering layer 210 may also be formed in elliptical shapes with different eccentricities.

In such an embodiment, the two long axes of the green opening OPSLg of the scattering layer 210 may have the same direction or may be arranged in different directions.

Since such an embodiment has more elliptical-shape variations than the embodiment of FIG. 23, external light may not form a constant diffraction pattern and deterioration of display quality may be effectively prevented.

In an embodiment, at least one of the openings OPSLr, OPSLg, OPSLb of the scattering layer 210 may be omitted as in comparative example 1 of FIG. 10, and in another embodiment, only some of the openings OPSLr, OPSLg, OPSLb of the scattering layer 210 of the same color may be omitted, and some of the openings may have a structure including an opening (see FIG. 21).

Here, the eccentricity of the elliptical-shaped opening can have a value greater than 0 and less than 1, and the angle formed by each long axis has four or more angles, and the angle formed by the long axis is at regular angle intervals of 45 degrees or less.

In an embodiment, the angle formed by the long axis of the elliptical shape may be one of 45 degrees or less and may be arranged at irregular intervals.

Such an embodiment in which the long axis is arranged at irregular intervals may be intentionally arranged randomly to reduce the diffraction pattern, and due to process errors, it may have an angle of 0 degrees or more and 10 degrees or less.

Additionally, the maximum horizontal gap between the openings may be about 4.5µm or greater and about 10µm or less.

In the embodiment of FIG. 23, a total of four unit pixels including red, green, and blue openings are included in one unit pixel. In such an embodiment, two green openings are included, and one red opening and one blue opening are included.

However, the color of two pixels having a same color may be red or blue, and the positions of each of the four openings may be arranged differently from that shown in FIG. 23.

In an embodiment, the unit pixel may be formed as a unit pixel including only one red opening, one green opening, and one blue opening.

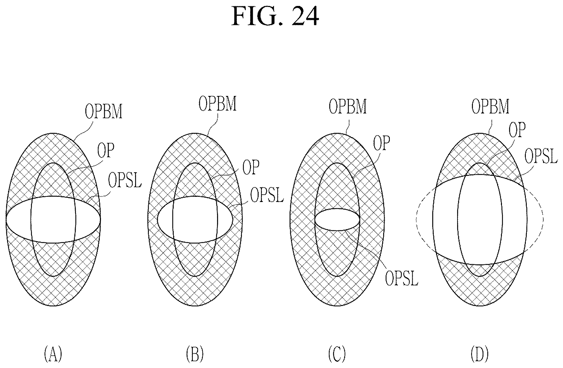

Hereinafter, an embodiment in which the longitudinal direction of the opening OPSL of the scattering layer 210 is perpendicular to the longitudinal direction of the opening OP of the pixel defining layer 380 and/or the second opening OPBM of the light blocking layer 220 will be described with reference to FIG. 24.

Referring to FIG. 24, the elliptical shape and size of the opening OP of the pixel defining layer 380 and the second opening OPBM of the light blocking layer 220 are shown to be the same as each other, and the opening OPSL of the scattering layer 210 is shown separately by changing only the size and/or eccentricity.

FIG. 24(A) shows an embodiment in which the opening OPSL of the scattering layer 210 is tangential to the second opening OPBM of the light blocking layer 220, and the opening OP of the pixel defining layer 380 is tangential to the second opening OPBM of the light blocking layer 220, and the opening OPSL of the scattering layer 210 has a structure that overlaps in some areas in a plan view.

As a result, in such an embodiment, a structure is formed in which the portion (hatched) of the scattering layer 210 exposed by the second opening OPBM of the light blocking layer 220 overlaps only a portion of the opening OP of the planar pixel defining layer 380.

In an embodiment, a portion of the scattering layer 210 exposed by the second opening OPBM of the light blocking layer 220 (hatched) overlaps only the second opening OPBM of the light blocking layer 220 in a plan view.

FIG. 24(B) shows an embodiment in which the opening OPSL of the scattering layer 210 does not contact the second opening OPBM of the light blocking layer 220 and the opening OP of the pixel defining layer 380, and is a flat surface, a portion of the opening OPSL of the upper scattering layer 210 overlaps the opening OP of the pixel defining layer 380, and the remaining portion does not overlap the opening OP of the pixel defining layer 380.

As a result, in such an embodiment, a structure is formed in which the portion (hatched) of the scattering layer 210 exposed by the second opening OPBM of the light blocking layer 220 overlaps only a portion of the opening OP of the pixel defining layer 380 in a plan view.

In an embodiment, a portion of the scattering layer 210 exposed by the second opening OPBM of the light blocking layer 220 (hatched) overlaps only the second opening OPBM of the light blocking layer 220 in a plan view.

FIG. 24(C) shows an embodiment in which the opening OPSL of the scattering layer 210 has a structure tangential to the opening OP of the pixel defining layer 380, and the opening OPSL of the scattering layer 210 is tangential to the opening OP of the pixel defining layer 380.

As a result, in such an embodiment, the portion (hatched) of the scattering layer 210 exposed by the second opening OPBM of the light blocking layer 220 has a structure in which it is located only within the opening OP of the pixel defining layer 380 in a plan view.

FIG. 24(D) shows an embodiment in which the opening OPSL of the scattering layer 210 does not contact the second opening OPBM of the light blocking layer 220 and the opening OP of the pixel defining layer 380, and is a flat surface. Some of the openings OPSL of the planar scattering layer 210 have a structure that does not overlap with the second openings OPBM of the light blocking layer 220.

As a result, in such an embodiment, the portion (hatched) of the scattering layer 210 exposed by the second opening OPBM of the light blocking layer 220 overlaps one part of the opening OP of the pixel defining layer 380, and/or one part of the light blocking layer 220 of the second opening OPBM in a plan view.

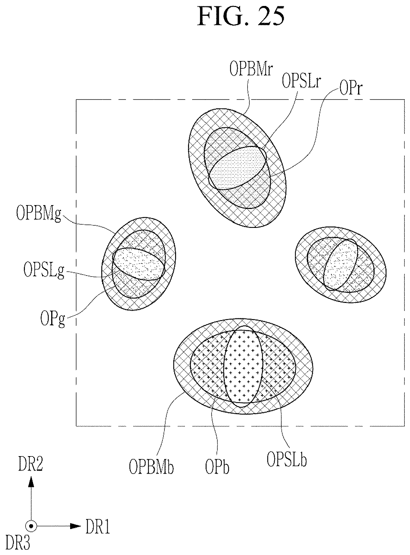

FIG. 25 shows an embodiment of one unit pixel in which the embodiment of FIG. 22(B) is arranged.

In the embodiment of FIG. 25, elliptical shapes of the same color have the same size and eccentricity, and the long-axis directions of the elliptical shapes are arranged differently.

That is, in FIG. 25, two green openings OPg of the pixel defining layer 380 are shown, and the two green openings OPg of the pixel defining layer 380 have the same area or eccentricity, and two green second openings OPBMg of the light blocking layer 220 also have the same area or eccentricity.

In an embodiment, the two green openings OPSLg of the scattering layer 210 are formed in an elliptical shape with the same eccentricity, but the long axes of the elliptical shapes are arranged in different directions.

That is, in such an embodiment, the openings OPSLr, OPSLg, OPSLb of the scattering layer 210 having the same color and elliptical shape have the same eccentricity, but have different long-axis directions.

In such an embodiment, as shown in FIG. 25, the long axis direction of the openings OPSLr, OPSLg, OPSLb of the scattering layer 210 are arranged in various ways, such that it is possible to prevent external light from forming a constant diffraction pattern and thereby prevent deterioration of display quality.

In an embodiment, elliptical shapes of the same color may be formed to have different sizes and eccentricities.

That is, in such an embodiment, unlike FIG. 25, the two green openings OPg of the pixel defining layer 380 have different areas or eccentricities, and the two green second openings OPBMg of the light blocking layer 220 also have different areas or eccentricities, and the two green openings OPSLg of the scattering layer 210 may also be formed in elliptical shapes with different eccentricities.

In such an embodiment, the two long axes of the green opening OPSLg of the scattering layer 210 may have the same direction or may be arranged in different directions.

Since such an embodiment has more elliptical shape variations than the embodiment of FIG. 25, such that external light may not form a constant diffraction pattern and deterioration of display quality can be prevented.

In an embodiment, at least one of the openings OPSLr, OPSLg, OPSLb of the scattering layer 210 may be omitted as in comparative example 1 of FIG. 10, and in another embodiment, only some of the openings OPSLr, OPSLg, OPSLb of the scattering layer 210 of the same color may be omitted, and some of the openings may have a structure including an opening (see FIG. 21).

Here, the eccentricity of the elliptical -shaped opening can have a value greater than 0 and less than 1, the angle formed by each long axis has four or more angles, and the angle formed by the long axis is at regular angle intervals of 45 degrees or less.

In an embodiment, the angle formed by the long axis of the elliptical shape may be of 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

In such embodiments, the maximum horizontal spacing between openings may be about 4.5µm or greater and about 10µm or less.

In an embodiment, as shown in FIG. 24, the elliptical shapes of the opening OP of the pixel defining layer 380 and the second opening OPBM of the light blocking layer 220 are shown as having the same long-axis direction, but may be formed in different long-axis directions.

In the embodiment of FIG. 25, a total of four unit pixels including red, green, and blue openings are included in a unit pixel. In such an embodiment, two green openings are included, and one red opening and one blue opening are included.

However, the color of the two pixels having a same color may be red or blue, and the positions of each of the four openings may be arranged differently from that shown in FIG. 25.

In an embodiment, the unit pixel may be formed as a unit pixel including only one red opening, one green opening, or one blue opening.

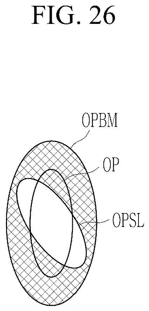

Hereinafter, an embodiment in which the long-axis direction of the opening OPSL of the scattering layer 210 has a certain angle with the long-axis direction of the opening OP of the pixel defining layer 380 and/or the long-axis direction of the second opening OPBM of the light blocking layer 220 will be described with reference to FIG. 26.

FIG. 26 shows an embodiment in which the opening OPSL of the scattering layer 210 does not contact the second opening OPBM of the light blocking layer 220 and the opening OP of the pixel defining layer 380. In a plan view, a portion of the opening OPSL of the scattering layer 210 overlaps the opening OP of the pixel defining layer 380, and the remaining portion of the opening OPSL of the scattering layer 210 does not overlap the opening OP of the pixel defining layer 380.

As a result, in such an embodiment, a structure is formed in which the portion (hatched) of the scattering layer 210 exposed by the second opening OPBM of the light blocking layer 220 overlaps only a portion of the opening OP of the pixel defining layer 380 in a plan view.

In an embodiment, a portion of the scattering layer 210 exposed by the second opening OPBM of the light blocking layer 220 (hatched) overlaps only the second opening OPBM of the light blocking layer 220 in a plan view.

Although only one embodiment is shown in FIG. 26, such an embodiment can be modified by changing the angle of the opening OPSL of the scattering layer 210, and other various modifications described above can be applied thereto.

The embodiment of FIG. 26 will now be described in greater detail.

A portion of the opening OPSL of the scattering layer 210 may be formed outside the second opening OPBM of the light blocking layer 220, and the opening OPSL of the scattering layer 210 may also be formed only within the opening OP of the pixel defining layer 380.

Elliptical shapes of the same color have the same size and eccentricity, and the long-axis directions of the elliptical shapes may be arranged differently.

That is, the openings OPSL of the plurality of scattering layers 210 corresponding to the same color have the same area or eccentricity, but the long axes of the elliptical shapes are arranged in different directions.

In an embodiment, elliptical shapes of the same color can be formed to have different sizes and eccentricities, and the long-axis directions can be arranged the same or in various ways.

In an embodiment, at least one of the openings OPSL of the scattering layer 210 may be omitted as in comparative example 1 of FIG. 10, and in another embodiment, the opening OPSL of the scattering layer 210 of the same color may be omitted, and some may have a structure including an opening (see FIG. 21).

In FIG. 26, the elliptical shapes of the opening OP of the pixel defining layer 380 and the second opening OPBM of the light blocking layer 220 are shown as having the same long-axis direction, but may be formed in different long-axis directions.

Here, the eccentricity of the elliptical opening can have a value greater than 0 and less than 1, each long axis can have an angle of four or more angles, and the angle formed by the long axis can be arranged at regular angle intervals of 45 degrees or less.

In an embodiment, the angle formed by the long axis of the elliptical shape may be 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

In such an embodiment, the maximum horizontal spacing between openings may be about 4.5µm or greater and about 10µm or less.

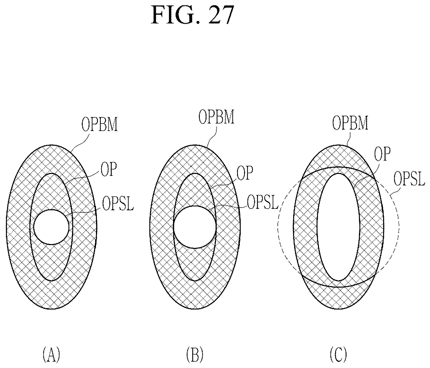

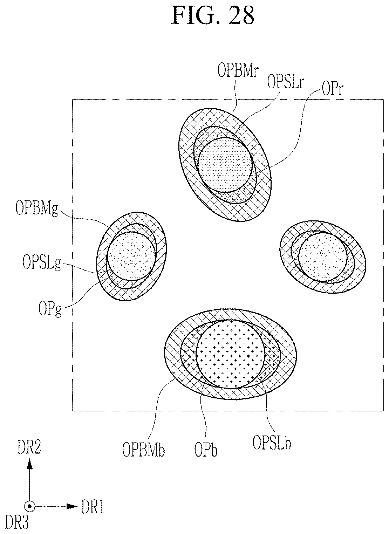

Hereinafter, embodiments in which the planar shape of the opening OP of the pixel defining layer 380 and the second opening OPBM of the light blocking layer 220 is formed in an elliptical shape, and the opening OPSL of scattering layer 210 is formed in a circular shape will be described with reference to FIGS. 27 and 28.

FIG. 27 shows various embodiments in which the opening OP of the pixel defining layer 380 and the second opening OPBM of the light blocking layer 220 have an elliptical planar shape, and the opening OPSL of the scattering layer 210 has a circular planar shape.

In FIG. 27, the elliptical shapes of the opening OP of the pixel defining layer 380 and the second opening OPBM of the light blocking layer 220 are shown as having the same long-axis direction, but may be formed in different long-axis directions.

FIG. 27(A) shows an embodiment in which the opening OPSL of the scattering layer 210 is formed smaller than the opening OP of the pixel defining layer 380, and the opening OPSL of the scattering layer 210 is located within the opening OP of the pixel defining layer 380 in a plan view.

FIG. 27(B) is a modified example of FIG. 27(A), and shows an embodiment in which the opening OPSL of the scattering layer 210 is inscribed with the opening OP of the pixel defining layer 380.

FIG. 27(C) shows an embodiment in which the opening OPSL of the scattering layer 210 is formed larger than the opening OP of the pixel defining layer 380, and additionally, a portion of the opening OPSL of the scattering layer 210 is flat and is located outside the second opening OPBM of the upper light blocking layer 220 and has a structure (see dotted line) that is obscured by the light blocking layer 220.

In an embodiment, the opening OPSL of the scattering layer 210 may have a structure tangential to the second opening OPBM of the light blocking layer 220.

FIG. 28 shows an embodiment of one unit pixel in which the embodiment of FIG. 27(B) is arranged. In such an embodiment, the circle shape and ellipse shape of different colors have different sizes and/or eccentricities, the ellipse shape of the same color has different sizes and/or eccentricities, and the long-axis directions of the shapes have different structures.

In FIG. 28, the scattering layer 210 exposed by the second opening OPBMr, OPBMg, OPBMb of the light blocking layer 220 is represented by diagonal lines, and also, the red, green, and blue light emitting layers exposed by the openings OPr, OPg, OPb of the pixel defining layer 380 are also represented by separate diagonal lines.

As a result, in the embodiment of FIG. 28, a portion of the light emitting layer of each color has a structure that overlaps the scattering layer 210 in a plan view.

In the embodiment of FIG. 28, the circular and elliptical shapes of the same color have the same size and eccentricity, and the long-axis directions of the elliptical shapes are arranged differently.

In such an embodiment, as shown in FIG. 28, two green openings OPg of the pixel defining layer 380 are shown, and the two green openings OPg of the pixel defining layer 380 have the same area or eccentricity, but are formed in different long-axis directions.

In addition, the two green second openings OPBMg of the light blocking layer 220 have the same area or eccentricity, but are formed in different long-axis directions.

In an embodiment, the two green openings OPSLg of the scattering layer 210 have the same area or radius.

In other words, the openings OPr, OPg, OPb of the pixel defining layer 380 with an elliptical shape in the same color and the second openings OPBMr, OPBMg, OPBMb of the light blocking layer 220 have the same eccentricity, but examples are shown in which the long-axis directions are different from each other.

In such an embodiment, as shown in FIG. 28, the arrangement in the long-axis direction is formed in various ways, such that it is possible to prevent external light from forming a constant diffraction pattern and thereby prevent deterioration of display quality.

In another embodiment, even circular and elliptical shapes of the same color can be formed to have different sizes and eccentricities.

In an embodiment, unlike FIG. 28, the two green openings OPg of the pixel defining layer 380 are formed as ellipses with different areas or eccentricities, and the two green second openings OPBMg of the light blocking layer 220 may be formed as ellipses with different areas or eccentricities, and the two green openings OPSLg of the scattering layer 210 may also be formed as circular shapes with different areas or radii.

In such an embodiment, the major axes of the two elliptical shapes may have the same direction or may be arranged in different directions.

Since such an embodiment has more elliptical-shape variations than that of the embodiment of FIG. 28, external light may not form a constant diffraction pattern and deterioration of display quality can be effectively prevented.

In an embodiment, at least one of the openings OPSLr, OPSLg, OPSLb of the scattering layer 210 may be omitted as in comparative example 1 of FIG. 10, and in another embodiment, only some of the openings OPSLr, OPSLg, OPSLb of the scattering layer 210 of the same color may be omitted, and some may have a structure including the openings (see FIG. 21).

Here, the eccentricity of the elliptical shape can have a value greater than 0 and less than 1, the angle formed by each long axis has four or more angles, and the angles formed by the long axis can be arranged at regular angular intervals of 45 degrees or less.

In an embodiment, the angle formed by the long axis of the elliptical shape may be 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

In such an embodiment, the maximum horizontal spacing between openings may be about 4.5µm or greater and about 10µm or less.

In the embodiment of FIG. 28, a total of four unit pixels including red, green, and blue openings are included in a unit pixel. In such an embodiment, two green openings are included, and one each of red and blue openings is shown.

In another embodiment, the color of the two pixels having a same color may be red or blue, and the positions of each of the four openings may be arranged differently from that of FIG. 28.

In an embodiment, the unit pixel may be formed as a unit pixel including only one red opening, one green opening, and one blue opening.

The structures of various embodiments are described above with reference to FIGS. 15 to 28.

Hereinafter, the change or modification in eccentricity or long-axis direction of the elliptical shape will be described in greater detail with reference to FIGS. 29 to 32.

FIG. 29 to FIG. 32 are plan views of a portion of a display panel according to various modified embodiments.

First, various modified structures of the embodiment of FIG. 28 and FIGS. 29 to 31 will be described.

In FIG. 29 to FIG. 31, the second openings OPBMr, OPBMg, OPBMb of the light blocking layer 220 and the openings of the pixel defining layer 380 are shown through the structure of the light emitting display panel DP formed in the display area DA, an embodiment in which the openings OPr, OPg, OPb are each formed in an elliptical shape, and the openings OPSLr, OPSLg, OPSLb of the scattering layer 210 are formed in a circular shape will be examined.

In FIG. 29 to FIG. 31, the openings OPSLr, OPSLg, OPSLb of the scattering layer 210 are located in the openings OPr, OPg, OPb of the pixel defining layer 380, as shown in FIGS. 27(B) and 28.

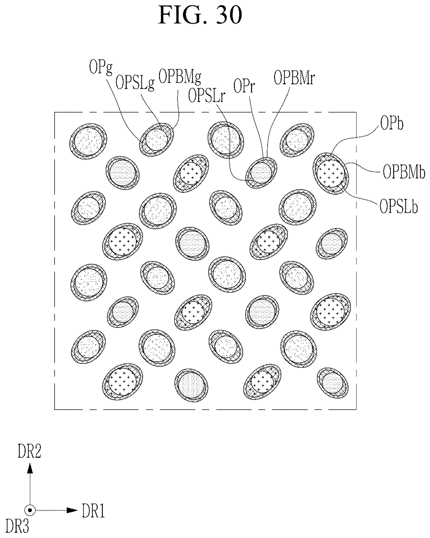

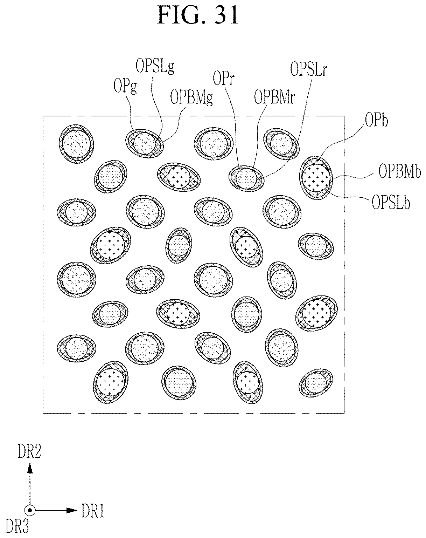

FIG. 29 to FIG. 31 each show different embodiments. Specifically, FIG. 29 shows an embodiment in which an elliptical shape is arranged at various angles, FIG. 30 shows an embodiment in which an elliptical shape is formed at various eccentricities, and FIG. 31 shows an embodiment in which an elliptical shape are arranged at various angles and are formed at various eccentricities.

First, referring to FIG. 29, the planar structures of the openings OPr, OPg, OPb of the pixel defining layer 380, the second openings OPBMr, OPBMg, OPBMb of the light blocking layer 220, and the openings OPSLr, OPSLg, OPSLb of the scattering layer 210 will be described in detail.

In an embodiment, as shown in FIG. 29, the openings OPSLr, OPSLg, OPSLb of the scattering layer 210 are formed in a circular shape and are located in the respective openings OPr, OPg, OPb of the corresponding pixel defining layer 380. The openings OPr, OPg, OPb of the pixel defining layer 380 having an elliptical shape and the second openings OPBMr, OPBMg, OPBMb of the light blocking layer 220 in an embodiment will now be described.

In an embodiment, as shown in FIG. 29, the openings OPr, OPg, OPb of the pixel defining layer 380 and the second openings OPBMr, OPBMg, OPBMb of the light blocking layer 220 each have an elliptical planar shape with the same eccentricity.

That is, the red opening OPr, the green opening OPg, and the blue opening OPb of the pixel defining layer 380 may all be ellipses with the same eccentricity.

In such an embodiment, the red second opening OPBMr, the green second opening OPBMg, and the blue second opening OPBMb of the light blocking layer 220 may all be ellipses having the same eccentricity.

Here, the eccentricity of the openings OPr, OPg, OPb of the pixel defining layer 380 and the second openings OPBMr, OPBMg, OPBMb of the light blocking layer 220 may have a value greater than 0 and less than 1.

An opening OPr, OPg, OPb of a pixel defining layer 380 corresponds to an opening OPSLr, OPSLg, OPSLb of a scattering layer 210 and a second opening OPBMr, OPBMg, OPBMb of a light blocking layer 220.

That is, an opening of the scattering layer 210 corresponding to each of the second openings OPBMr, OPBMg, OPBMb of the light blocking layer 220 OPSLr, OPSLg, OPSLb and the openings OPr, OPg, OPb of the pixel defining layer 380 are located within each of the second openings OPBMr, OPBMg, OPBMb of the light blocking layer 220 in the plan view.

The second openings OPBMr, OPBMg, OPBMb of the light blocking layer 220, the openings OPSLr, OPSLg, OPSLb of the scattering layer 210, and the openings OPr, OPg, OPb of the pixel defining layer 380 correspond to each other and may overlap each other at least partially in a plan view.

In an embodiment, the second openings OPBMr, OPBMg, OPBMb of light blocking layer 220 corresponding to the openings OPr, OPg, OPb of the pixel defining layer 380 can have a certain horizontal distance from each other, and the second openings OPBMr, OPBMg, OPBMb of the two corresponding light blocking layers 220 and the openings OPr, OPg, OPb of the pixel defining layer 380 can be formed at the same angle in the same direction of the long axis of the elliptical shape.

Here, the horizontal gap between the second openings OPBMr, OPBMg, OPBMb of the light blocking layer 220 and the corresponding openings OPr, OPg, OPb of the pixel defining layer 380 may be about 4.5µm or greater and about 10µm or less. The horizontal gap may change depending on the thickness of the layer (e.g., encapsulation layer) located between the two in the cross-section, and the encapsulation layer may have a thickness of about 6µm.

In an embodiment, the long-axis directions of the corresponding second openings OPBMr, OPBMg, OPBMb of the light blocking layer 220 and the openings OPr, OPg, OPb of the pixel defining layer 380 may not be constant due to process errors, etc., e.g., by an angle of 0 degrees or greater and 10 degrees or less.

In the embodiment of FIG. 29, each long axis of the plurality of openings OPr, OPg, OPb of the pixel defining layer 380 can have an angle of four or more angles, and also, the angle formed by the long axis can be arranged at intervals of 45 degrees or less.

In such an embodiment, as described above, the angles formed by the long axes of the plurality of openings OPr, OPg, OPb of the pixel defining layer 380 or the plurality of second openings OPBMr, OPBMg, OPBMb of the light blocking layer 220 can be placed at equal intervals at an angle of 45 degrees or less.

However, in another embodiment, the angle formed by the long axis of each opening may be 45 degrees or less and may be arranged at irregular intervals.

The embodiment in which the long axis of the opening is arranged at such irregular intervals may be intentionally arranged to reduce the diffraction pattern, or may have an angle of 0 degrees or more and 10 degrees or less or be arranged at irregular intervals due to processing errors.

In such an embodiment, the maximum horizontal spacing between openings may be about 4.5µm or greater and about 10µm or less.

If the plurality of openings OPr, OPg, OPb of the pixel defining layer 380 or the plurality of second openings OPBMr, OPBMg, OPBMb of the light blocking layer 220 have four or more openings or are spaced at an angle of 45 degrees or less, less color separation of external light occurs or a constant diffraction pattern or color separation occurs regardless of the angle, thereby making it difficult for the user to see the diffraction pattern.

Now, the embodiment of FIG. 30 will be described in detail.

In an embodiment, as shown in FIG. 30, the second openings OPBMr, OPBMg, OPBMb of the light blocking layer 220 and the openings OPr, OPg, OPb of the pixel defining layer 380 are formed in elliptical shapes with two or more different eccentricities, and the openings OPSLr, OPSLg, OPSLb of the scattering layer 210 are formed in a circular shape and are respectively located into the openings OPr, OPg, OPb of the corresponding pixel defining layer 380.

In an embodiment, each elliptical-shaped opening of the same color may be formed into an elliptical shape with an eccentricity of 2 or more.

Here, the eccentricity of the elliptical shape may be greater than 0 to less than 1.

In an embodiment, as shown in FIG. 30, the long-axis direction of the ellipse has only two directions forming 45 degrees with respect to the first direction DR1 or the second direction DR2, but the long-axis direction of the ellipse may have various directions in other embodiments.

In FIG. 30, the openings OPr, OPg, OPb of the pixel defining layer 380, the second openings OPBMr, OPBMg, OPBMb of the light blocking layer 220, and the openings OPSLr, OPSLg, OPSLb of the scattering layer 210 are further shown.

In an embodiment, as shown in FIG. 30, the openings OPr, OPg, OPb of the pixel defining layer 380 and the second openings OPBMr, OPBMg, OPBMb of the light blocking layer 220 have an elliptical planar shape and are oriented in the first direction DR1, or the elliptical long-axis directions are arranged only in two directions forming 45 degrees with respect to the second direction DR2.

The openings OPSLr, OPSLg, OPSLb of the scattering layer 210 are formed in a circular shape and are tangential to the openings OPr, OPg, OPb of the corresponding pixel defining layer 380, respectively.

In an embodiment, each of the red opening OPr, the green opening OPg, and the blue opening OPb of the pixel defining layer 380 may be formed as an ellipse with at least two different eccentricities.

In addition, the red second opening OPBMr, the green second opening OPBMg, and the blue second opening OPBMb of the light blocking layer 220 may each be formed as an ellipse having at least two different eccentricities.

In addition, in the embodiment of FIG. 30, the openings OPr, OPg, OPb of the pixel defining layer 380 of the same color may have an elliptical planar shape with at least two different eccentricities, and the same color light blocking may be used. The second openings OPBMr, OPBMg, OPBMb of the light blocking layer 220 may also have an elliptical planar shape with at least two different eccentricities.

The openings OPr, OPg, OPb of one pixel defining layer 380 correspond to the second openings OPBMr, OPBMg, OPBMb of one light blocking layer 220 and the openings OPSLr, OPSLg, OPSLb of one scattering layer 210.

That is, an opening of the scattering layer 210 corresponding to each of the second openings OPBMr, OPBMg, OPBMb of the light blocking layer 220 OPSLr, OPSLg, OPSLb and openings OPr, OPg, OPb of the pixel defining layer 380 are located within each of the second openings OPBMr, OPBMg, OPBMb of the light blocking layer 220.

The respective second openings OPBMr, OPBMg, OPBMb of each corresponding light blocking layer 220, the openings OPSLr, OPSLg, OPSLb of the scattering layer 210, and the openings OPr, OPg, OPb of the pixel defining layer 380 can overlap each other in a plan view.

In an embodiment, the second openings OPBMr, OPBMg, OPBMb of the corresponding light blocking layer 220 and the openings OPr, OPg, OPb of the pixel defining layer 380 having an elliptical shape can be formed at the same angle with each other, with a constant horizontal distance in the long-axis direction of the ellipse.

Here, the horizontal gap between the second openings OPBMr, OPBMg, OPBMb of the light blocking layer 220 and the corresponding openings OPr, OPg, OPb of the pixel defining layer 380 may be about 4.5µm or greater and about 10µm or less, and the horizontal spacing may change depending on the thickness of the layer (for example, the encapsulation layer) located between the two in cross-section.

In an embodiment, the long-axis directions of the second openings OPBMr, OPBMg, OPBMb of the corresponding light blocking layers 220 and the openings OPr, OPg, OPb of the pixel defining layer 380 are constant due to process errors, etc., and may form an angle of 0 degrees or more and 10 degrees or less.

In the embodiment of FIG. 30, two or more elliptical shapes, which are the same color opening, but having different eccentricities, may be placed in various positions at various proportions.

In an embodiment, the same number of elliptical shapes with different eccentricities may be included in the display area, and in another embodiment, the elliptical shapes with different eccentricities may be included in different numbers.

In an embodiment, for example, where the red opening OPr of the pixel defining layer 380 is formed in two elliptical shapes with different eccentricities, the corresponding red second opening OPBMr of the light blocking layer 220 can also have different eccentricities.

However, in another embodiment, the red second opening OPBMr of the light blocking layer 220 may be formed with the same eccentricity.

Referring to FIG. 30, the angle formed by each long axis of the plurality of openings OPr, OPg, OPb of the pixel defining layer 380 or the plurality of second openings OPBMr, OPBMg, OPBMb of the light blocking layer 220 is 45 degrees with respect to the first direction DR1 and the second direction DR2.

In an embodiment in which the eccentricity of the ellipse is formed in various ways, unlike FIG. 29, the number of angles formed by the long axis of the ellipse may be less than 4.

In other words, the embodiment of FIG. 30 has various elliptical shapes with different eccentricities that are formed to reduce color separation of external light or to generate a constant diffraction pattern or color separation regardless of angle.

Therefore, the embodiment of FIG. 30 enables constant color separation and/or constant diffraction in a different manner from the embodiment of FIG. 28 in which the long-axis direction of the ellipse is varied.

On the other hand, in the embodiment of FIG. 30, the number of ellipses in the long-axis direction is small, so the reflection diffraction pattern can have directionality, so the directionality of the diffraction pattern may be reduced by forming one of the plurality of openings OPr, OPg, OPb of the pixel defining layer 380 or the plurality of second openings OPBMr, OPBMg, OPBMb of the light blocking layer 220 in a circular shape or by increasing the number of long-axis directions in an elliptical shape.

Now, the embodiment of FIG. 31 will be described. The embodiment of FIG. 31 combines the embodiment of FIG. 29 and the embodiment of FIG. 30.

In an embodiment, as shown in FIG. 31, the second openings OPBMr, OPBMg, OPBMb of the light blocking layer 220 and the openings OPr, OPg, OPb of the pixel defining layer 380 are formed in elliptical shapes with different eccentricities even for the same color, the angle formed by the long axes of the second openings OPBMr, OPBMg, OPBMb of the light blocking layer 220 and the openings OPr, OPg, OPb of the pixel defining layer 380 is 4 degrees or more or the long axis of the angles formed are arranged at intervals of less than 45 degrees.

Here, the eccentricity of the elliptical shape may be greater than 0 to less than 1.

Here, the openings OPSLr, OPSLg, OPSLb of the scattering layer 210 are formed in a circular shape and are tangential to the corresponding openings OPr, OPg, OPb of the pixel defining layer 380.

The embodiment of FIG. 31 includes all the features of the embodiment of FIG. 29 and the embodiment FIG. 30, such that multiple openings OPr, OPg, OPb of the pixel defining layer 380 or multiple second openings OPBMr, OPBMg, OPBMb of the light blocking layer 220 have four or more openings, or are arranged at intervals of 45 degrees or less, additionally, by forming various eccentricities of an ellipse, it minimizes color separation of external light or ensures a constant diffraction pattern or color separation regardless of the angle.

In an embodiment, the long-axis directions of the plurality of openings OPr, OPg, OPb of the pixel defining layer 380 or the plurality of second openings OPBMr, OPBMg, OPBMb of the light blocking layer 220 are formed at equal intervals or irregular intervals.

A rough comparison of the embodiments of FIGS. 29 to 31 may be as shown in Table 1 below.

**[Table 1]**

| | FIG.29 embodiment | FIG.30 embodiment | FIG.31 embodiment |
|---|---|---|---|
| pixel defining layer opening ellipse eccentricity | red, green, blue | eccentricity more than 2 | eccentricity more than 2 |
| | same eccentricity | | |
| | | different eccentricity by color | different eccentricity by color |
| | | opening of the same color has a different eccentricity | opening of the same color has a different eccentricity |
| | | (a circle with an eccentricity of 0 is also possible) | (a circle with an eccentricity of 0 is also possible) |
| color filter second opening area (aperture ratio) | same | area varies depending on eccentricity | area varies depending on eccentricity |
| arrange ratio | equalization arrange | total number of ellipses with different eccentricities is the same or different | total number of ellipses with different eccentricities is the same or different |
| pixel defining layer opening ellipse long-axis angle | four or more angles | 2 angles of 45 degrees (angles less than 4 are also possible) | can be arranged at more than 4 angles |
| light blocking layer opening elliptical shape | pixel defining layer | pixel defining layer | pixel defining layer |
| | defined to be offset at a certain distance in the opening | defined to be offset at a certain distance in the opening | defined to be offset at a certain distance in the opening |
| scattering layer opening | circular and may or may not be tangential to the elliptical opening | circular and may or may not be tangential to the elliptical opening | circular and may or may not be tangential to the elliptical opening |

In embodiments, the diffraction pattern may be further improved by randomly arranging the direction of the long axis of the elliptical shape.

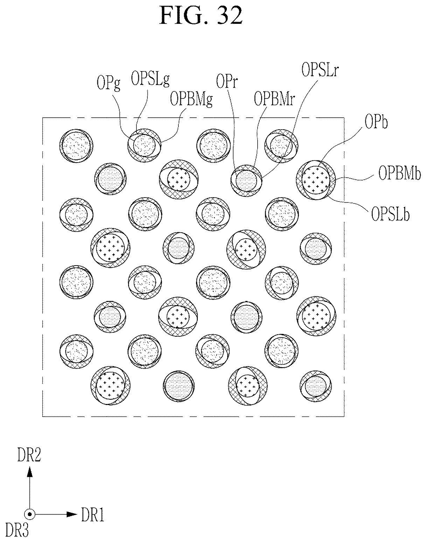

Hereinafter, the structure of the embodiment of FIG. 32, which is a modified embodiment of FIG. 31, will be described.

FIG. 32 is an embodiment that combines the embodiment of FIG. 9 and the embodiment of FIG. 31, and is an embodiment in which the eccentricity and long-axis direction of the elliptical shape are variously modified from the embodiment of FIG. 9.

In the embodiment of FIG. 32, the openings OPr, OPg, OPb of the pixel defining layer 380 and the second openings OPBMr, OPBMg, OPBMb of the light blocking layer 220 are formed in a circular shape, the openings of the scattering layer 210 are circular, and the openings OPSLr, OPSLg, OPSLb have an elliptical shape.

Here, the openings OPSLr, OPSLg, OPSLb of the scattering layer 210 have a structure that is peripheral to the openings OPr, OPg, OPb of the pixel defining layer 380.

The openings OPr, OPg, OPb of the pixel defining layer 380 and the second openings OPBMr, OPBMg, OPBMb of the light blocking layer 220 are formed in a circular shape to be centered around the openings OPSLr, OPSLg, OPSLb of the scattering layer 210, which has an elliptical shape.

In the embodiment of FIG. 32, the embodiment of FIG. 29 and the embodiment of FIG. 30 are combined, so the openings OPSLr, OPSLg, OPSLb of the scattering layer 210 having an elliptical shape are formed into different eccentricities even for the same color, and the angles formed by the long axis of the elliptical shape have four or more angles, or the angles formed by the long axis are arranged at intervals of less than 45 degrees.

Here, the eccentricity of the elliptical shape may be greater than 0 to less than 1.

In the embodiment of FIG. 32, like the embodiment of FIG. 31, the elliptical shape has four or more long-axis directions or is spaced at angles of 45 degrees or less, and the eccentricity of the elliptical shape is additionally formed in various ways to separate colors of external light, ensuring that a small amount of diffraction occurs or that a constant diffraction pattern or color separation occurs regardless of the angle.

In an embodiment, the elliptical-shaped long-axis direction may be formed at equal intervals or at irregular intervals.

Additionally, the maximum horizontal spacing between openings may be about 4.5µm or greater and about 10µm or less.

Additionally, the embodiment of FIG. 32 may have the same characteristics as Table 1 above, or the long-axis direction of the elliptical shape may be randomly arranged.

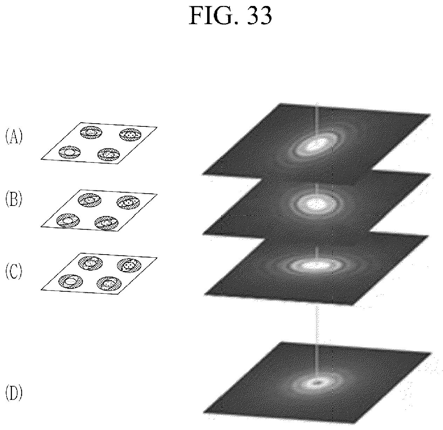

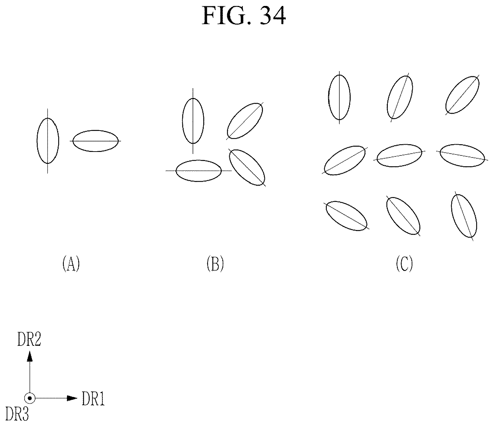

Hereinafter, the characteristics according to the long-axis direction of the elliptical shape will be described with reference to FIGS. 33 and 34.

First, the relationship between the long-axis angle of the ellipse and the direction of the diffraction pattern of reflected light through FIG. 33 will be described.

FIG. 33 is a diagram showing reflection characteristics of a light emitting display device depending on the angle.

In FIG. 33, a structure in which the opening of the pixel defining layer 380, the opening of the scattering layer 210, and the opening of the light blocking layer 220 are arranged in the same direction is shown on the left side, and the diffraction pattern of the reflected light is shown on the right side accordingly.

Referring to FIG. 33, the opening of the pixel defining layer 380 and the opening of the light blocking layer 220 are formed in a circular shape, but when the opening of the scattering layer 210 has an elliptical shape, the diffraction pattern of the reflected light is also formed in an elliptical shape. However, it can be confirmed that the long-axis directions may be different.

That is, the long-axis direction of the elliptical shape and the long-axis direction of the elliptical pattern of the diffraction pattern of the reflected light may be perpendicular to each other.

FIG. 33 shows that the diffraction patterns (A), (B), and (C) on the right side of FIG. 33 can be combined to form a circular diffraction pattern as shown in FIG. 33(D) below, showing that it is possible to have a diffraction pattern that is independent of the angle.

Below, various angles of the elliptical-shaped long axis will be described with reference to FIG. 34.

FIG. 34 is a diagram showing various angle arrangements according to an embodiment.

FIG. 34 shows the long-axis directions of one set of ellipses that can be formed in one display area.

The elliptical shape shown in FIG. 34 may correspond to the opening OP of the pixel defining layer 380, the second opening OPBM of the light blocking layer 220, and/or the opening OPSL of the scattering layer 210.

FIG. 34(A) shows an embodiment in which an elliptical-shaped opening has two long-axis directions, and an embodiment in which the two long-axis directions are arranged at an angle of 90 degrees.

FIG. 34(B) shows an embodiment in which an elliptical-shaped opening has four long-axis directions, and an embodiment in which the four long axes are arranged at intervals of 45 degrees.

FIG. 34(C) shows an embodiment in which an elliptical-shaped opening has nine long-axis directions, and an embodiment in which nine long-axis directions are arranged at intervals of 20 degrees.

In addition to the long-axis direction shown in FIG. 34, various angles can be formed in various spaced-apart long-axis orientations, which may include four or more long-axis angles, as a smaller number of long-axis directions will result in diffraction patterns depending on the angle.

An embodiment in which the elliptical shape has an elliptical shape with a single eccentricity is described above.

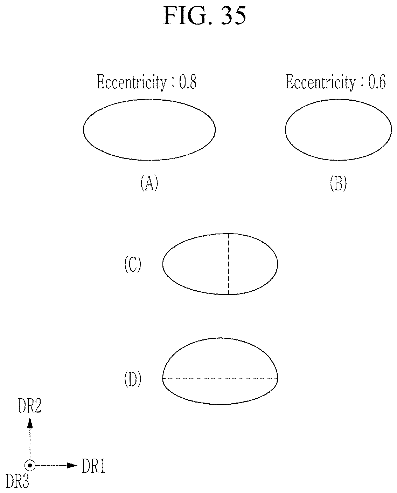

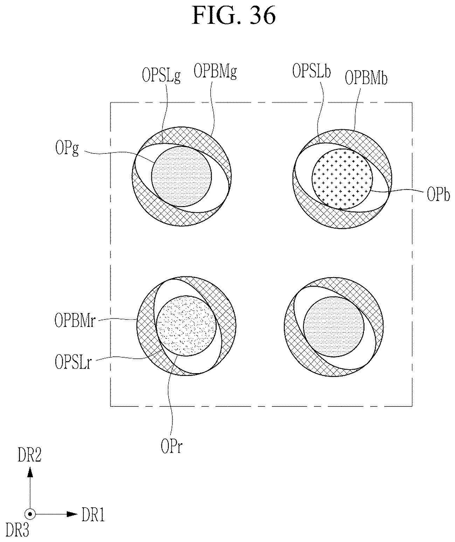

However, in another embodiment, one elliptical-shaped opening may be formed by merging at least two elliptical shapes with different eccentricities, which will be described in detail with reference to FIGS. 35 and 36.

FIGS. 35 and 36 are diagrams showing a structure combining ellipses with different eccentricities.

First, the elliptical oval shape and the arrangement of the openings based thereon will be described with reference to FIG. 35.

In FIG. 35, an example of merging two or more elliptical shapes with different eccentricities are shown.

In FIGS. 35(A) and 35(B), ellipses with different eccentricities are depicted, and in FIGS. 35(C) and 35(D), an oval or ellipses that combine two ellipses with different eccentricities in different ways are depicted.

In FIG. 35(A), an ellipse with an eccentricity of 0.8 is shown, and in FIG. 35(B), an ellipse shape with an eccentricity of 0.6 is shown.

An ellipse that merges these two ellipses may have a shape like FIG. 35(C) or FIG. 35(D).

In FIGS. 35(C) and 35(D), a dotted line is shown within the merged oval shape, and the ovals on both opposing sides of the dotted line are parts of an ellipse with different eccentricities.

That is, FIG. 35(C) is an example of combining the ellipses of FIGS. 35(A) and FIG. 35(B) cut along the second direction DR2, and FIG. 35(D) is an example of FIGS. 35(A) and FIG. 35(D), which is an example of combining the ellipses in FIGS. 35(A) and 35(B) along the first direction DR1 and then combining them.

The method of combining two ellipses with different eccentricities is not limited to this and can be combined in various ways.

The oval shape merged in the same manner as in FIG. 35(C) is used as the opening OPSL of the scattering layer 210, and the opening OP of the pixel defining layer 380 and the second opening OP of the light blocking layer 220 are used as the opening OPSL of the scattering layer 210, and the second opening OPBM of the light blocking layer 220 formed in a circular shape is shown in FIG. 36.

The embodiment of FIG. 36 shows only one unit pixel, and one unit pixel includes one red opening OPr, OPSLr, OPBMr, one blue opening OPb, OPSLb, OPBMb, and two green openings OPg, OPSLg, OPBMg.

In the embodiment of FIG. 36, the long-axis directions of each of the openings OPSLr, OPSLg, OPSLb of the scattering layer 210 may be different from each other, and the openings OPSLr, OPSLg, OPSLb of the scattering layer 210 may be aligned with the corresponding pixel defining layer, which has a structure that contacts the openings OPr, OPg, OPb of the pixel defining layer 380 and the second openings OPBMr, OPBMg, OPBMb of the light blocking layer 220.

As in the embodiment using two ellipses with different eccentricities as in FIG. 36, the angle formed by the long axis can have four or more angles, and the angle formed by the long axis can also be arranged at intervals of less than 45 degrees.

In an embodiment, the angle formed by the long axis of the oval shape may be 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

In an embodiment, the maximum horizontal spacing between openings may be about 4.5µm or greater and about 10µm or less.

In an embodiment, the eccentricities of the two ellipses used for merging may vary, so the size of the merged ellipses may also vary.

In an embodiment, two ovals with different eccentricities for each color can be combined, and even if they are the same color, two ovals with different eccentricities can be combined to form various ovals.

In an embodiment, as shown in FIG. 36, a total of four unit pixels including red, green, and blue openings may be included in a unit pixel. In this case, two green openings are included, and one red opening and one blue opening are included.

However, the color of the two pixels having a same color in the unit pixel may be red or blue, and the positions of each of the four openings may be arranged differently from that of FIG. 36.

In an embodiment, the unit pixel may be formed as a unit pixel including only one red opening, one green opening, and one blue opening.

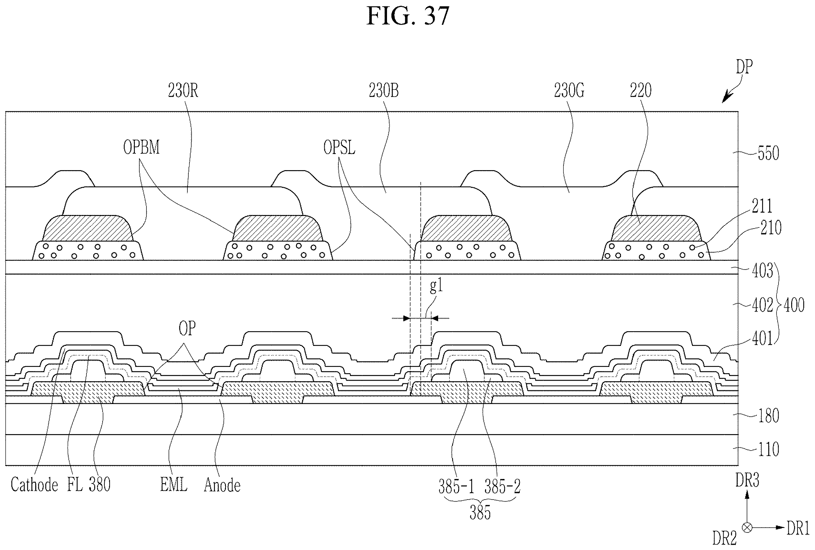

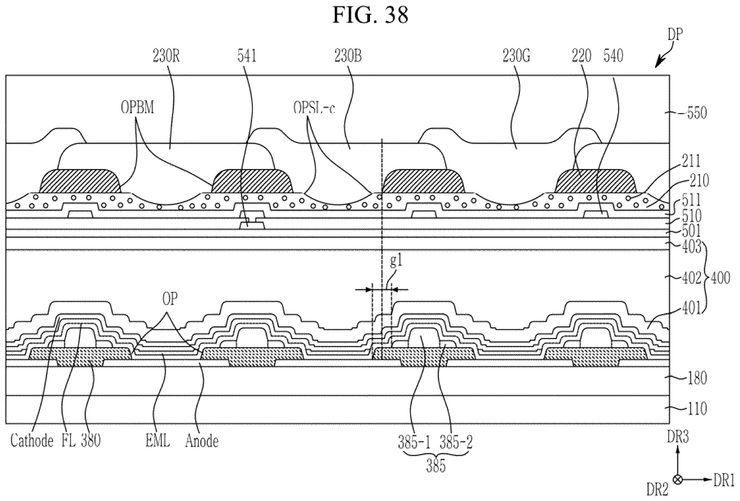

Hereinafter, an embodiment having a cross-sectional structure different from that of FIG. 7 will be described, with reference to FIGS. 37 and 38.

FIG. 37 and FIG. 38 are schematic cross-sectional views of a display panel according to another embodiment.

First, the embodiment of FIG. 37 is substantially the same as the embodiment of FIG. 7, except that the embodiment of FIG. 37 does not include a sensing insulating layer (501, 510, 511) formed for touch detection between the encapsulation layer 400 and the scattering layer 210, and multiple sensing electrodes (540, 541).

As a result, in such an embodiment, the scattering layer 210, the light blocking layer 220, and the color filters 230R, 230G, 230B are located on the encapsulation layer 400, the second inorganic encapsulation layer 403 is tangential to the scattering layer 210, and the upper structure of the scattering layer 210 and the lower structure of the encapsulation layer 400 may be the same as those in FIG. 7.

In an embodiment, a concave part OPSL-c may be formed instead of an opening OPSL located in the scattering layer 210, the cross-sectional structure of which is shown in FIG. 38.

FIG. 38 is a modified embodiment of FIG. 7 in which a concave part OPSL-c of the scattering layer 210 is formed instead of an opening OPSL of the scattering layer 210.

FIG. 38 may have the same structure as FIG. 7 except for the concave part OPSL-c of the scattering layer 210.

Referring to FIG. 38, the concave part OPSL-c of the scattering layer 210 is thinner than the scattering layer 210 at other locations, and in the embodiment of FIG. 38, the scattering layer 210 has a structure in which the thickness gradually decreases.

In an embodiment, the step of the upper surface of the scattering layer 210 located in the concave part OPSL-c of the scattering layer 210 may have a cross-sectional structure in which the step changes rapidly depending on the position.

In an embodiment, the thickness of the scattering layer 210 changes rapidly at the boundary of the concave part OPSL-c of the scattering layer 210, and the thickness of the scattering layer may not change or may change slowly at the central part of the concave part OPSL-c of the scattering layer 210.

On the other hand, the planar structure of the concave part OPSL-c of the scattering layer 210 can have a structure that combines two or more ellipses, such as the opening OPSL of the scattering layer 210 described above, as shown in FIG. 35 or FIG. 36.

Specifically, the planar shapes of the concave part OPSL-c of the scattering layer 210, the opening of the pixel defining layer 380, and the second opening of the light blocking layer 220 may correspond to any one of FIGS. 8, 9, 11, 15 to 28, 29 to 32, and 36, and may be formed as modified embodiments thereof.

Therefore, the embodiment including the concave part OPSL-c of the scattering layer 210 may also include the following features, like the opening OPSL of the scattering layer 210.

In an embodiment including the concave part OPSL-c of the scattering layer 210, the circular and oval shapes of the same color have the same size and eccentricity, and the long-axis directions of the oval shapes may be arranged differently.

In an embodiment, an oval shape with the same eccentricity is formed, but the long-axis direction of the oval shape may be arranged in a different direction.

In an embodiment, circle shapes and oval shapes of the same color may be formed to have different sizes and eccentricities.

In an embodiment, at least one of the openings OPSLr, OPSLg, OPSLb of the scattering layer 210 may be omitted as in comparative example 1 of FIG. 10, and in another embodiment, only some of the openings OPSLr, OPSLg, OPSLb of the scattering layer 210 of the same color are omitted, and some may have a structure including the openings (see FIG. 21).

Here, the eccentricity of the oval-shaped opening can have a value greater than 0 and less than 1, and the angle formed by each long axis has four or more angles, and the angle formed by the long axis is at regular angle intervals of 45 degrees or less.

In an embodiment, the angle formed by the long axis of the oval shape may be one of 45 degrees or less and may be arranged at irregular intervals.

The embodiment in which the long axes are arranged at such irregular intervals may be intentionally randomly arranged to reduce the diffraction pattern, or may have an angle of 0 degrees or more and 10 degrees or less or be arranged at irregular intervals due to process errors.

Additionally, the maximum horizontal spacing between openings may be about 4.5µm or greater and about 10µm or less.

The light emitting display device including the concave part OPSL-c of the scattering layer 210 has the scattering layer 210 located on the entire surface of the light emitting layer EML, similar to comparative example 1 of FIGS. 10 and 12.

However, the scattering layer 210 located on the front side of the light emitting layer EML has a thin thickness, so the frontal efficiency is reduced to a lesser extent compared to comparative example 1, and thus frontal luminance can be improved compared to comparative example 1.

In such an embodiment, due to the concave part OPSL-c of the scattering layer 210, the display quality may be improved due to a weaker diffraction pattern than in comparative example 0.

In such an embodiment, the planar shape of the concave part OPSL-c of the scattering layer 210, the opening of the pixel defining layer 380, and/or the second opening of the light blocking layer 220 is elliptical, such that it is difficult for the user to recognize by diversifying the eccentricity or the long-axis direction of the ellipse. Accordingly, the diffraction pattern may not have directionality.

The concave part OPSL-c of the scattering layer 210 can be formed by adjusting the thickness of the scattering layer 210 using a halftone mask on a photosensitive transparent organic material.

The cross-sectional structure of the concave part OPSL-c of the scattering layer 210 can be changed by adjusting the degree of light transmission through the halftone mask.

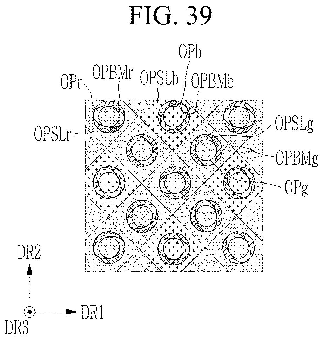

Hereinafter, the planar structure of the color filters 230R, 230G, 230B according to an embodiment will be described in detail with reference to FIG. 39.

FIG. 39 is a plan view including a color filter of a display area according to an embodiment.

FIG. 39 is a diagram more clearly illustrating the embodiment of FIG. 9 by adding the planar structure of the color filters 230R, 230G, 230B.

Referring to FIG. 7, which is a cross-sectional view, adjacent color filters 230R, 230G, 230B have a structure in which they overlap each other on the light blocking layer 220.

The planar structure of this overlapping area may vary, and one of the planar structures in the embodiment may have a diamond shape, as shown in FIG. 39.

Specifically, each of the color filters 230R, 230G, 230B has a rhombic shape covering an opening OPr, OPg, OPb of the corresponding pixel defining layer 380, an opening OPSLr, OPSLg, OPSLb of the scattering layer 210, and a second opening OPBMr, OPBMg, OPBMb of the light blocking layer 220.

Referring to FIG. 39, the color filters 230R, 230G, 230B are each shown with different hatching, and the boundary between adjacent color filters 230R, 230G, 230B is shown as a single line.

However, some areas of the actually adjacent color filters 230R, 230G, 230B may overlap each other as shown in FIG. 7, and the overlapping portions are located at the boundary line of the color filters 230R, 230G, 230B in FIG. 39.

In an embodiment, a light blocking area of the color filter may be formed in which at least two color filters 230R, 230G, 230B overlap, instead of the light blocking layer 220.

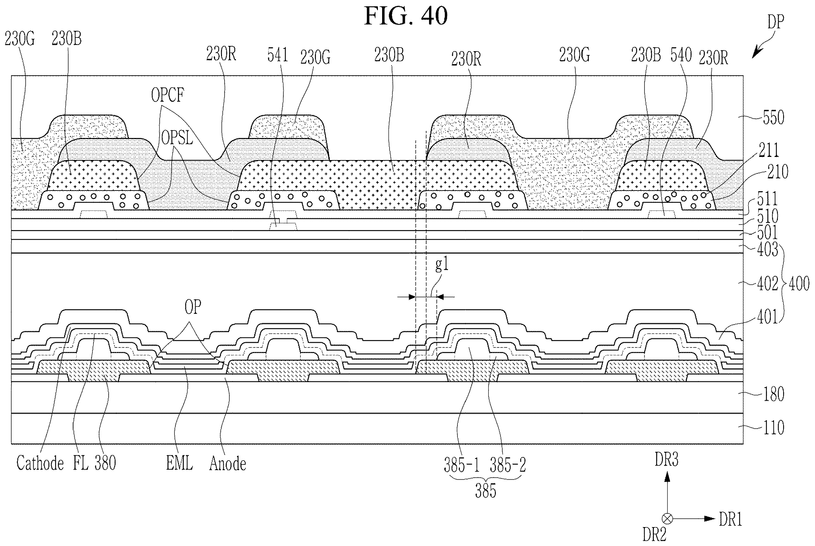

Hereinafter, an embodiment that does not include a light blocking layer and includes a light blocking area of a color filter, in which at least two color filters 230R, 230G, 230B overlap each other, will be described with reference to FIGS. 40 to 44,.

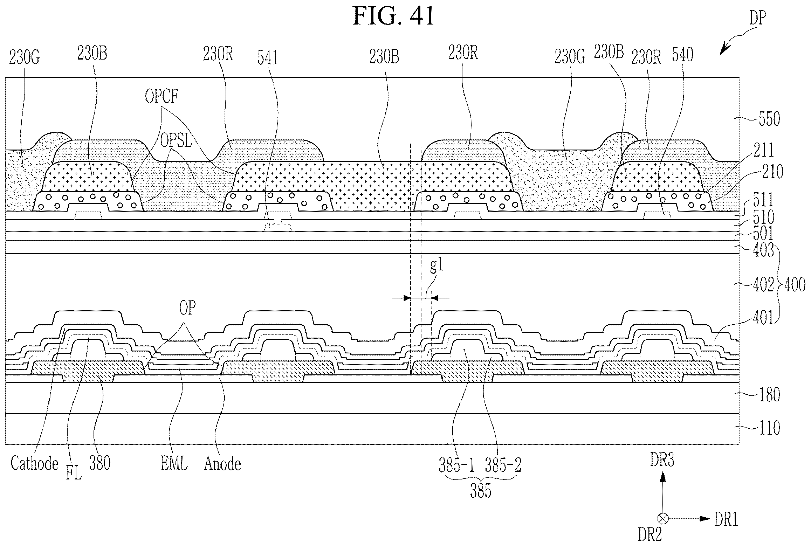

First, the modified structure of FIG. 7 will be described with reference to FIGS. 40 and 41.

FIG. 40 and FIG. 41 are schematic cross-sectional views of a display panel according to another embodiment.

Hereinafter, the structure of the light emitting display panel DP according to an embodiment will first be described with reference to FIG. 40, and description of the same parts as in FIG. 7 will be omitted.

The light emitting display panel DP according to the embodiment of FIG. 40 can display an image by forming light emitting diodes on the substrate 110, and can detect a touch by including a plurality of sensing electrodes 540 and 541, and also has the color characteristics of the color filters 230R, 230G, 230B to light emitted from the light emitting diode, including the color filters 230R, 230G, 230B,

In an embodiment, a black light blocking layer that blocks visible light may not be formed, and instead of a light blocking layer, at least two color filters may be overlapped to block visible light.

An area that blocks visible light by overlapping at least two or more color filters is called a light blocking area, and in the embodiment of FIG. 40, a blue-color filter 230B, a red-color filter 230R, and a green-color filter 230G are sequentially stacked.

The order in which color filters are stacked may vary in embodiments.

In addition, a polarizer is not formed on the front surface of the light emitting display panel DP according to the embodiment of FIG. 40, and instead, the pixel defining layer 380 is formed of a black organic material, forming a light blocking area in which at least two color filters are overlapped on the upper part of the pixel defining layer 380, so that even if external light enters the interior, the external light is reflected from an anode, etc., and is not transmitted to the user.

Specifically, color filters 230R, 230G, 230B are located on the third sensing insulating layer 511.

The color filters 230R, 230G, 230B are a red-color filter 230R that transmits red light, a green-color filter 230G that transmits green light, and a blue-color filter 230B that transmits blue light.

Each of the color filters 230R, 230G, 230B may be positioned to overlap the anode of the light emitting diode in a plan view.

Since the light emitted from the emitting layer EML may change to a corresponding color as it passes through a color filter, all light emitted from the emitting layer EML may have the same color.

In another embodiment, the light emitting layer EML may emit light of different colors, and the displayed color can be strengthened by passing through a color filter of the same color.

In an embodiment, the color filters 230R, 230G, 230B may be replaced with a color conversion layer or may further include a color conversion layer.

The color conversion layer may include quantum dots.

In the embodiment of FIG. 40, the light blocking layer that is black and blocks visible light is not formed, and a light blocking area formed by overlapping at least two color filters is formed instead of the light blocking layer.

In the embodiment of FIG. 40, the light blocking area includes a blue-color filter 230B, a red-color filter 230R, and a green-color filter 230G sequentially stacked.

The order in which color filters are stacked may vary in embodiments.

The light blocking area where at least two or more color filters overlap may be positioned to overlap the sensing electrodes 540 and 541 in a plan view, and may be positioned not to overlap the anode in a plan view.

Accordingly, the anode and the light emitting layer EML, which can display images, may not be obscured by the light blocking area and the sensing electrodes 540 and 541.

Referring to FIG. 40, the light blocking area of the color filter where three color filters overlap is located only in the area that overlaps the pixel defining layer 380 in a plan view, and one side of the light blocking area of the color filter is placed inward from the corresponding side of the pixel defining layer 380.

Only one color filter can be located in an area excluding the light blocking area, and light of the color of the corresponding color filter is transmitted to form a light transmission area of the color filter.

Hereinafter, the light transmission area of the color filter, where only one color filter is located, is also referred to as the second opening OPCF of the light blocking area because light is transmitted therethrough.

The second opening OPCF of the light blocking area is an opening located in a light blocking area where at least two or more color filters overlap and may correspond to an area where only one color filter is located.

In an embodiment, the second opening OPCF of the light blocking area of the color filter may correspond to the second opening OPBM of the light blocking layer 220 described above.

As a result, the second opening OPCF of the light blocking area of the color filter may have a circular or elliptical shape, or may have a flat shape that merges two or more elliptical shapes with different eccentricities, as shown in FIG. 35.

The area of the second opening OPCF of the light blocking area is formed to be larger than the opening OP of the pixel defining layer 380, and the opening OP of the pixel defining layer 380 in plan view is the second opening OPCF of the light blocking area.

In an embodiment, the opening OPSL of the scattering layer 210 may be located within the second opening OPCF of the light blocking area, and in another embodiment, a portion of the opening OPSL of the scattering layer 210 may be located in the light blocking area, and it may be located outside the second opening OPCF.

In addition, the opening OPSL of the scattering layer 210 may be located inside or outside the opening OP of the pixel defining layer 380, so that the opening OPSL of the scattering layer 210 is formed on the pixel defining layer 380. It may be located within the opening OP of the pixel defining layer 380, and the opening OP of the pixel defining layer 380 may be located within the opening OPSL of the scattering layer 210.

In an embodiment, some of the openings OPSL of the scattering layer 210 may be located inside the opening OP of the pixel defining layer 380 in plan view, and the remaining part may be located outside the opening OP of the pixel defining layer 380.

In an embodiment, a concave part OPSL-c of the scattering layer 210 may be formed instead of the opening OPSL of the scattering layer 210.

In addition, one side of the spacer 385 is disposed to be inward at a certain distance g1 from the corresponding side of the pixel defining layer 380, and the spacer 385 is also disposed inward to one side of the light blocking area.

As a result, when viewed from the front of the display panel DP, the spacer 385 may be obscured by the light blocking area and may not be visible.

When external light is incident, the external light passes through the second opening OPCF of the light blocking area of the color filter and the opening OPSL of the scattering layer 210, and is then reflected from the side wall of the opening OP of the pixel defining layer 380.

The side wall of the opening OP of the pixel defining layer 380 is curved, and color separation occurs depending on the position of reflection, so that the reflected light can appear in various colors, such as a rainbow.

Such color-separated reflected light can easily be recognized by the user eye and may degrade the display quality, but in such an embodiment, the scattering particles 211 located in the scattering layer 210 can make it difficult for the user to easily recognize the reflected light by scattering the light.

In addition, as will be described later, the shape, size, and angle of the opening OPSL of the scattering layer 210 are changed in various ways, and various openings OPSL of the scattering layer 210 are included in one panel, so it is possible to prevent reflected external light from forming a specific diffraction pattern.

As a result, it may be difficult for the user to recognize the reflection of external light, thereby reducing the deterioration of display quality due to reflected light.

In an embodiment, it may be formed to have a non-elliptical or near-elliptical shape, and its direction or eccentricity may be changed in various ways.

In addition, various modifications to the previously described second opening OPBM of the light blocking layer 220 and the corresponding opening OP of the pixel defining layer 380 may be used to form the second opening OPCF of the light blocking area of the color filter and the opening OP of the pixel defining layer 380.

A planarization layer 550 covering the color filters 230R, 230G, 230B is positioned on the color filters 230R, 230G, 230B.

The planarization layer 550 is used to planarize the upper surface of the light emitting display panel, and may be a transparent organic insulating layer containing one or more materials selected from the group consisting of polyimide, polyamide, acrylic resin, benzocyclobutene, and phenol resin.

In an embodiment, a low refractive layer and an additional planarization layer may be further positioned on the planarization layer 550 to improve frontal visibility and light output efficiency of the display panel.

Light can be refracted and emitted toward the front by the low refractive layer and the additional flattening layer with high refractive characteristics.

In such an embodiment, the planarization layer 550 may be omitted and a low refractive layer and an additional planarization layer may be located directly on the color filter.

In such an embodiment, a polarizer is not included on top of the planarization layer 550.

In other words, the polarizer can prevent display quality from deteriorating when external light is incident and reflected by the anode or the side wall of the opening OP of the pixel defining layer 380, which is visible to the user.

However, the polarizer has the undesired characteristic of consuming more power to display a certain luminance by not only reducing the reflection of external light but also reducing the light emitted from the light emitting layer EML.

In an embodiment, the light emitting display device may not include a polarizer to reduce power consumption.

In addition, in such an embodiment, the side of the anode is covered with the pixel defining layer 380 to reduce the degree of reflection from the anode, and a light blocking area where at least two or more color filters overlap each other is also formed to prevent light from entering, and such an embodiment already includes a structure to reduce the degree of display quality and prevent deterioration of display quality due to reflection.

Therefore, no polarizer is formed on the front of the light emitting display panel DP.

In the embodiment of FIG. 40, the light blocking area where at least two or more color filters are overlapped is formed by three color filters overlapping.

However, in another embodiment, the light blocking area of the color filter may be formed by overlapping two color filters, which is shown in FIG. 41.

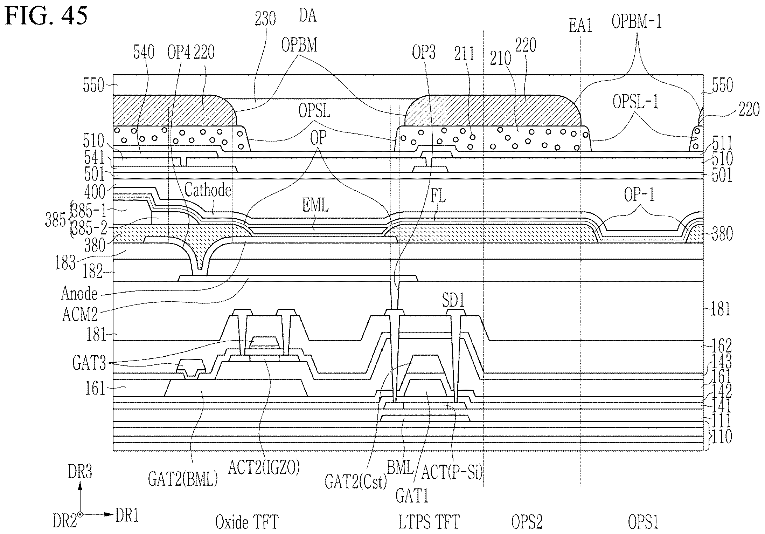

FIG. 41 is a view corresponding to FIGS. 7 and 40, and substantially the same as FIG. 45 except for the color filters 230R, 230G, 230B, so the lower structure of the third sensing insulating layer 511 is the same as that of FIG. 40.

Hereinafter, the upper structure of the third sensing insulating layer 511, which is different from that of FIG. 40, will be described.

Referring to FIG. 41, a light blocking layer that blocks visible light is not formed, and a blue-color filter 230B and a red-color filter 230R are sequentially overlapped to block visible light.

The order in which color filters are stacked may vary depending in embodiments.

Specifically, the shading area where two color filters overlap consists of a blue-color filter 230B and a red-color filter 230R overlapping, and there is also a part where a green-color filter 230G overlaps in some areas of the light blocking area of the color filter.

However, the green-color filter 230G is not formed in the light blocking area of the color filter, and the light blocking area of the color filter is formed using only two color filters, unlike the embodiment of FIG. 40.

The light blocking area where two color filters overlap is located only in the area that overlaps the pixel defining layer 380 in a plan view, and one side of the light blocking area of the color filter goes inward from the corresponding side of the pixel defining layer 380.

Only one color filter can be located in the area excluding the light blocking area of the color filter, and the light of the color of the color filter is transmitted to form the second opening OPCF of the light transmitting area of the color filter or the light blocking area of the color filter.

The area of the second opening OPCF is formed larger than the opening OP of the pixel defining layer 380, and in a plan view, the opening OP of the pixel defining layer 380 can be located within the second opening OPCF of the color filter's blocking area.

In an embodiment, the opening OPSL of the scattering layer 210 may be located within the second opening OPCF of the light blocking area, and in another embodiment, a portion of the opening OPSL of the scattering layer 210 may be located outside the second opening OPCF of the light blocking area.

In addition, the opening OPSL of the scattering layer 210 may be located inside or outside the opening OP of the pixel defining layer 380, so that the opening OPSL of the scattering layer 210 is formed on the pixel defining layer 380, it may be located within the opening OP of the pixel defining layer 380 in plan view, and the opening OP of the pixel defining layer 380 may be located within the opening OPSL of the scattering layer 210.

In an embodiment, a part of the opening OPSL of the scattering layer 210 may be located inside the opening OP of the pixel defining layer 380 in a plan view, and the remaining part may be located outside the opening OP of the pixel defining layer 380.

In an embodiment, a concave part OPSL-c of the scattering layer 210 may be formed instead of the opening OPSL of the scattering layer 210.

In addition to the pixel defining layer 380, the light blocking area of the color filter also overlaps the scattering layer 210, the spacer 385, and the plurality of sensing electrodes 540 and 541 in a plan view.

Specifically, the shading area of the color filter is arranged inward at a certain interval g1 from one side of the pixel defining layer 380 corresponding to the spacer 385, and the spacer 385 is also arranged inward on one side of the blocking area of the color filter.

Additionally, the plurality of sensing electrodes 540 and 541 are covered in a plan view with the light blocking area of the color filter.

As a result, when viewed from the front of the display panel DP, the spacer 385 and the plurality of sensing electrodes 540 and 541 may not be visible because they are obscured by the light blocking area of the color filter.

In an embodiment, the color filters 230R, 230G, 230B may be replaced with a color conversion layer or may further include a color conversion layer.

The color conversion layer may include quantum dots.

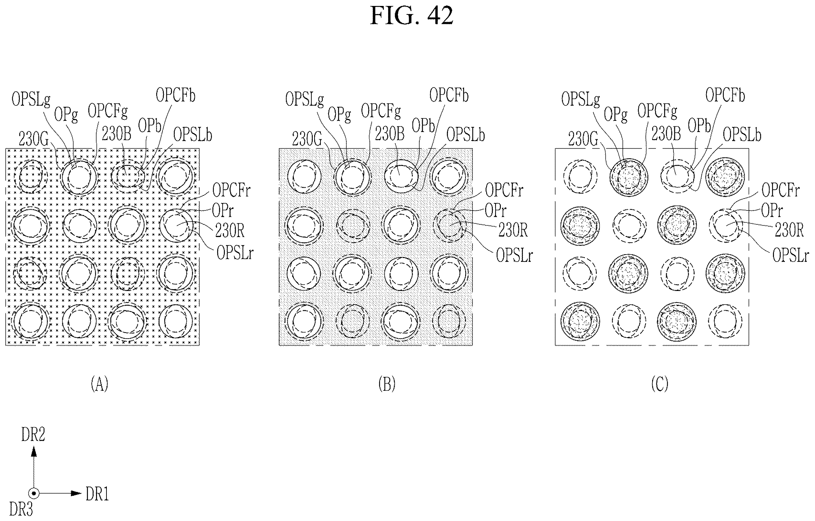

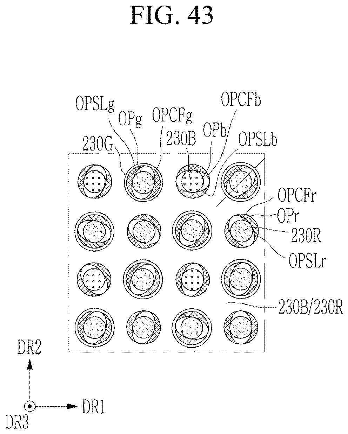

An embodiment having a cross-sectional structure as shown in FIG. 41 may have a planar structure as shown in FIG. 42 and FIG. 43.

The embodiments of FIGS. 42 and 43 may be a planar structure modified from the embodiment of FIG. 9.

First, the planar structure of each color filter 230R, 230G and 230B through FIG. 42 will be described in detail.

FIG. 42 is a plan view showing color filters of a display area according to another embodiment.

FIG. 42(A) shows the layer where the blue-color filter 230B is formed, and a hatch is drawn at the portion where the blue-color filter 230B is located.

The remaining layers are shown with dotted lines in FIG. 42(A).

As shown in FIG. 42(A), the blue-color filter 230B is located in the light blocking area and the blue-light transmission area through which blue light is transmitted, and is not formed in the red and green light transmission areas.

In addition, FIG. 42(B) shows the layer where the red-color filter 230R is formed, and a hatch is drawn at the portion where the red-color filter 230R is located.

The remaining layers are shown with dotted lines in FUG. 42(B).

As shown in FIG. 42(B), the red-color filter 230R is located in the light blocking area and the red-light transmission area through which red light is transmitted, and is not formed in the blue- and green-light transmission areas.

FIG. 42(C) shows the layer where the green-color filter 230G is formed, and a hatch is drawn at the portion where the green-color filter 230G is located.

The remaining layers are shown with dotted lines in FIG. 42(C).

As shown in FIG. 42(C), the green-color filter 230G is formed in an island-like structure and is located only in the green-light transmission area through which green light is transmitted, and is not formed in the light blocking area and the red- and blue-light transmission areas.

In an embodiment, the green-color filter 230G may overlap with some of the light blocking areas of the color filter.

A planar structure as shown in FIG. 43 can be obtained by combining the color filters shown in FIGS. 42(A), 42(B), and 42(C).

FIG. 43 is a plan view of a portion of a display panel according to another embodiment.

FIG. 43 is a plan view corresponding to FIG. 9, in which, unlike the embodiment of FIG. 9, a light blocking area is formed by overlapping two or more color filters instead of a light blocking layer, and the green-color filter 230G has an island-shaped structure.

Here, the boundary of the green-color filter 230G is further shown outside the green second opening OPCFg among the second openings of the color filter, so that the green-color filter 230G has an island-shaped structure, and that the green-color filter 230G partially overlaps the light blocking area of the color filter.

In FIG. 43, the red-color filter 230R and the blue-color filter 230B are each located in a light blocking area, but hatches corresponding to the red-color filter 230R and the blue-color filter 230B are not shown in the light blocking area. Instead, "230B/230R" clearly indicates that the light blocking area is where the blue-color filter 230B and the red-color filter 230R are located.

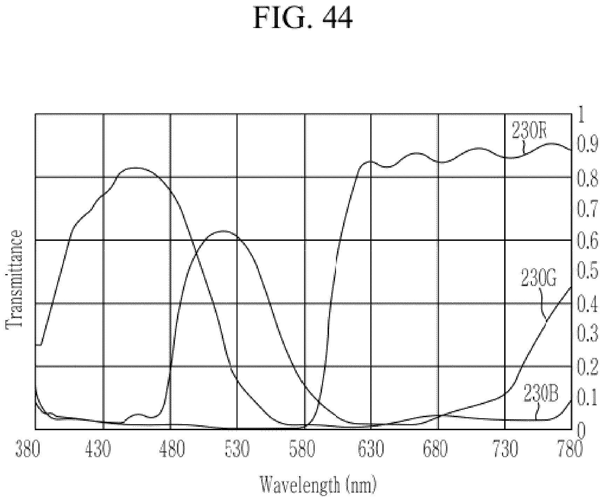

FIG. 44 shows how two color filters can be stacked to replace the role of a light blocking layer.

FIG. 44 is a graph showing the transmittance versus the wavelength of the color filter.

FIG. 44 is a graph of the transmittance for the wavelengths of each color filter 230R, 230G, 230B, so light in the wavelength range indicated at a high point is transmitted.

Referring to FIG. 44, each color filter 230R, 230G, 230B has a transmittance of less than 10% for parts other than the wavelength band that passes through it, and it can be confirmed that there is almost no wavelength band that passes through when three or two color filters overlap.

Therefore, it can be confirmed that by overlapping at least two color filters can replace the role of a light blocking layer, and it is possible to replace the light blocking layer by overlapping three color filters as in FIG. 40, or overlapping two color filters as in FIG. 41 to FIG. 43.

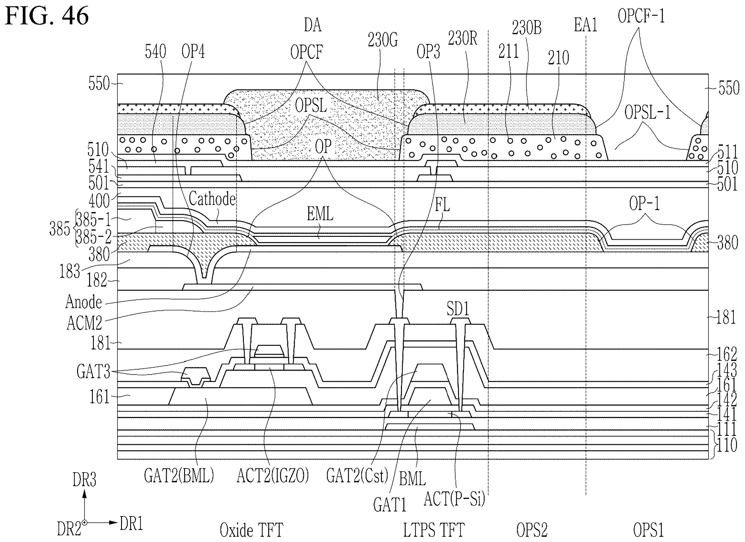

The stacked structure of the display area DA and the first component area EA1 will be examined in more detail through FIGS. 45 and 46.

FIGS. 45 and 46 are cross-sectional views of a light emitting display device according to an embodiment.

FIG. 45 shows an embodiment including a light blocking layer 220, and FIG. 46 shows an embodiment in which a light blocking area of the color filter is formed by overlapping a blue-color filter 230B and a red-color filter 230R instead of the light blocking layer 220.

First, the embodiment of FIG. 45 will be described in detail.

A light emitting display device can be largely divided into a lower panel layer and an upper panel layer. The lower panel layer is where the light emitting diodes and pixel circuitry of the pixel are located, and may even include an encapsulation layer 400 that covers it.

Here, the pixel circuit part includes the second organic layer 182 and the third organic layer 183, and refers to the lower part thereof, the light emitting diode is the upper part of the third organic layer 183, and is located at the bottom of the encapsulation layer 400.

The structure located on top of the encapsulation layer 400 may correspond to the upper panel layer.

Referring to FIG. 45, a metal layer BML is located on the substrate 110.

The substrate 110 may include a material that has rigid properties and does not bend, such as glass, or it may include a flexible material that can bend, such as plastic or polyimide.

In the case of a flexible substrate, as shown in FIG. 45, the substrate 110 may have a double-layer structure of polyimide and a barrier layer formed of an inorganic insulating material thereon.

The metal layer BML may be formed in a position that overlaps the channel of the driving transistor T1 in a plan view among the subsequent first semiconductor layers, and is also called a lower shielding layer.

The metal layer BML may include a metal or metal alloy such as copper (Cu), molybdenum (Mo), aluminum (Al), or titanium (Ti).

A buffer layer 111 covering the substrate 110 and the metal layer BML is located on the substrate 110.

The buffer layer 111 serves to block the penetration of impure elements into the first semiconductor layer (ACT(P-Si)) and is an inorganic insulating material containing silicon oxide (SiOx), silicon nitride (SiNx), silicon oxynitride (SiONx), etc.

A first semiconductor layer (ACT(P-Si)) including or formed of a silicon semiconductor (e.g., a polycrystalline semiconductor (P-Si)) is located on the buffer layer 111.

The first semiconductor layer (ACT(P-Si)) includes a channel of a polycrystalline transistor (LTPS TFT) including the driving transistor T1, and a first region and a second region located on both sides thereof.

Here, the polycrystalline transistor (LTPS TFT) may include not only the driving transistor T1 but also various switching transistors or compensation transistors.

Additionally, the first semiconductor layer (ACT(P-Si)) has regions on both sides of the channel that have conductive layer characteristics through plasma treatment or doping, and can serve as the first and second electrodes of the transistor.

A first gate insulating layer 141 may be positioned on the first semiconductor layer (ACT(P-Si)).

The first gate insulating layer 141 may be an inorganic insulating layer containing silicon oxide (SiOx), silicon nitride (SiNx), or silicon oxynitride (SiONx).

A first gate conductive layer GAT1 including the gate electrode of a polycrystalline transistor (LTPS TFT) may be positioned on the first gate insulating layer 141.

The first gate conductive layer GAT1 may define a first scan line or an emission control line in addition to the gate electrode of the polycrystalline transistor (LTPS TFT).

The first gate conductive layer may include a metal or metal alloy such as copper (Cu), molybdenum (Mo), aluminum (Al), or titanium (Ti), and may be composed of a single layer or multiple layers.

After forming the first gate conductive layer GAT1, a plasma treatment or doping process may be performed to make the exposed area of the first semiconductor layer conductive.

That is, the first semiconductor layer (ACT(P-Si)) covered by the first gate conductive layer GAT1 is not conductive, and the part of the first semiconductor layer (ACT(P-Si)) not covered by the first gate conductive layer GAT1 may have the same characteristics as the conductive layer.

A second gate insulating layer 142 may be positioned on the first gate conductive layer GAT1 and the first gate insulating layer 141.

The second gate insulating layer 142 may be an inorganic insulating layer containing silicon oxide (SiOx), silicon nitride (SiNx), or silicon oxynitride (SiONx).

A second gate conductive layer including one electrode (GAT2Cst) of the sustain capacitor Cst and the lower shielding layer (GAT2(BML)) of the oxide transistor (Oxide TFT) is located on the second gate insulating layer 142.

The lower shielding layer (GAT2(BML)) of the oxide transistor (Oxide TFT) is located at the bottom of the channel of each oxide transistor (Oxide TFT) and serves to shield against light or electromagnetic interference provided to the channel from the bottom.

In an embodiment, one electrode (GAT2(Cst)) of the sustaining capacitor Cst overlaps the gate electrode of the driving transistor T1 to form the sustaining capacitor Cst.

In an embodiment, the second gate conductive layer may further include a scan line, a control line, or a voltage line.

The second gate conductive layer may include a metal or metal alloy such as copper (Cu), molybdenum (Mo), aluminum (Al), or titanium (Ti), and may be composed of (or defined by) a single layer or multiple layers.

A first interlayer insulating layer 161 may be positioned on the second gate conductive layer.

In an embodiment, the first interlayer insulating layer 161 may include an inorganic insulating layer containing silicon oxide (SiOx), silicon nitride (SiNx), or silicon oxynitride (SiONx), and in an embodiment, the inorganic insulating material may be formed to be thick.

An oxide semiconductor layer (ACT2(IGZO)) including a channel, a first region, and a second region of an oxide transistor (Oxide TFT) may be positioned on the first interlayer insulating layer 161.

A third gate insulating layer 143 may be located on the oxide semiconductor layer (ACT2(IGZO)).

A third gate insulating layer 143 may be located on the front surface of the oxide semiconductor layer (ACT2(IGZO)) and the first interlayer insulating layer 161.

A third gate insulating layer 143 may include an inorganic insulating layer containing silicon oxide (SiOx), silicon nitride (SiNx), or silicon oxynitride (SiONx).

A third gate conductive layer GAT3 including the gate electrode of an oxide transistor (Oxide TFT) may be positioned on the third gate insulating layer 143.

The gate electrode of an oxide transistor (Oxide TFT) may overlap the channel.

The third gate conductive layer GAT3 may further include a scan line or a control line, and may additionally include a connection electrode connected to the lower shielding layer (GAT2(BML)) of the oxide transistor (Oxide TFT).

The third gate conductive layer GAT3 may include a metal or metal alloy such as copper (Cu), molybdenum (Mo), aluminum (Al), or titanium (Ti), and may be composed of (or defined by) a single layer or multiple layers.

A second interlayer insulating layer 162 may be positioned on the third gate conductive layer GAT3.

The second interlayer insulating layer 162 may have a single-layer or multi-layer structure.

The second interlayer insulating layer 162 may include an inorganic insulating material such as silicon nitride (SiNx), silicon oxide (SiOx), or silicon nitride (SiOxNy), or may include an organic material.

A first data conductive layer SD1 is positioned on the second interlayer insulating layer 162 and includes a connection electrode connected to the first and second regions of each of the polycrystalline transistor (LTPS TFT) and the oxide transistor (Oxide TFT).

The first data conductive layer SD1 may include a metal or metal alloy such as aluminum (Al), copper (Cu), molybdenum (Mo), titanium (Ti), and may be composed of (or defined by) a single layer or multiple layers.

A first organic layer 181 may be positioned on the first data conductive layer SD1.

The first organic layer 181 may be an organic insulating layer containing an organic material, and the organic material includes at least one material selected from polyimide, polyamide, acrylic resin, benzocyclobutene, and phenol resin.

A second data conductive layer including an anode connection electrode ACM2 may be positioned on the first organic layer 181.

The second data conductive layer may include a data line or a driving voltage line.

The second data conductive layer SD2 may include a metal or metal alloy such as aluminum (Al), copper (Cu), molybdenum (Mo), or titanium (Ti), and may be composed of (or defined by) a single layer or multiple layers.

A second organic layer 182 and a third organic layer 183 are located on the second data conductive layer, and an anode connection opening OP4 is provided in the second organic layer 182 and the third organic layer 183.

The anode connection electrode ACM2 is electrically connected to the anode through the anode connection opening OP4.

The second organic layer 182 and the third organic layer 183 may be organic insulating layers, and may include at least one material selected from polyimide, polyamide, acrylic resin, benzocyclobutene, and phenol resin.

In an embodiment, the third organic layer 183 may be omitted.

The pixel defining layer 380 may be positioned on the anode and has an opening OP exposing the anode and covers at least a portion of the anode.

In an embodiment, the pixel defining layer 380 may be a black pixel defining layer that include or is formed of a black organic material to prevent externally applied light from being reflected back to the outside, and in another embodiment, the pixel defining layer may include or be formed of a transparent organic material.

In an embodiment, the pixel defining layer 380 may include a negative-type black organic material and a black pigment.

A spacer 385 is located on the pixel defining layer 380.

The spacer 385 may include a first part 385-1 that is tall (or protruded) and located in a narrow area, and a second part 385-2 that is short and is located in a wide area.

Unlike the pixel defining layer 380, the spacer 385 may include or be formed of a transparent organic insulating material.

In an embodiment, the spacer 385 may include or be formed of a positive-type transparent organic material.

On top of the anode, the spacer 385, the pixel defining layer 380, the functional layers FL and a cathode are sequentially formed, and in the display area DA and the first component area EA1, the functional layer FL and cathode can be located in all areas.

The light emitting layer EML is located between the functional layers FL, and the light emitting layer EML may be located only within the opening OP of the pixel defining layer 380.

In an embodiment, the functional layer FL and the light emitting layer EML can be combined with each other and may also be collectively referred to as the intermediate layer.

The functional layer FL may include at least one of auxiliary layers such as an electron injection layer, an electron transport layer, a hole transport layer, and a hole injection layer, and the hole injection layer and the hole transport layer may be located below the light emitting layer EML layer, and an electron transport layer and an electron injection layer may be located on top of the light emitting layer EML.

An encapsulation layer 400 is located on the cathode.

The encapsulation layer 400 includes at least one inorganic layer and at least one organic layer, and in an embodiment, may have a triple-layer structure including a first inorganic encapsulation layer, an organic encapsulation layer, and a second inorganic encapsulation layer.

The encapsulation layer 400 may be used to protect the light emitting layer EML from moisture or oxygen that may enter from the outside.

In an embodiment, the encapsulation layer 400 may include a structure in which an inorganic layer and an organic layer are further sequentially stacked.

The sensing insulating layers 501, 510, 511 and a plurality of sensing electrodes 540, 541 are positioned on the encapsulation layer 400 for touch detection.

In the embodiment of FIG. 45, touch can be sensed in a capacitive manner using two sensing electrodes 540 and 541.

Specifically, a first sensing insulating layer 501 is formed on the encapsulation layer 400, and a plurality of sensing electrodes 540 and 541 are formed thereon.

The plurality of sensing electrodes 540 and 541 may be insulated with the second sensing insulating layer 510 interposed therebetween, and some of them may be electrically connected through an opening located in the second sensing insulating layer 510.

Here, the sensing electrodes (540, 541) may include a metal or a metal alloy such as aluminum (Al), copper (Cu), silver (Ag), gold (Au), molybdenum (Mo), titanium (Ti), tantalum TA, and can be composed of (or defined by) a single layer or multiple layers.

A third sensing insulating layer 511 is formed on the sensing electrode 540.

A scattering layer 210, a light blocking layer 220, and color filters 230R, 230G, 230B are positioned on the third sensing insulating layer 511.

The scattering layer 210 may be positioned to overlap the pixel defining layer 380 and the sensing electrodes 540 and 541 in a plan view, a portion of the scattering layer 210 overlaps the anode in a plan view, and the portion may not overlap the anode.

The scattering layer 210 may overlap the pixel defining layer 380 in a plan view.

The scattering layer 210 includes scattering particles 211 capable of scattering light, and has an opening OPSL that overlaps the opening OP of the pixel defining layer 380 at least in part in a plan view.

The size, shape, and arrangement direction of the opening OPSL of the scattering layer 210 can vary, and according to the embodiment, it can be formed in the concave part (see FIG. 38) of the scattering layer 210 instead of the opening OPSL of the scattering layer 210.

The light blocking layer 220 may be positioned to overlap the sensing electrodes 540 and 541 in a plan view.

The light blocking layer 220 has a second opening OPBM, and the second opening OPBM of the light blocking layer 220 overlaps the opening OP of the pixel defining layer 380 in a plan view.

Additionally, the second opening OPBM of the light blocking layer 220 may be formed wider than the opening OP of the pixel defining layer 380.

As a result, the anode overlapping the opening OP of the pixel defining layer 380 (i.e., exposed by the opening OP of the pixel defining layer 380) is also exposed in a plan view by the light blocking layer 220, the anode may not be obscured the light blocking layer 220.

This is to ensure that the anode and the light emitting layer EML capable of displaying an image are not obscured by the light blocking layer 220 and the sensing electrodes 540 and 541.

The second opening OPBM of the light blocking layer 220 can be formed larger than the opening OPSL of the scattering layer 210, and at least a part of the second opening OPBM of the light blocking layer 220 in a plan view can overlap the opening OPSL of the scattering layer 210.

In addition, the light blocking layer 220 has a structure that overlaps the anode connection opening OP4 in a plan view but does not overlap the opening OP3 of the first organic layer 181 in a plan view.

The color filters 230R, 230G, 230B are positioned on the sensing insulating layers 501, 510, 511, the scattering layer 210, and the light blocking layer 220.

In an embodiment, the color filters 230R, 230G, 230B may be replaced with a color conversion layer or may further include a color conversion layer.

The color conversion layer may include quantum dots.

A planarization layer 550 may be positioned on the color filters 230R, 230G, 230B to cover the color filters 230R, 230G, 230B, and in an embodiment, a low refractive layer and an additional planarization layer may further be positioned on top of the planarization layer 550 to improve frontal visibility and light emission efficiency of the display device.

Light can be refracted and emitted toward the front by an additional planarization layer with a low refractive layer and a high refractive property.

In such an embodiment, the planarization layer 550 may be omitted and a low refractive layer and an additional planarization layer may be located directly on the color filter 230.

In such an embodiment, a polarizer is not included on top of the planarization layer 550.

In other words, the polarizer can play a role in preventing display quality from deteriorating when external light is incident and reflected by an anode, etc., and is visible to the user.

However, in such embodiment, the side of the anode is covered with the pixel defining layer 380 to reduce the degree of reflection from the anode, and the scattering layer 210 and the light blocking layer 220 are also formed to prevent deterioration of display quality due to reflection.

Therefore, no polarizer is desired to be provided on the front of the display panel DP.

In an embodiment, in FIG. 45, in addition to the stacked structure of the display area DA, the cross-sectional structure of the first component area EA1, which is formed to allow light to transmit through a portion of the display area DA, is shown.

In FIG. 45, the first component area EA1 is divided into a first optical sensor area OPS1 (also referred to as a transmissive optical sensor area) and a second optical sensor area OPS2 (also referred to as a non-transmissive optical sensor area).

In an embodiment, the first optical sensor area OPS1 is an area formed to allow light to pass through, with additional openings OP-1, OPSL-1, OPBM-1 formed not to overlap in a plan view the pixel defining layer 380, the scattering layer 210 and the light blocking layer 220.

In an embodiment, the second optical sensor area OPS2 is an area formed to overlap the pixel defining layer 380, the scattering layer 210, and the light blocking layer 220 in a plan view so that light does not transmit through.

Both the first optical sensor area OPS1 and the second optical sensor area OPS2 of the first component area EA1 may not include a layer that blocks light, such as a metal layer or a semiconductor layer.

In an embodiment, for example, the first optical element (see ES1 in FIG. 2) is located on the back of the first component area EA1, and the front of the light emitting display device can be detected through the first optical sensor area OPS1 located in the first component area EA1.

Specifically, the layered structure of the first component area EA1 is as follows.

The buffer layer 111, which is an inorganic insulating layer, is positioned on the substrate 110, and the first gate insulating layer 141 and the second gate insulating layer 142, which are inorganic insulating layers, are sequentially positioned thereon.

Additionally, a first interlayer insulating layer 161, a third gate insulating layer 143, and a second interlayer insulating layer 162, which are inorganic insulating layers, are sequentially stacked on the second gate insulating layer 142.

On the second interlayer insulating layer 162, a first organic layer 181, a second organic layer 182, and a third organic layer 183, which are organic insulating layers, are sequentially stacked.

A functional layer FL may be located on the third organic layer 183, and a cathode may be located on the third organic layer 183.

The encapsulation layer 400 is positioned on the cathode, and the sensing insulating layers 501, 510, 511 are sequentially positioned on top of the cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, 511 may all be inorganic insulating layers.

A planarization layer 550 may be positioned on the sensing insulating layers 501, 510, 511.

In the first component area EA1 as described above, a metal layer, a first semiconductor layer, a first gate conductive layer, a second gate conductive layer, an oxide semiconductor layer, a third gate conductive layer, a first data conductive layer, a second data conductive layer, and an anode are not located.

Additionally, the light emitting layer EML and the sensing electrodes 540 and 541 are not formed.

Additionally, in the first optical sensor area OPS1 of the first component area EA1, additional openings OP-1, OPSL-1, OPBM-1 may be formed so that the pixel defining layer 380, the scattering layer 210, and the light blocking layer 220 are not formed.

As a result, light may pass through the first optical sensor area OPS1 and may not be scattered.

In an embodiment, the second optical sensor area OPS2 in the first component area EA1 may have a structure where light does not penetrate by overlapping the pixel defining layer 380 and the light blocking layer 220 without forming additional openings OP-1, OPSL-1, OPBM-1.

In an embodiment, a concave part (see FIG. 38) of the scattering layer 210 may be provided instead of the opening OPSL of the scattering layer 210.

As described above, an embodiment in which a total of three organic layers are formed, and an anode connection opening is formed in the second organic layer and the third organic layer was examined.

In an embodiment, where at least two organic layers may be formed, the anode connection opening may be located in the upper organic layer located away from the substrate, and the lower organic layer opening may be located in the lower organic layer.

Hereinafter, with reference to FIG. 46, an embodiment in which the light blocking area of the color filter is formed by overlapping the blue-color filter 230B and the red-color filter 230R instead of the light blocking layer 220 will be described.

In FIG. 46, the third sensing insulating layer 511 and the structure there below are the same as those in FIG. 45, so only the upper structure of the third sensing insulating layer 511, which differs from FIG. 45, will hereinafter be described in detail.

The color filters 230R, 230G, 230B are located on the third sensing insulating layer 511.

In the embodiment of FIG. 46, there is no inclusion of a light blocking layer, and the role of the light blocking layer is performed by the overlapped color filters 230R, 230B, and the overlapped color filters 230R, 230B can be positioned to overlap in a plan view with the scattering layer 210 and the sensing electrodes (540, 541).

The overlapped color filters 230R, 230B have a second opening OPCF, and the second opening OPCF of the overlapped color filters 230R, 230B is connected to the opening OP of the pixel defining layer 380 and the opening OPSL of the scattering layer 210.

Additionally, the second opening OPCF of the overlapped color filters 230R, 230B may be formed wider than the opening OP of the pixel defining layer 380.

As a result, the anode, which is overlapped (i.e., exposed by the opening OP of the pixel defining layer 380), can have a structure that is not obscured in a plan view by the overlapped color filters 230R, 230B.

This is to ensure that the anode and the light emitting layer EML capable of displaying an image are not obscured by the overlapped color filters 230R, 230B and the sensing electrodes 540 and 541.

Additionally, the overlapped color filters 230R, 230B have a structure that overlaps the anode connection opening OP4 in a plan view.

The second opening OPCF of the overlapped color filters 230R, 230B may be formed larger than the opening OPSL of the scattering layer 210, and at least a portion of the second opening OPCF of the overlapped color filters 230R, 230B in a plan view may overlap the opening OPSL of the scattering layer 210.

One color filter may be located within the second opening OPCF of the overlapped color filters 230R, 230B, and in FIG. 46, a green-color filter 230G is located.

In an embodiment, the color filters 230R, 230G, 230B may be replaced with a color conversion layer or may further include a color conversion layer.

The color conversion layer may include quantum dots.

Above the color filters 230R, 230G, 230B is a planarization layer 550 covering the color filters 230R, 230G, 230B, and above the planarization layer 550 may be a low refractive layer and additional planarization layers to improve frontal visibility and light emission efficiency of the display device.

In an embodiment, the planarization layer 550 may be omitted, and a low refractive layer and an additional planarization layer may be located directly on the color filter.

In the embodiment of FIG. 46, the polarizer is not included on top of the planarization layer 550.

In other words, the polarizer can play a role in preventing display quality from deteriorating as external light is incident and reflected by an anode, etc., and is visible to the user.

However, in such an embodiment, the sides of the anode are covered with the pixel defining layer 380 to reduce the degree of reflection from the anode, and the overlapped color filters 230R, 230B and a scattering layer 210 are also formed to reduce the amount of light incident on the anode and to prevent deterioration of display quality due to reflection.

Therefore, in such an embodiment, no polarizer is separately provided on the front of the display panel DP.

The size, shape, and arrangement direction of the opening OPSL of the scattering layer 210 can vary, and according to the embodiment, it can be formed in the concave part of the scattering layer 210 instead of the opening OPSL of the scattering layer 210 (see FIG. 38).

In an embodiment, the cross-sectional structure of the first component area EA1 according to the embodiment of FIG. 46 may be as follows.

The first component area EA1 is divided into a first optical sensor area OPS1 and a second optical sensor area OPS2.

Here, the first optical sensor area OPS1 is an area formed so that light can pass through, where each additional opening OP-1, OPSL-1, OPCF-1 is located not to overlap in a plan view the shading area of the color filter formed by overlapping the pixel defining layer 380, scattering layer 210, and at least two color filters.

In such an embodiment, the second optical sensor area OPS2 is an area formed to overlap the shading area of the color filter formed by overlapping the pixel defining layer 380, the scattering layer 210, and at least two color filters in a plan view, and is formed so that light does not penetrate.

Both the first optical sensor area OPS1 and the second optical sensor area OPS2 of the first component area EA1 may not include a layer that blocks light, such as a metal layer or a semiconductor layer.

In an embodiment, for example, the first optical element (see ES1 in FIG. 2) is located on the back side of the first component area EA1, and it can detect the front side of the light emitting display device through the first optical sensor area OPS1 located in the first component area EA1.

Specifically, the layered structure of the first component area EA1 is as follows.

A buffer layer 111, which is an inorganic insulating layer, is positioned on the substrate 110, and a first gate insulating layer 141 and a second gate insulating layer 142, which are inorganic insulating layers, are sequentially positioned thereon.

Additionally, a first interlayer insulating layer 161, a third gate insulating layer 143, and a second interlayer insulating layer 162, which are inorganic insulating layers, are sequentially stacked on the second gate insulating layer 142.

On the second interlayer insulating layer 162, a first organic layer 181, a second organic layer 182, and a third organic layer 183, which are organic insulating layers, are sequentially stacked.

A functional layer FL may be located on the third organic layer 183, and a cathode may be located on the third organic layer 183.

An encapsulation layer 400 is positioned on the cathode, and sensing insulating layers 501, 510, 511 are sequentially positioned on top of the cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, 511 may all be inorganic insulating layers.

A planarization layer 550 may be positioned on the sensing insulating layers 501, 510, 511.

In the first component area EA1 as described above, a metal layer, a first semiconductor layer, a first gate conductive layer, a second gate conductive layer, an oxide semiconductor layer, a third gate conductive layer, a first data conductive layer, and a second data conductive layer and the anode are not located.

Additionally, the light emitting layer EML and the sensing electrodes 540 and 541 are not formed.

Additionally, in the first optical sensor area OPS1 of the first component area EA1, additional openings OP-1, OPSL-1, OPCF-1 may be formed so that the pixel defining layer 380 and the color filter may not be formed.

As a result, light may pass through the first optical sensor area OPS1.

On the other hand, in the second optical sensor area OPS2 of the first component area EA1, the additional openings OP-1, OPSL-1, OPCF-1 are not located, so the pixel defining layer 380 and the scattering layer 210 may have a structure in which light does not pass through and is not scattered by overlapping the light blocking area of the color filter.

In an embodiment, a concave part (see FIG. 38) of the scattering layer 210 is provided instead of the opening OPSL of the scattering layer 210.

As described above, an embodiment in which a total of three organic layers are formed, and an anode connection opening is formed in the second organic layer and the third organic layer has been examined.

However, at least two organic layers may be formed, and in this case, the anode connection opening may be located in the upper organic layer located away from the substrate, and the lower organic layer opening may be located in the lower organic layer.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A light emitting display device (1000), comprising:
a substrate (110);
an anode located on the substrate;
a pixel defining layer (380) located on the anode, wherein a first opening, OP, is defined through the pixel defining layer to overlap the anode;
a light emitting layer, EML, located in the first opening of the pixel defining layer;
a cathode located on the light emitting layer and the pixel defining layer;
an encapsulation layer (400) located on the cathode;
a scattering layer (210) located on the encapsulation layer, wherein the scattering layer includes scattering particles (211), and a scattering layer opening, OPSL, is defined through the scattering layer to overlap the first opening in a plan view at least in part; and
a light blocking layer (220) located on the scattering layer, wherein a second opening, OPBM, is defined through the light blocking layer to overlap the first opening in a plan view,
wherein at least one selected from the first opening, the scattering layer opening, and the second opening has an oval or elliptical planar shape.

2. The light emitting display device (1000) of claim 1, wherein
the first opening, OP, and the second opening, OPBM, have a circular planar shape and
the scattering layer opening, OPSL, has the oval or elliptical planar shape.

3. The light emitting display device (1000) of claim 2, wherein
the scattering layer opening, OPSL, contacts the first opening, OP, and/or the second opening, OPBM, in a plan view.

4. The light emitting display device (1000) of claim 1, wherein
the first opening, OP, the second opening, OPBM, and the scattering layer opening, OPSL, have the oval or elliptical planar shape.

5. The light emitting display device (1000) of claim 4, wherein the scattering layer opening, OPSL, and the first opening, OP, coincide with each other in a plan view.

6. The light emitting display device (1000) of claim 4 , wherein
a long-axis direction of the scattering layer opening, OPSL, is different from a long-axis direction of the first opening, OP, or a long-axis direction of the second opening, OPBM.

7. The light emitting display device (1000) of claim 4, wherein the scattering layer opening, OPSL, has a circular planar shape.

8. The light emitting display device (1000) of claim 2 or 4 or 7, wherein
a portion of the first opening, OP, is covered with the scattering layer (210).

9. A light emitting display device (1000), comprising:
a substrate (110);
a plurality of anodes located on the substrate;
a pixel defining layer (380) located on the anode, wherein a plurality of first openings, OP, are defined through the pixel defining layer to overlap the plurality of anodes;
a plurality of light emitting layers, EML, located in the plurality of first openings of the pixel defining layer;
a cathode located on the light emitting layer and the pixel defining layer;
an encapsulation layer (400) located on the cathode;
a scattering layer (210) located on the encapsulation layer, wherein the scattering layer includes scattering particles (211), and a plurality of scattering layer openings, OPSL, are defined through the scattering layer to overlap the plurality of first openings in a plan view at least in part; and
a light blocking layer (220) located on the scattering layer, wherein a plurality of second openings, OPBM, are defined through the light blocking layer to overlap the plurality of first openings in a plan view,
wherein each of the plurality of first openings, the plurality of scattering layer openings, and the plurality of second openings are in a circular shape in the plan view, and
wherein each of the plurality of scattering layer openings is located within a corresponding one of the plurality of first openings in the plan view.

10. The light emitting display device (1000) of claim 9, wherein a first opening, OP, and a scattering layer opening, OPSL, corresponding to each other have a same center in the plan view.

11. The light emitting display device (1000) of claim 9 or 10, wherein at least one of the plurality of first openings, OP, does not overlap the plurality of scattering layer openings, OPSL, in the plan view.

12. A light emitting display device (1000) , comprising
a substrate;
an anode located on the substrate;
a pixel defining layer located on the anode, wherein a first opening is defined through the pixel defining layer to overlap the anode;
a light emitting layer located in the first opening of the pixel defining layer;
a cathode located on the light emitting layer and the pixel defining layer;
an encapsulation layer located on the cathode;
a scattering layer located on the encapsulation layer, wherein the scattering layer includes scattering particles, and a scattering layer concave part, OPSL-c, is defined in the scattering layer (210) to overlap the first opening, OP, in a plan view at least in part; and
a light blocking layer located on the scattering layer, wherein a second opening is defined through the light blocking layer to overlap the first opening in the plan view,
wherein the scattering layer concave part is thinner than another part of the scattering layer.

13. The light emitting display device (1000) of claim 12, wherein each of the first opening, OP, the scattering layer concave part. OSL-c,, and the second opening, OPBM, has a circular planar shape or an oval or elliptical planar shape.

14. The light emitting display device (1000) of any of the previous claims,
wherein the light blocking layer (220) comprising a plurality of color filters (230R, 230G, 230B),
wherein the plurality of color filters corresponds to different colors, respectively,
wherein the plurality of color filters includes at least two color filters overlapping each other in a light blocking area of the color filter, and
wherein the second opening, OPCF, is defined through only one color filter among the plurality of color filters to overlap the first opening in the plan view.

15. The light emitting display device (1000) of any of the previous claims, wherein the elliptical planar shape is a planar shape in which at least two elliptical shapes with different plane eccentricities are combined.
